# EUROPEAN PATENT SPECIFICATION

(11) **EP 2 421 064 B1**
(45) Date of publication and mention of the grant of the patent: **04.07.2018**
(21) Application number: 11177750.4
(22) Date of filing: 17.08.2011
(51) Int. Cl.: H01L 51/54

(54) **Compound for organic optoelectronic device, organic light emmiting diode including the same and display including the light emmiting diode**
Verbindung für organische optoelektronische Vorrichtungen, organische Leuchtdiode damit und Anzeige mit der Leuchtdiode
Composé pour dispositif opto-électronique organique, diode électroluminescente l'incluant et affichage incluant la diode électroluminescente

(30) Priority: 18.08.2010 KR 20100079778; 20.12.2010 KR 20100131038
(43) Date of publication of application: 22.02.2012
(73) Proprietor: CHEIL INDUSTRIES INC., Kumi-city, Kyungsangbuk-do 730-030 (KR)
(72) Inventor: Jung, Sung-Hyun, Uiwang-si, Gyeonggi-do (KR); Huh, Dal-Ho, Uiwang-si, Gyeonggi-do (KR); Ryu, Dong-Wan, Uiwang-si, Gyeonggi-do (KR); Lee, Kyoung-Mi, Uiwang-si, Gyeonggi-do (KR); Kang, Eui-Su, Uiwang-si, Gyeonggi-do (KR); Chae, Mi-Young, Uiwang-si, Gyeonggi-do (KR)
(74) Representative: Michalski Hüttermann & Partner Patentanwälte mbB

(56) References cited:
- EP-A1- 1 862 524
- EP-A1- 2 202 818
- WO-A1-2009/061145
- US-A1- 2005 221 124
- US-A1- 2008 124 572

## Description

### BACKGROUND OF THE INVENTION

### (a) Field of the Invention

A compound for an organic optoelectronic device that is capable of providing an organic optoelectronic device having good life span, efficiency, electrochemical stability, and thermal stability, an organic light emmiting diode including the same, and a display including the light emmiting diode are disclosed

### (b) Description of the Related Art

An organic optoelectronic device is, in a broad sense, a device for transforming photo-energy to electrical energy or a device for transforming electrical energy to photo-energy conversely.

US 2005/221124 A1 refers to an organic electroluminescent (OEL) compound that comprises at least one fluorene derivative and at least one carbazole derivative. The compound has good electrical properties, light emitting properties and charge transport ability, and thus is suitable as a host material suitable for fluorescent and phosphorescent dopants of all colors including red, green, blue, white, etc., and as a charge transport material. An OEL display device that uses an organic layer that includes the OEL compound has a high efficiency, a low voltage, a high luminance, and a long lifespan because it has superior current density.

EP 1 862 524 A1 refers to an organic light emitting device including: a substrate; a first electrode; a second electrode; and an organic layer interposed between the first electrode and the second electrode and including an emission layer, wherein one of the first electrode and the second electrode is a reflective electrode and the other is a semitransparent or transparent electrode, and wherein the organic layer includes a layer having at least one of the compounds having at least one carbazole group, and a flat panel display device including the organic light emitting device. The organic light emitting device has low driving voltage, excellent current density, high brightness, excellent color purity, high efficiency, and long lifetime.

EP 2 202 818 A1 refers to an organic EL device includes: an anode, a cathode and an organic thin-film layer interposed between the anode and the cathode, in which the organic thin-film layer includes: an emitting layer containing a host material and a phosphorescent material; and a hole transport ing layer provided adjacent to the anode relative to the emitting layer.

WO 2009/061145 A1 refers to a novel compound that is capable of largely improving life span, efficiency, electrochemical stability and thermal stability of the organic light emitting device, and an organic light emitting device in which said compound is included in an organic compound layer.

US 2008/124572 A1 refers to an aromatic amine derivative with a specific structure having a carbazole skeleton to which a diarylamino group bonds via a bonding group. An organic electroluminescence device which is composed of one or more organic thin film layers including at least one light emitting layer sandwiched between a cathode and an anode, wherein at least one of the organic thin film layers contains the aromatic amine derivative singly or as its mixture component.

An organic optoelectronic device may be classified as follows in accordance with its driving principles. A first organic optoelectronic device is an electronic device driven as follows: excitons are generated in an organic material layer by photons introduced from an external light source to a device; the excitons are separated into electrons and holes; and the electrons and holes are respectively transferred to different electrodes and used as a current source (a voltage source).

A second organic optoelectronic device is an electronic device driven as follows: a voltage or a current is applied to at least two electrodes to inject holes and/or electrons into an organic material semiconductor positioned at the interface of the electrodes, and the device are driven by the injected electrons and holes.

For example, the organic optoelectronic device includes an organic light emitting diode (OLED), an organic solar cell, an organic photo-conductor drum, an organic transistor, an organic memory device, etc. and requires a hole injecting or transporting material, an electron injecting or transporting material, or a light emitting material.

Particularly, the organic light emitting diode (OLED) has recently drawn attention due to an increase in demand for a flat panel display. In general, organic light emission refers to transformation of electrical energy to photo-energy.

The organic light emitting diode transforms electrical energy into light by applying a current to an organic light emitting material. It has a structure that a functional organic material layer is interposed between an anode and a cathode. The organic material layer includes a multi-layer including different materials, for example, a hole injection layer (HIL), a hole transport layer (HTL), an emission layer, an electron transport layer (ETL), and an electron injection layer (EIL) in order to improve efficiency and stability of an organic light emitting diode.

In such an organic light emitting diode, when a voltage is applied between an anode and a cathode, holes from the anode and electrons from the cathode are injected to an organic material layer. The holes and electrons are recombined to generate excitons having high energy. The generated excitons generate light with a certain wavelength, while shifting to a ground state.

Recently, a phosphorescent light emitting material as well as the fluorescent light emitting material can be used as a light emitting material for an organic light emitting diode. Such a phosphorescent material emits lights by transiting the electrons from a ground state to an exited state, transiting a singlet exciton to a triplet exciton without radiance through intersystem crossing, and transiting the triplet exciton to a ground state.

As described above, an organic material layer for an organic light emitting diode includes a light emitting material and a charge transport material, for example, a hole injection material, a hole transport material, an electron transport material, an electron injection material, and so on.

The light emitting material is classified as blue, green, and red light emitting materials according to emitted colors, and yellow and orange light emitting materials to emit colors near to natural colors.

When one material is used as a light emitting material, a device may have deteriorated efficiency, because interactions among molecules shifts a maximum light emitting wavelength to a long wavelength, decreases color purity, or quenches light emitting effects. Therefore, a host/dopant system is used as a light emitting material in order to improve color purity and increase luminous efficiency and stability through energy transfer.

In order to implement excellent performance of an organic light emitting diode, a material constituting an organic material layer, for example a hole injection material, a hole transport material, a light emitting material, an electron transport material, an electron injection material, and a light emitting material such as a host and/or a dopant should be stable and have good efficiency. However, development of a material forming an organic material layer for an organic light emitting diode is not satisfactory but required of better stability and efficiency. This material development is also required for other organic photoelectric devices.

In general, an organic light emitting diode is classified into a low molecular organic light emitting diode and a polymer organic light emitting diode. The low molecular organic light emitting diode is fabricated in a form of a thin film using a vacuum deposit method and thus, may have excellent efficiency and life-span performance. On the other hand, the polymer organic light emitting diode may be fabricated using an inkjet method or a spin coating method and thus, may cost small in the initial step but have a large area.

Both of the low molecular organic light emitting diode and the polymer organic light emitting diode have spontaneous light emission, fast response speed, photviewing angle, ultra thin film, high image quality, durability, broad operation temperature range, and the like and thus, draw attention as a next generation display. In particular, the low molecular organic light emitting diode and the polymer organic light emitting diode spontaneously emit light and thus, have good visibility in a dark place or against an external light with no need of a backlight. Accordingly, they may be fabricated to have about 1/3 less thickness and weight than a conventional liquid crystal display (LCD).

In addition, the low molecular organic light emitting diode and the polymer organic light emitting diode have more than 1000 times faster response speed than LCD by a micro second and thus, may realize a perfect motion picture without an after-image. Accordingly, the low molecular organic light emitting diode and the polymer organic light emitting diode are expected to be an optimum display in a multimedia era, since they have 80 times improved efficiency and more than 100 times improved life-span due to remarkable technological development since the first model was developed in the late 1980s. Recently, the organic light emitting diodes rapidly tend to be bigger, for example, a 40 inch organic light emitting diode panel and the like.

Development of organic light emitting diodes with a big size should be accompanied with improved luminous efficiency and improved life-span. Herein, luminous efficiency of a device requires smooth combination of a hole with an electron in an emission layer. However, since an organic material has slower electron mobility than hole mobility, an electron transport layer (ETL) needs to be used to increase electron injection and mobility from a cathode and simultaneously, to block hole mobility, so that a hole may be efficiently combined with an electron in an emission layer.

In addition the organic material is prevented from crystallization due to Joule heat generated during operation to improve life-span of a device. Therefore, required is development of an organic compound with excellent electron injection and mobility and high electrochemical stability.

### SUMMARY OF THE INVENTION

A compound for an organic optoelectronic device that may act as a hole injection and hole transport, or an electron injection and transport, and also act as a light emitting host along with an appropriate dopant is provided.

An organic photoelectric device having excellent life span, efficiency, driving voltage, electrochemical stability, and thermal stability is provided.

According to one embodiment of the present invention, a compound for an organic optoelectronic device represented by the following Chemical Formula 1 is provided.

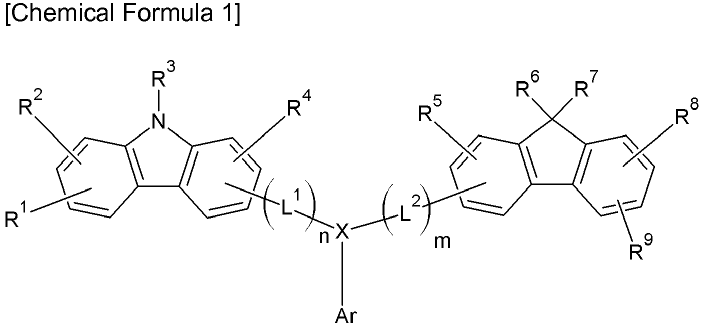

In Chemical Formula 1, Ar is a substituted or unsubstituted biphenyl group; a substituted or unsubstituted dibenzofuranyl group; or a substituted or unsubstituted dibenzothiophenyl group,
X is N, B, or P,
L¹ and L² are the same or different and independently a single bond, a substituted or unsubstituted C2 to C10 alkenylene group, a substituted or unsubstituted C2 to C10 alkynylene group, a substituted or unsubstituted C6 to C30 arylene group or a substituted or unsubstituted C2 to C30 heteroarylene group,
n and m are the same or different and independently integers ranging from 0 to 3, and
R¹ to R⁹ are the same or different and independently hydrogen, deuterium, a halogen, a cyano group, a hydroxyl group, an amino group, a substituted or unsubstituted C1 to C20 amine group, a nitro group, a carboxyl group, a ferroceny group, a substituted or unsubstituted C1 to C20 alkyl group, a substituted or unsubstituted C6 to C30 aryl group, a substituted or unsubstituted C2 to C30 heteroaryl group, a substituted or unsubstituted C1 to C20 alkoxy group, a substituted or unsubstituted C6 to C20 aryloxy group, a substituted or unsubstituted C3 to C40 silyloxy group, a substituted or unsubstituted C1 to C20 acyl group, a substituted or unsubstituted C2 to C20 alkoxycarbonyl group, a substituted or unsubstituted C2 to C20 acyloxy group, a substituted or unsubstituted C2 to C20 acylamino group, a substituted or unsubstituted C2 to C20 alkoxycarbonylamino group, a substituted or unsubstituted C7 to C20 aryloxycarbonylamino group, a substituted or unsubstituted C1 to C20 sulfamoylamino group, a substituted or unsubstituted C1 to C20 sulfonyl group, a substituted or unsubstituted C1 to C20 alkylthiol group, a substituted or unsubstituted C6 to C20 arylthiol group, a substituted or unsubstituted C1 to C20 heterocyclothiol group, a substituted or unsubstituted C1 to C20 ureide group, a substituted or unsubstituted C3 to C40 silyl group, or a combination thereof, wherein
when Ar is a substituted or unsubstituted biphenyl group, the Chemical Formula 1 is represented by the following Chemical Formula B-1:

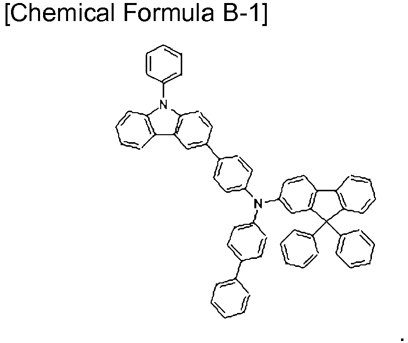

The compound for an organic optoelectronic device may be a compound represented by the following Chemical Formula 3.

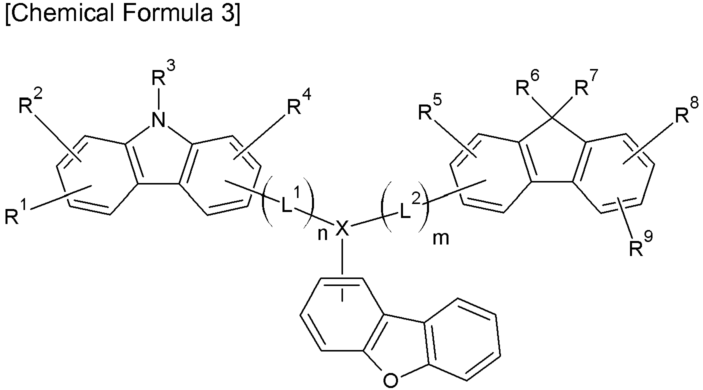

In Chemical Formula 3, X is N, B, or P,
L¹ and L² are the same or different and independently a single bond, a substituted or unsubstituted C2 to C10 alkenylene group, a substituted or unsubstituted C2 to C10 alkynylene group, a substituted or unsubstituted C6 to C30 arylene group or a substituted or unsubstituted C2 to C30 heteroarylene group,
n and m are the same or different and independently integers ranging from 0 to 3, and
R¹ to R⁹ are the same or different and independently hydrogen, deuterium, a halogen, a cyano group, a hydroxyl group, an amino group, a substituted or unsubstituted C1 to C20 amine group, a nitro group, a carboxyl group, a ferroceny group, a substituted or unsubstituted C1 to C20 alkyl group, a substituted or unsubstituted C6 to C30 aryl group, a substituted or unsubstituted C2 to C30 heteroaryl group, a substituted or unsubstituted C1 to C20 alkoxy group, a substituted or unsubstituted C6 to C20 aryloxy group, a substituted or unsubstituted C3 to C40 silyloxy group, a substituted or unsubstituted C1 to C20 acyl group, a substituted or unsubstituted C2 to C20 alkoxycarbonyl group, a substituted or unsubstituted C2 to C20 acyloxy group, a substituted or unsubstituted C2 to C20 acylamino group, a substituted or unsubstituted C2 to C20 alkoxycarbonylamino group, a substituted or unsubstituted C7 to C20 aryloxycarbonylamino group, a substituted or unsubstituted C1 to C20 sulfamoylamino group, a substituted or unsubstituted C1 to C20 sulfonyl group, a substituted or unsubstituted C1 to C20 alkylthiol group, a substituted or unsubstituted C6 to C20 arylthiol group, a substituted or unsubstituted C1 to C20 heterocyclothiol group, a substituted or unsubstituted C1 to C20 ureide group, a substituted or unsubstituted C3 to C40 silyl group, or a combination thereof.

The compound for an organic optoelectronic device may be a compound represented by the following Chemical Formula 4.

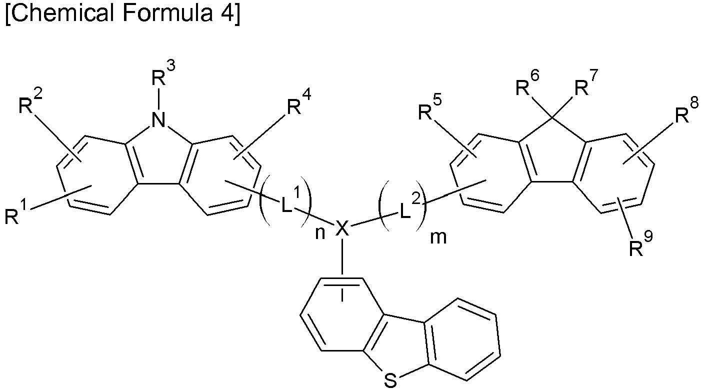

In Chemical Formula 4, X is N, B, or P,
L¹ and L² are the same or different and independently a single bond, a substituted or unsubstituted C2 to C10 alkenylene group, a substituted or unsubstituted C2 to C10 alkynylene group, a substituted or unsubstituted C6 to C30 arylene group or a substituted or unsubstituted C2 to C30 heteroarylene group,
n and m are the same or different and independently integers ranging from 0 to 3,
R¹ to R⁹ are the same or different and independently hydrogen, deuterium, a halogen, a cyano group, a hydroxyl group, an amino group, a substituted or unsubstituted C1 to C20 amine group, a nitro group, a carboxyl group, a ferroceny group, a substituted or unsubstituted C1 to C20 alkyl group, a substituted or unsubstituted C6 to C30 aryl group, a substituted or unsubstituted C2 to C30 heteroaryl group, a substituted or unsubstituted C1 to C20 alkoxy group, a substituted or unsubstituted C6 to C20 aryloxy group, a substituted or unsubstituted C3 to C40 silyloxy group, a substituted or unsubstituted C1 to C20 acyl group, a substituted or unsubstituted C2 to C20 alkoxycarbonyl group, a substituted or unsubstituted C2 to C20 acyloxy group, a substituted or unsubstituted C2 to C20 acylamino group, a substituted or unsubstituted C2 to C20 alkoxycarbonylamino group, a substituted or unsubstituted C7 to C20 aryloxycarbonylamino group, a substituted or unsubstituted C1 to C20 sulfamoylamino group, a substituted or unsubstituted C1 to C20 sulfonyl group, a substituted or unsubstituted C1 to C20 alkylthiol group, a substituted or unsubstituted C6 to C20 arylthiol group, a substituted or unsubstituted C1 to C20 heterocyclothiol group, a substituted or unsubstituted C1 to C20 ureide group, a substituted or unsubstituted C3 to C40 silyl group, or a combination thereof.

The compound for an organic optoelectronic device may be one of compounds represented by the following Chemical Formulas A-2 to A-9, A-11 to A-18, A-20 to A-27, A-29 to A-36, A-38 to A-45, A-47 to A-54, A-57 to A-60, A-62 to A-65, A-68 to A-75, A-78 to A-85, A-88 to A-95.

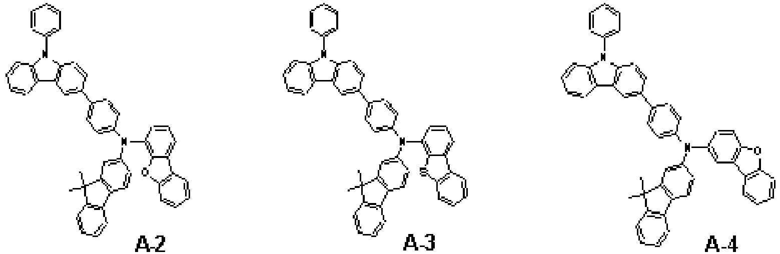

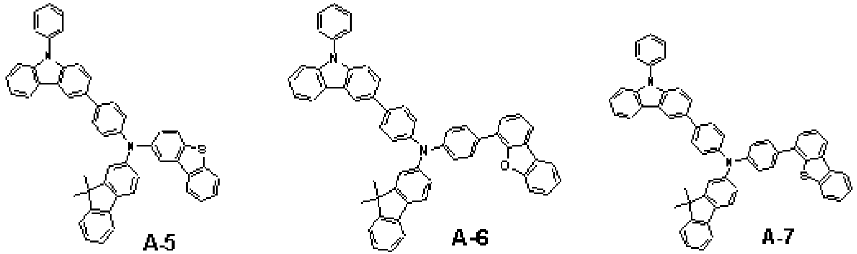

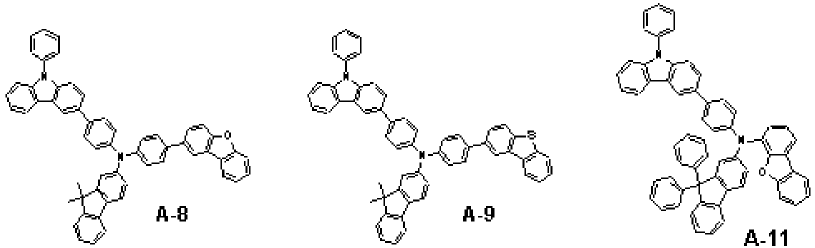

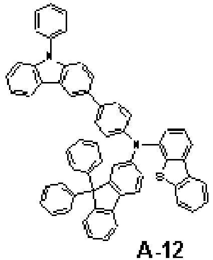

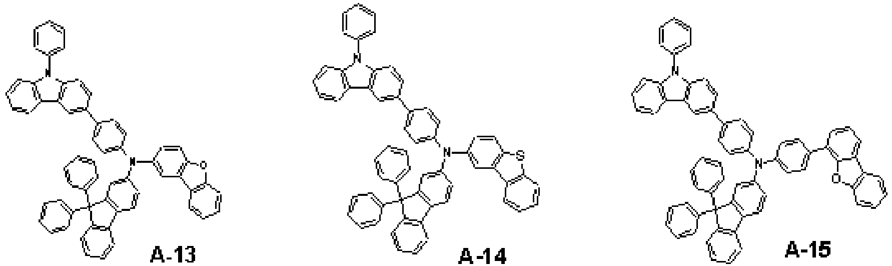

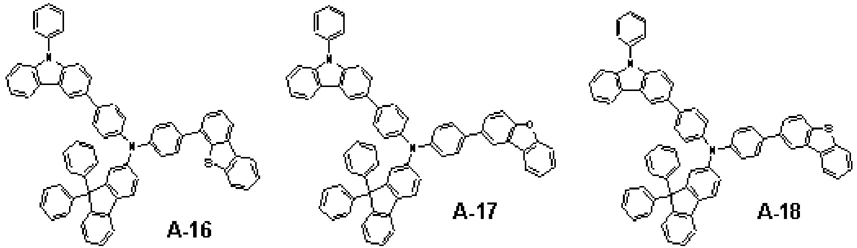

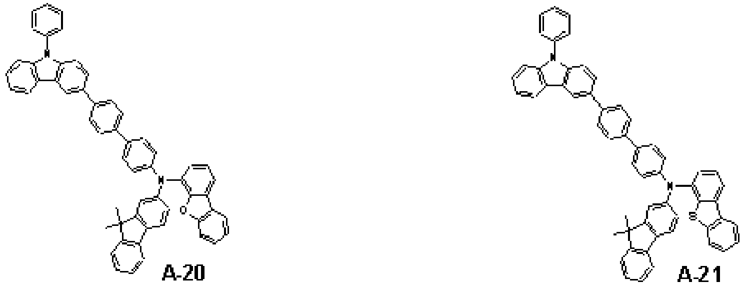

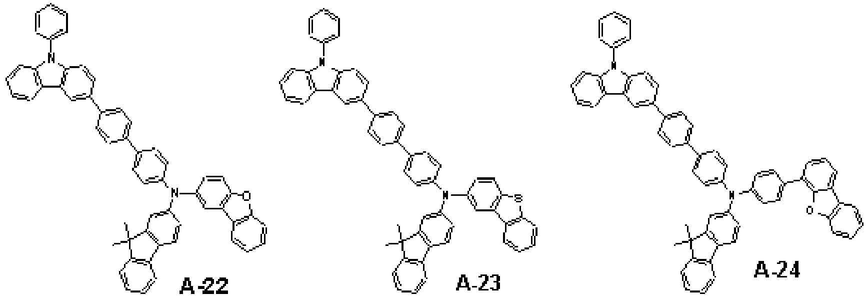

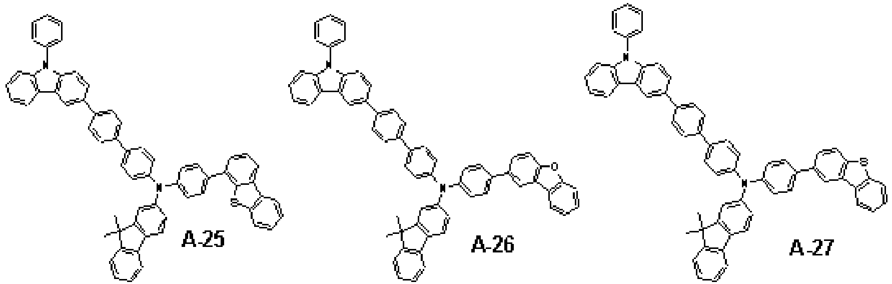

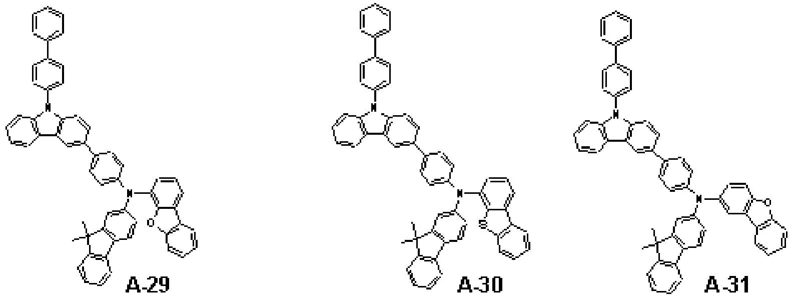

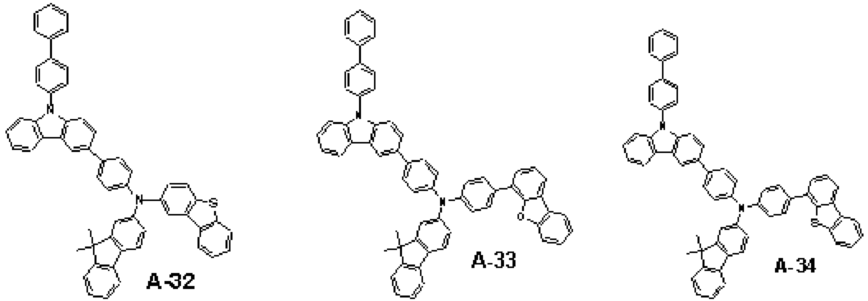

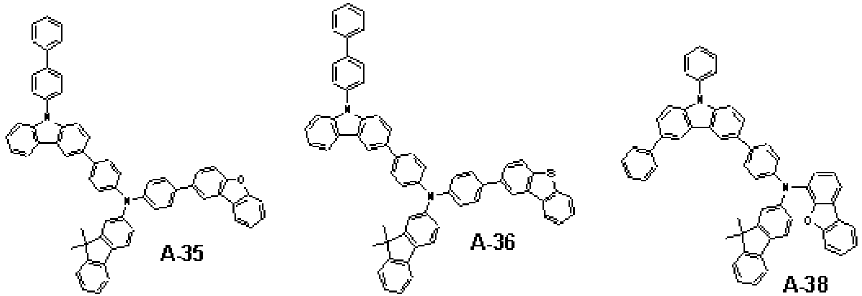

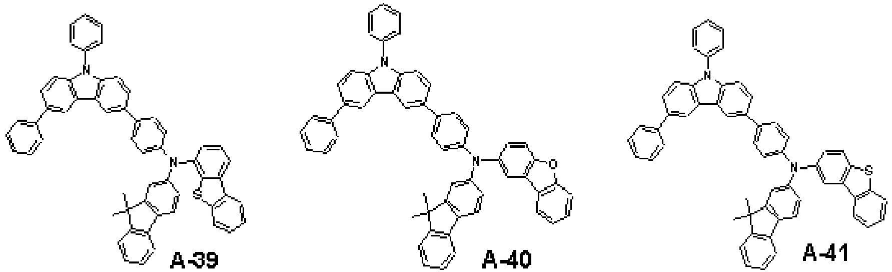

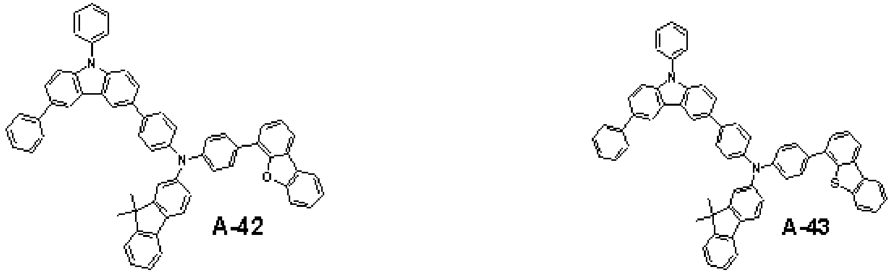

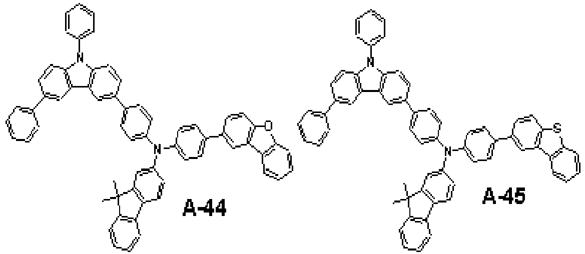

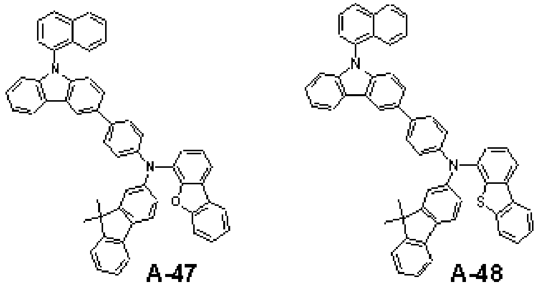

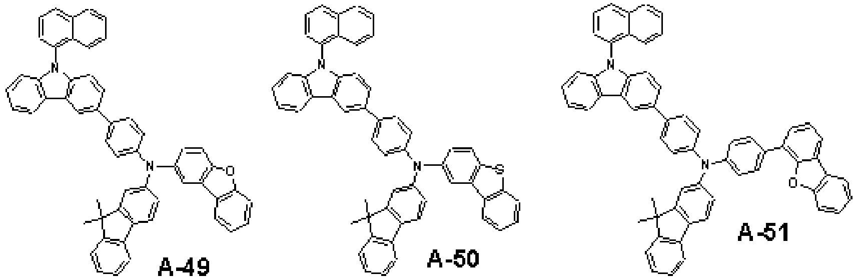

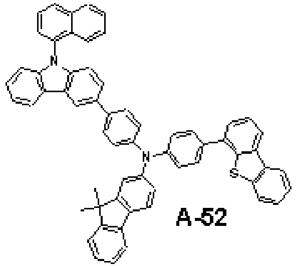

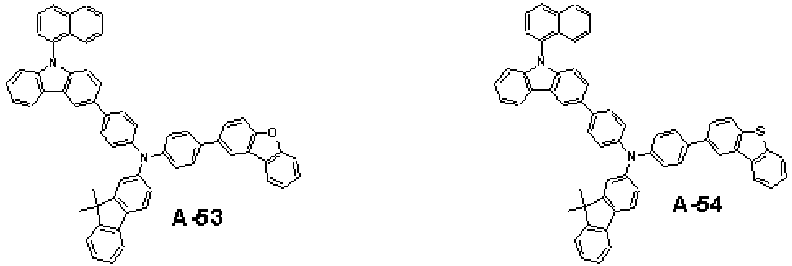

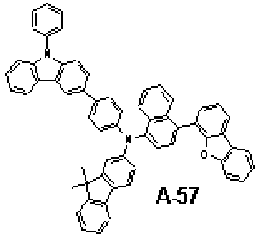

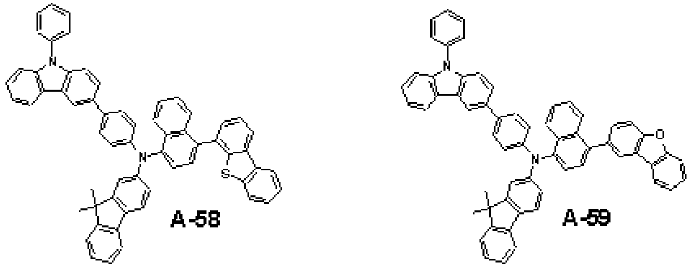

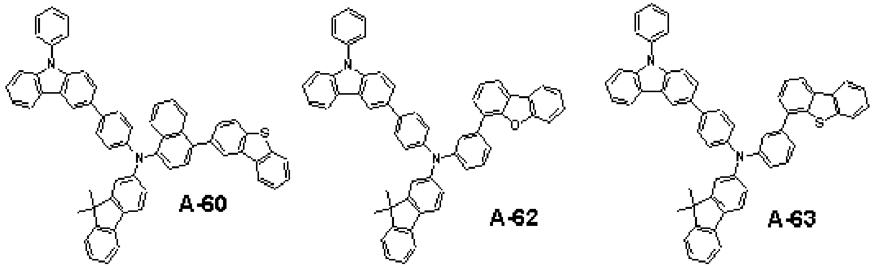

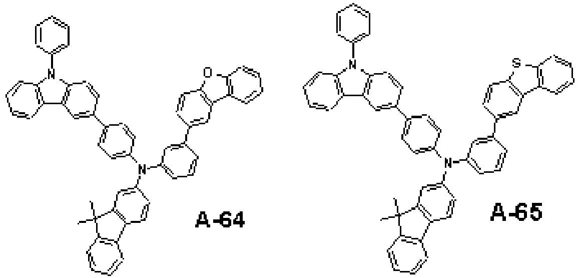

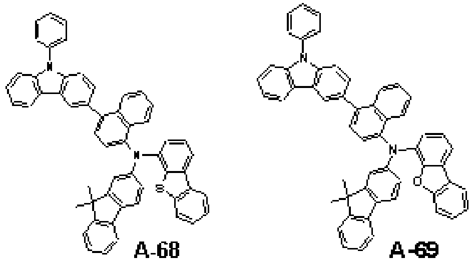

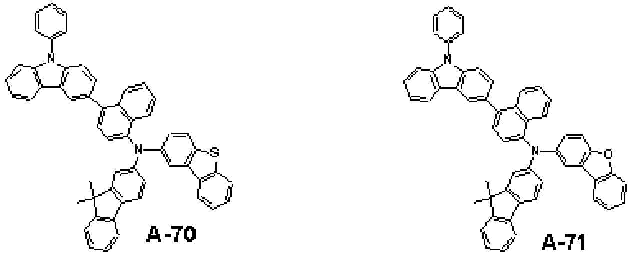

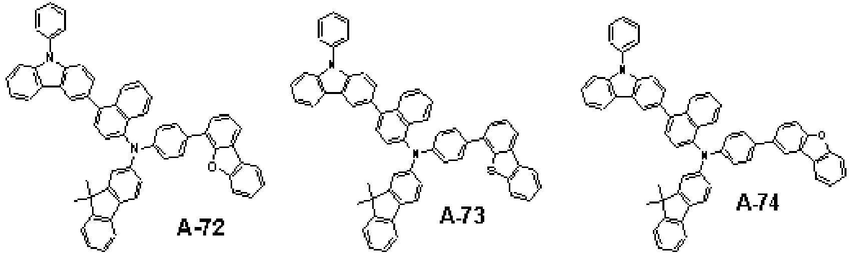

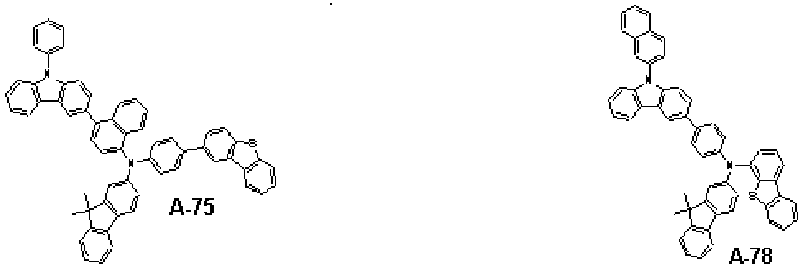

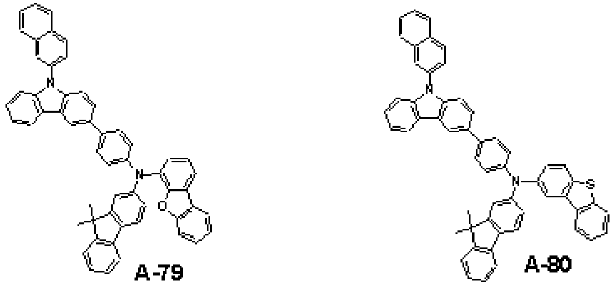

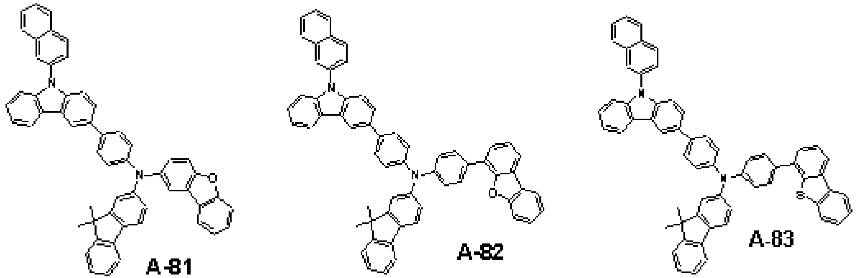

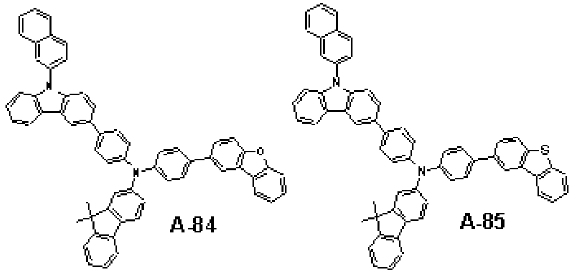

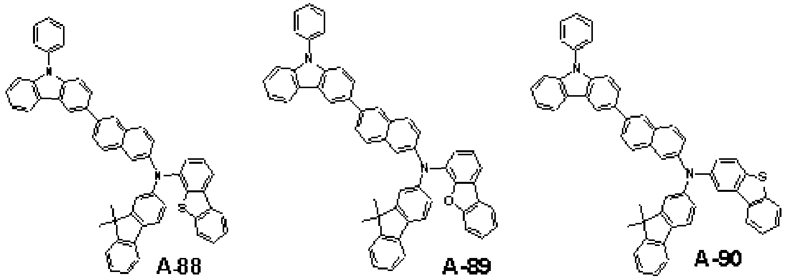

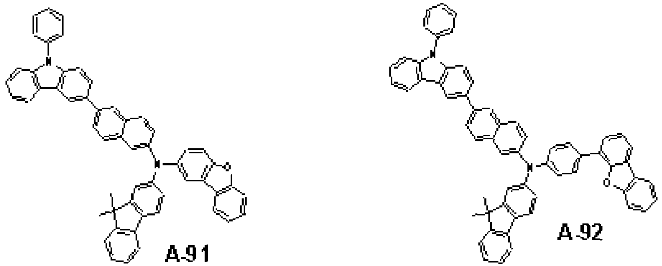

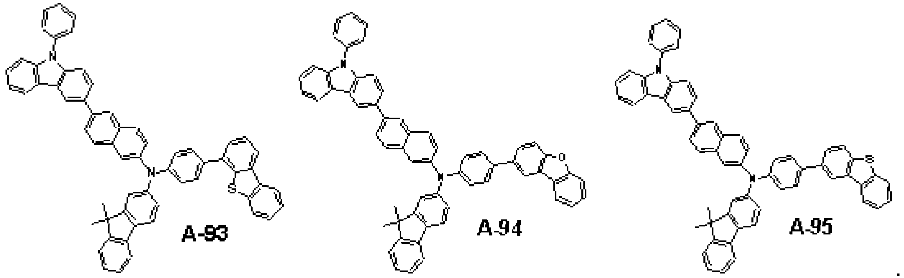

The compound for an organic optoelectronic device may be one of compounds represented by the following Chemical Formula B-1.

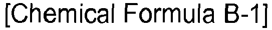

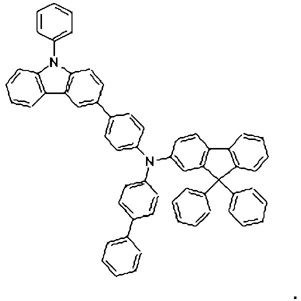

The compound for an organic optoelectronic device may bs used as a hole transport material or hole injection material of an organic light emitting diode.

The compound for an organic optoelectronic device may have triplet excitation energy (T1) of 2.0eV or more.

The organic optoelectronic device may be selected from organic photoelectronic device, organic light emitting diode, an organic solar cell, an organic transistor, an organic photosensitive drum, and organic memory device.

According to another embodiment of the present invention, organic light emitting diode includes an anode, a cathode, and at least one organic thin layer interposed between the anode and the cathode, wherein at least one organic thin layer may provide an organic photoelectric device including the compound for an organic optoelectronic device according to one embodiment.

The organic thin layer may be selected from an emission layer, a hole transport layer (HTL), a hole injection layer (HIL), a electron transport layer (ETL), an electron injection layer (EIL), a hole blocking layer, a combination thereof.

The compound for an organic optoelectronic device may be included in one of a hole transport layer (HTL), a hole injection layer (HIL), an electron transport layer (ETL), or an electron injection layer (EIL).

The compound for an organic optoelectronic device may be included in an emission layer.

The compound for an organic optoelectronic device may be included in an emission layer as a phosphorescent or fluorescent host material.

The compound for an organic optoelectronic device may be included in an emission layer as a fluorescent blue dopant material.

According to yet another embodiment of the present invention, a display device including the organic light emitting diode is provided.

The compound has high hole or electron transporting properties, film stability, thermal stability and high triplet excitation energy.

The compound may be used in an emission layer as a hole injection/transport material, a host material, or an electron injection/transport material. The organic photoelectric device including the compound excellent life-span, and luminous efficiency while having low driving voltages due to excellent electrochemical and thermal stability.

### BRIEF DESCRIPTION OF THE DRAWINGS

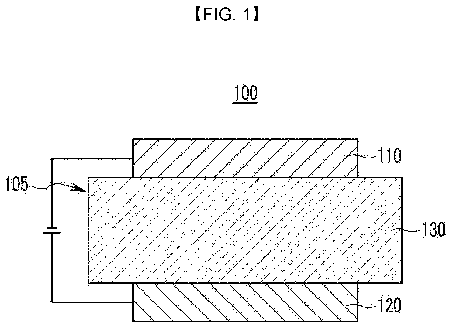

FIGS. 1 to 5 are cross-sectional views showing organic light emmiting diodes including compounds according to various embodiments of the present invention.

### DETAILED DESCRIPTION

Exemplary embodiments of the present invention will hereinafter be described in detail. However, these embodiments are only exemplary, and the present invention is not limited thereto.

As used herein, when a definition is not otherwise provided, the term "substituted" may refer to one substituted with deuterium, a halogen, a hydroxy group, an amino group, a substituted or unsubstituted C1 to C20 amine group, nitro group, a substituted or unsubstituted C3 to C40 silyl group, a C1 to C30 alkyl group, a C1 to C10 alkylsilyl group, a C3 to C30 cycloalkyl group, a C6 to C30 aryl group, a C1 to C20 alkoxy group, a fluoro group, a C1 to C10 trifluoroalkyl group such as a trifluoromethyl group, or a cyano group, instead of at least hydrogen of substituents or compounds.

As used herein, when specific definition is not otherwise provided, the prefix "hetero" may refer to one including 1 to 3 of N, O, S, or P, and remaining carbons in one ring.

As used herein, when a definition is not otherwise provided, the term "combination thereof" may refer to at least two substituents bound to each other by a linker, or at least two substituents condensed to each other.

As used herein, when a definition is not otherwise provided, the term "alkyl group" may refer to an aliphatic hydrocarbon group. The alkyl group may be a saturated alkyl group that does not include any alkene group or alkyne group. Alternatively, the alkyl may be an unsaturated alkyl group that includes at least one alkene group or alkyne group. The term "alkene" group may refer to a group in which at least two carbon atoms are bound in at least one carbon-carbon double bond, and the term "alkyne" group may refer to a group in which at least two carbon atoms are bound in at least one carbon-carbon triple bond. Regardless of being saturated or unsaturated, the alkyl may be branched, linear, or cyclic.

The alkyl group may have 1 to 20 carbon atoms. The alkyl group may be a medium-sized alkyl having 1 to 10 carbon atoms. The alkyl group may be a lower alkyl having 1 to 6 carbon atoms.

For example, a C1-C4 alkyl may have 1 to 4 carbon atoms and may be selected from the group consisting of methyl, ethyl, propyl, iso-propyl, n-butyl, iso-butyl, sec-butyl, and t-butyl.

Examples of an alkyl group may be selected from a methyl group, an ethyl group, a propyl group, an isopropyl group, a butyl group, an isobutyl group, a t-butyl group, a pentyl group, a hexyl group, an ethenyl group, a propenyl group, a butenyl group, a cyclopropyl group, a cyclobutyl group, a cyclopentyl group, a cyclohexyl group, which may be individually and independently substituted.

The term "aromatic group" may refer to a cyclic functional group where all elements have conjugated p-orbital. Examples of the aromatic group include an aryl group and a heteroaryl group.

The term "aryl" group may refer to an aryl group including a carbocyclic aryl (e.g., phenyl) having at least one ring having a covalent pi electron system.

The term "heteroaryl group" may refer to an aryl group where 1 to 3 heteroatoms selected from N, O, S, and P, and remaining carbon. When the heteroaryl group is a fused ring, each ring may include 1 to 3 heteroatoms.

The term "spiro structure" may refer to a cyclic structure having a common carbon contact point. The term spiro structure may refer to a compound or substituent having a spiro structure.

According to one embodiment of the present invention, a compound for an organic optoelectronic device may have a core structure including carbazolyl and fluorenyl groups as a substituent linked to an N, B, or P atom.

Since a carbazolyl group with excellent hole properties is linkedto an N, B or P atom in the core structure, the compound may be used as a hole injection material or a hole transport material for an organic light emitting diode.

At least one substituent combined to the core may have excellent electron properties. Accordingly, the compound has the core structure having excellent hole properties and is reinforced with electron properties of the substituent and thus, satisfy a condition required from an emission layer. In particular, the compound may be used as a host material for an emission layer.

The hole properties are that holes generated at an anode are easily injected into an emission layer and moved therein due to conductive properties according to HOMO levels.

In addition, the electron properties are that electrons generated at a cathode are easily injected into an emission layer and moved therein due to conductive properties according to LUMO levels.

Furthermore, the compound for an organic optoelectronic device has a core and various substituents substituted in the core and thus, various energy band gaps.

When a compound having various energy levels according to a substituent is used for an organic photoelectric device, it may reinforce hole transport capability or electron transport capability and thus, have excellent effects on efficiency and driving voltage and also, excellent electrochemical and thermal stability, resultantly improving life-span of the organic photoelectric device.

According to one embodiment of the present invention, a compound for an organic optoelectronic device represented by the following Chemical Formula 1 is provided.

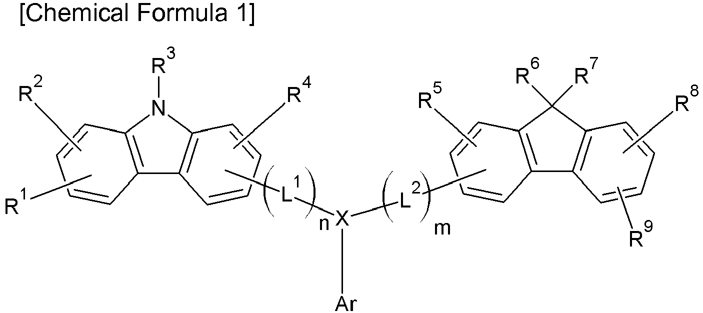

In Chemical Formula 1, Ar is a substituted or unsubstituted biphenyl group; a substituted or unsubstituted dibenzofuranyl group; or substituted or unsubstituted dibenzothiophenyl group,
X is N, B, or P,
L¹ and L² are the same or different and independently a single bond, a substituted or unsubstituted C2 to C10 alkenylene group, a substituted or unsubstituted C2 to C10 alkynylene group, a substituted or unsubstituted C6 to C30 arylene group or a substituted or unsubstituted C2 to C30 heteroarylene group,
n and m are the same or different and independently integers ranging from 0 to 3, and
R¹ to R⁹ are the same or different and independently hydrogen, deuterium, a halogen, a cyano group, a hydroxyl group, an amino group, a substituted or unsubstituted C1 to C20 amine group, a nitro group, a carboxyl group, a ferroceny group, a substituted or unsubstituted C1 to C20 alkyl group, a substituted or unsubstituted C6 to C30 aryl group, a substituted or unsubstituted C2 to C30 heteroaryl group, a substituted or unsubstituted C1 to C20 alkoxy group, a substituted or unsubstituted C6 to C20 aryloxy group, a substituted or unsubstituted C3 to C40 silyloxy group, a substituted or unsubstituted C1 to C20 acyl group, a substituted or unsubstituted C2 to C20 alkoxycarbonyl group, a substituted or unsubstituted C2 to C20 acyloxy group, a substituted or unsubstituted C2 to C20 acylamino group, a substituted or unsubstituted C2 to C20 alkoxycarbonylamino group, a substituted or unsubstituted C7 to C20 aryloxycarbonylamino group, a substituted or unsubstituted C1 to C20 sulfamoylamino group, a substituted or unsubstituted C1 to C20 sulfonyl group, a substituted or unsubstituted C1 to C20 alkylthiol group, a substituted or unsubstituted C6 to C20 arylthiol group, a substituted or unsubstituted C1 to C20 heterocyclothiol group, a substituted or unsubstituted C1 to C20 ureide group, a substituted or unsubstituted C3 to C40 silyl group, or a combination thereof.

When the Ar and R¹ to R⁹ substituents are appropriately combined, a compound for an organic optoelectronic device may have excellent hole or electron properties, film stability, thermal stability and high triplet excitation energy (T1). In addition, the compound may have excellent thermal stability or excellent resistance against oxidation due to appropriate combination of the substituents.

The compound represented by the above Chemical Formula 1 has an unsymmetrical bipolar structure. The unsymmetrical bipolar structure may improve hole and electron transport capabilities and thus, improve luminous efficiency and performance of a device.

In the unsymmetrical bipolar structure, substituents may be adjusted to prepare a compound with a bulky structure and thus, lower crystalline. The compound with lower crystalline may improve life-span of a device.

In Chemical Formula 1, Ar may not be a carbazolyl group. In other words, X, a core atom, in the above Chemical Formula 1 may not be substituted with more than two carbazolyl groups. The reason is that a compound has increased symmetry and thus, increased crystalline.

The L¹, L², n, and m may be adjusted to control length of a compound, which may adjustπ-conjugation length of the compound. Accordingly, the compound may be adjusted regarding a triplet energy bandgap and thus, usefully applied to an emission layer for an organic photoelectric device as a phosphorescent host
In addition, when a heteroaryl group is introduced as the substituent, a compound may have a molecule structure with bipolar properties and realize high efficiency as a phosphorescent host.

In Chemical Formula 1, a fluorenyl group, as a substituent for the core, may increase symmetry of a molecule itself and thus, hinder recrystallization of a compound. Accordingly, when this compound is used for a hole injection layer and a hole transport layer (HTL) for an organic electric field light emitting element, it may accomplish long life-span and high efficiency of the element.

The Ar is a substituted or unsubstituted biphenyl group; a substituted or unsubstituted dibenzofuranyl group; or a substituted or unsubstituted dibenzothiophenyl group.

When the dibenzofuranyl group or dibenzothiophenyl group 1 having hole transport property is unsymmetrically combined as shown in the above Chemical Formula, it includes a hetero aromatic cycle withdrawing electrons and brings about unsymmetric bipolar properties all over a molecule.

The term "substituted" in the definition of "substituted or unsubstituted" may refer to one substituted with a substituent selected from deuterium, a halogen, a cyano group, a hydroxy group, an amino group, a substituted or unsubstituted C1 to C20 amine group, a nitro group, a substituted or unsubstituted C1 to C20 alkyl group, a substituted or unsubstituted C1 to C20 alkoxy group, a substituted or unsubstituted C3 to C40 silyl group, and a combination thereof, instead of hydrogen of each substituent.

Compared with the aforementioned basic structure of a compound, a "substituted" structure as aforementioned may subtly regulate electric-optical properties and thin film properties to optimize performance of a material for an organic photoelectric device as well as maintain basic properties of a compound.

The compound for an organic organic photoelectric device may be represented by the following Chemical Formula 2.

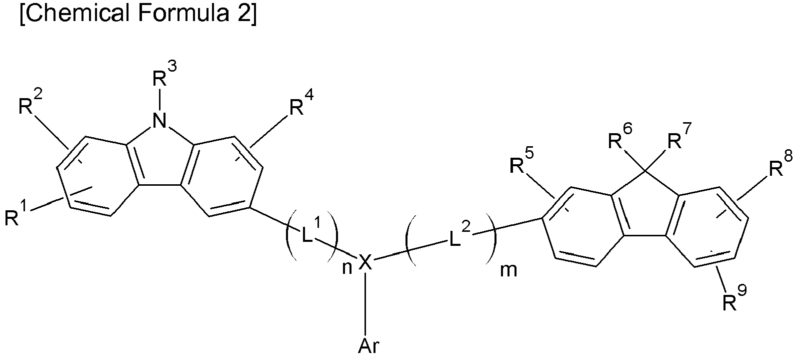

The above Chemical Formula 2 may be the same as the aforementioned Chemical Formula 1 but is limited to combination location. However, when a compound satisfies the combination location of Chemical Formula 2, it may be advantageous in terms of actual synthesis. Other than that, Chemical Formula 2 is the same as Chemical Formula 1 and will not be repeated.

The compound for an organic organic photoelectric device may be represented by the following Chemical Formula 3.

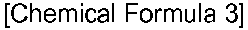

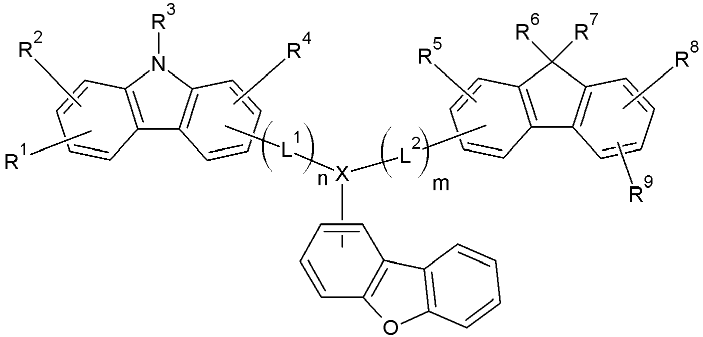

The above structure of Chemical Formula 3 restricts an Ar substituent in the above Chemical Formula 1 to be a dibenzofuranyl group

This structure may improve thermal stability of a material and remarkably increase half life-span of a device.

The compound for an organic organic photoelectric device may be represented by the following Chemical Formula 4.

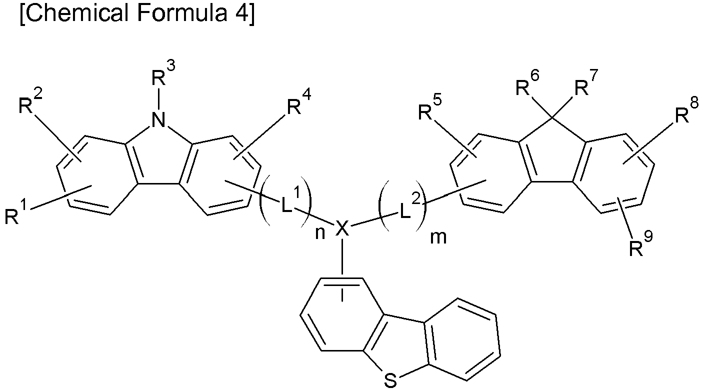

The structure of the above Chemical Formula 4 restricts an Ar substituent in the above Chemical Formula 1 to be a dibenzothiophenyl group. This structure may improve thermal stability of a material and remarkably increases half life-span of a device.

The compound for an organic organic photoelectric device may be represented by one of the following Chemical Formulas below. Since the following structure may accomplish excellent thin film properties and improve thermal stability of a compound due to asymmetry of a molecule and excellent hole transport properties of a carbazolyl group, the compound is applied to a hole injection layer and a hole transport layer (HTL) for an organic electric field light emitting element and thus, may accomplish long life-span and high efficiency of the organic electric field light emitting element.

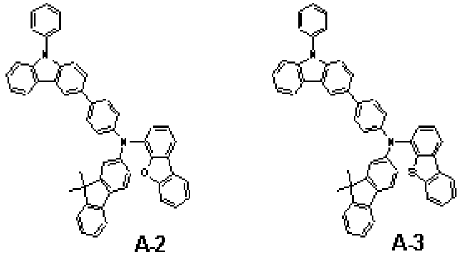

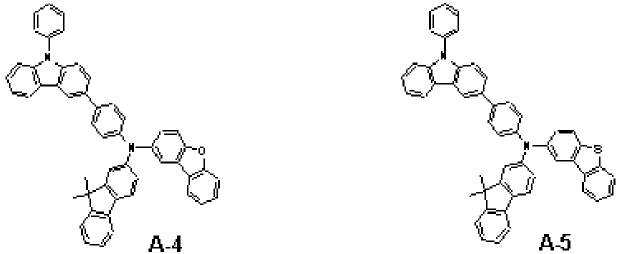

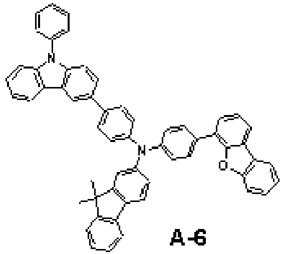

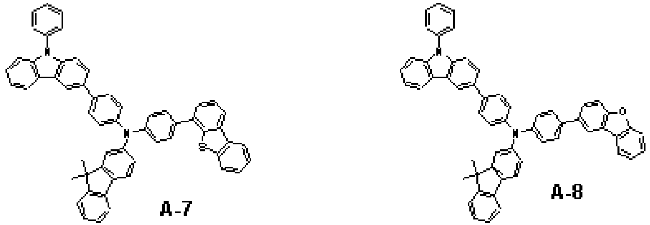

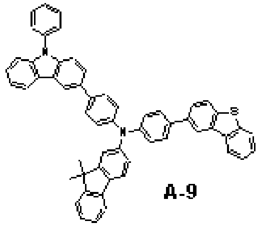

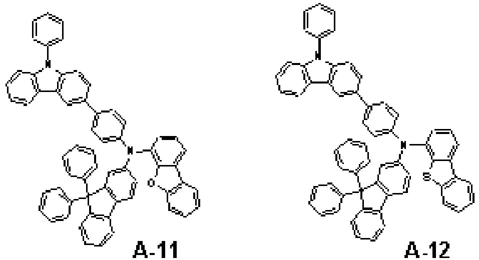

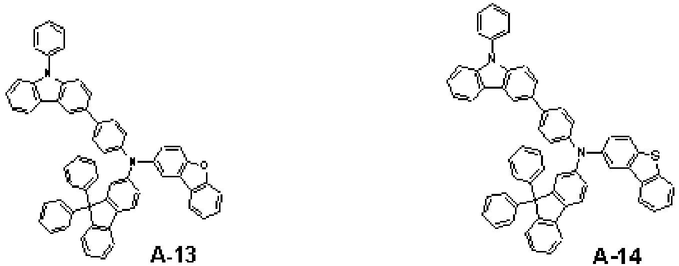

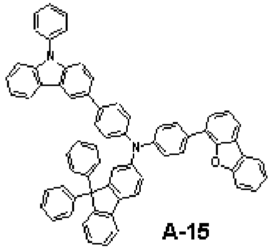

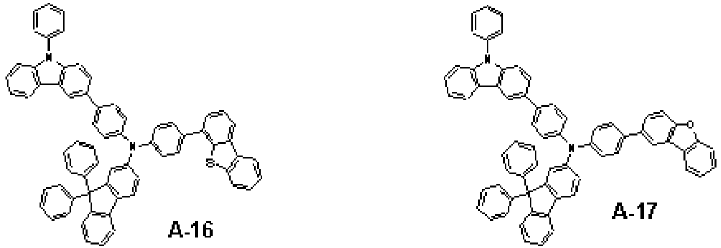

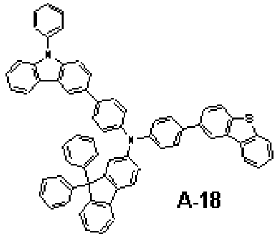

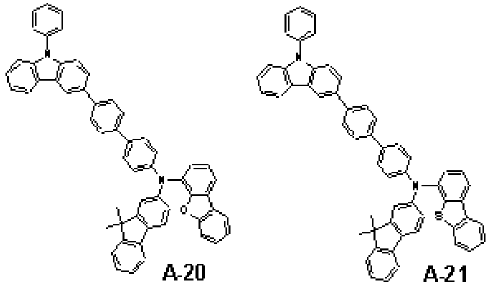

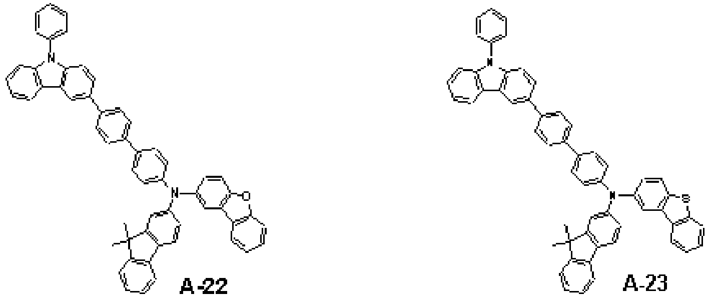

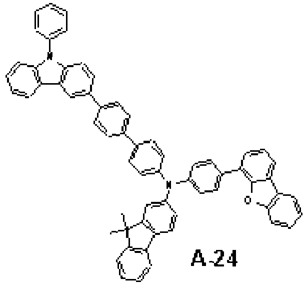

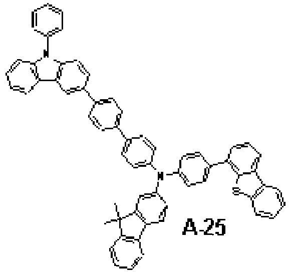

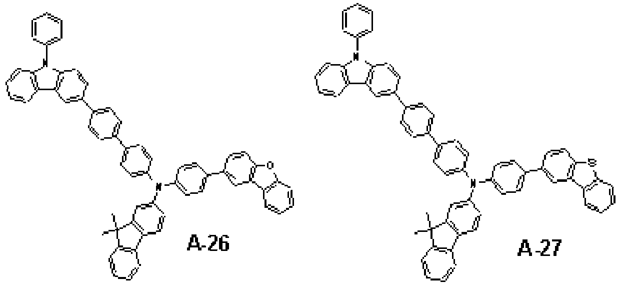

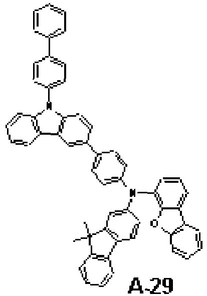

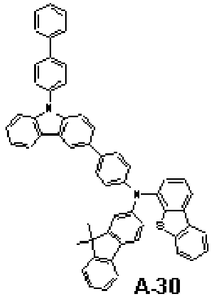

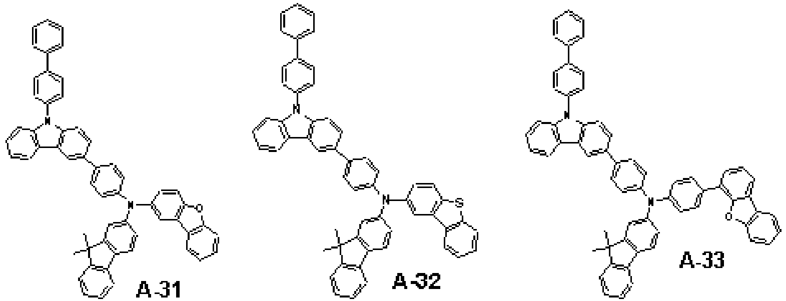

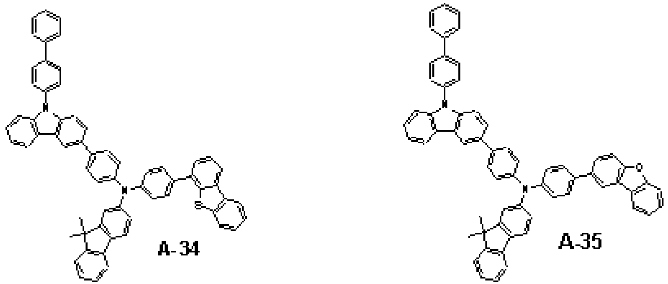

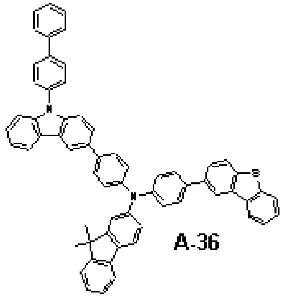

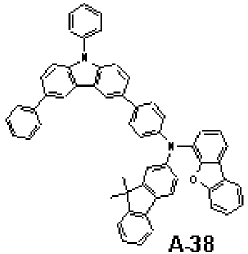

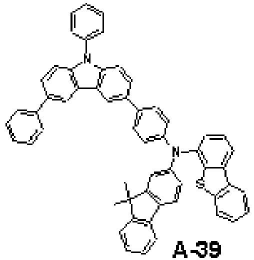

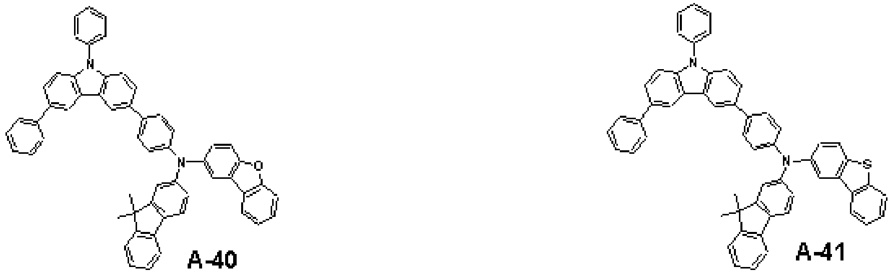

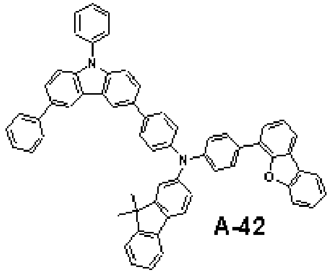

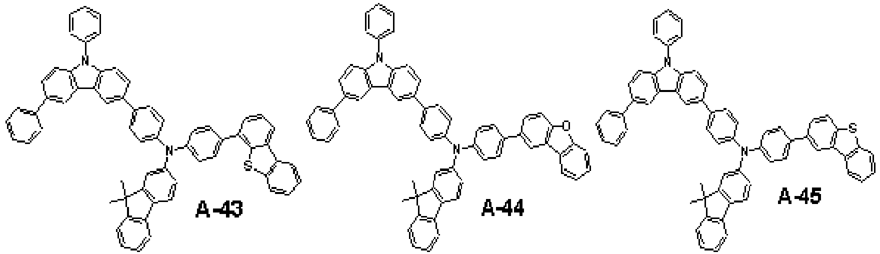

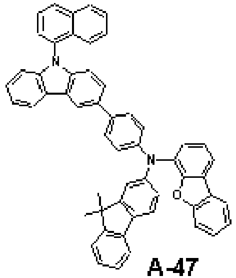

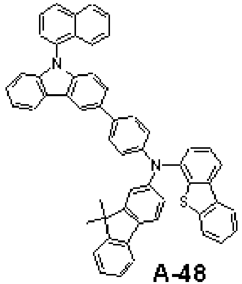

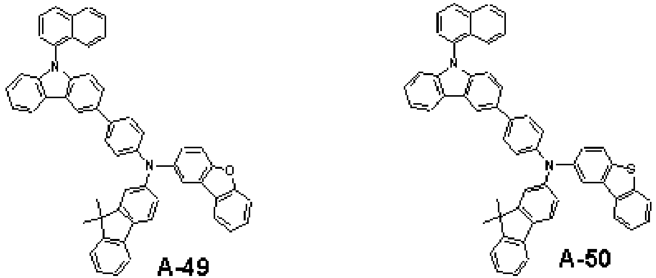

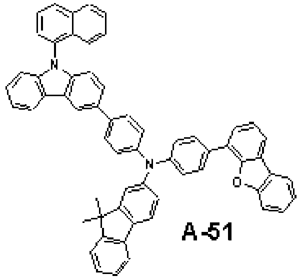

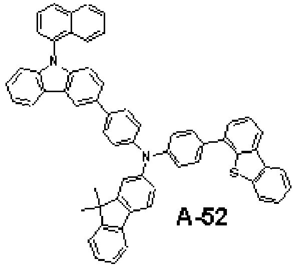

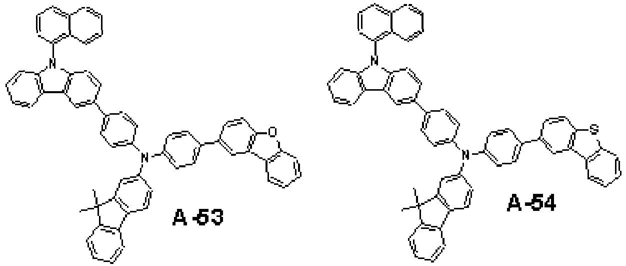

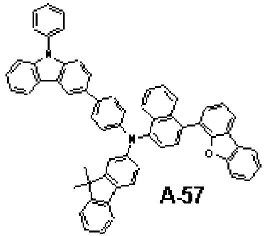

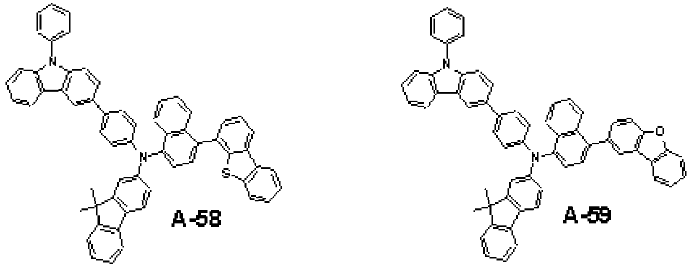

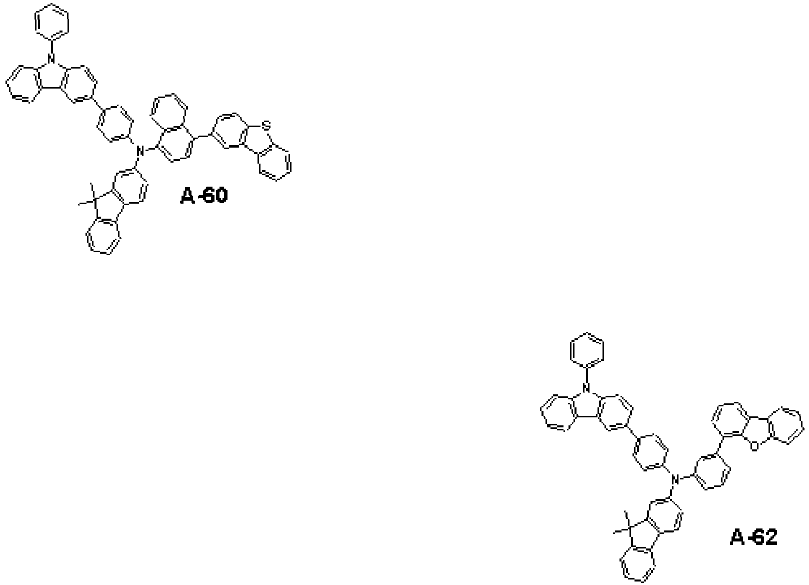

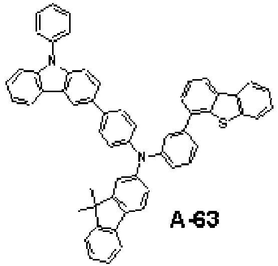

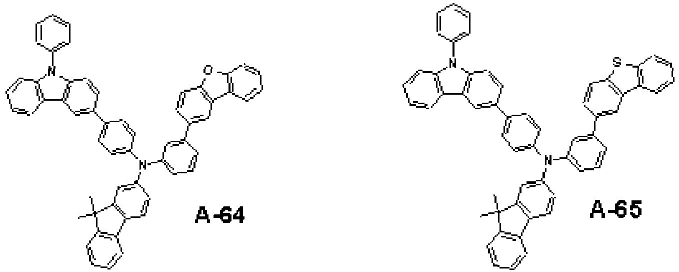

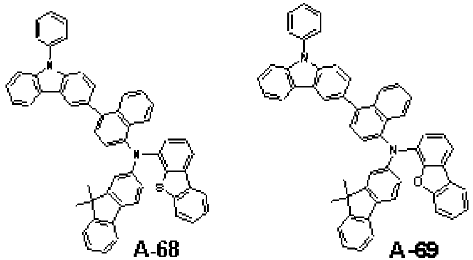

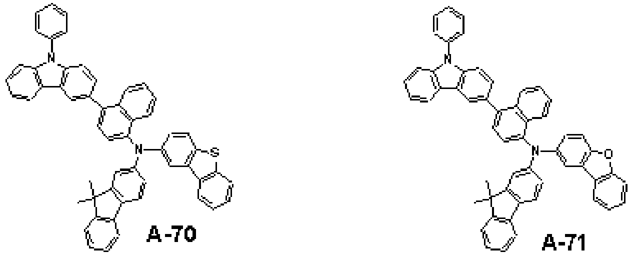

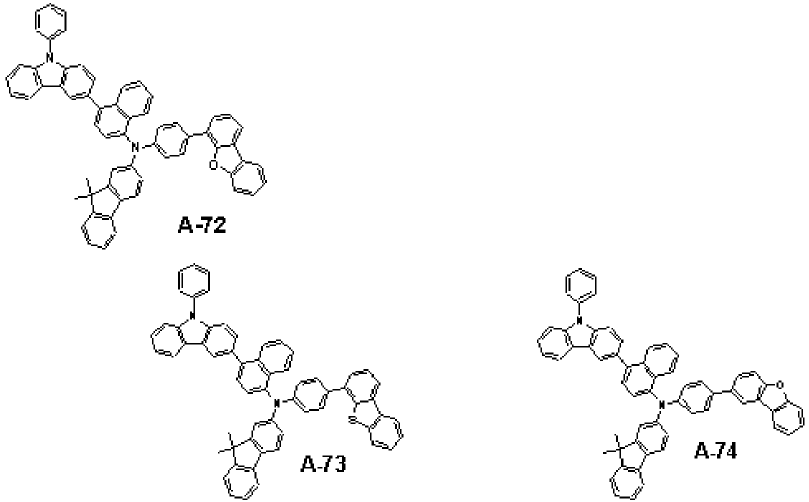

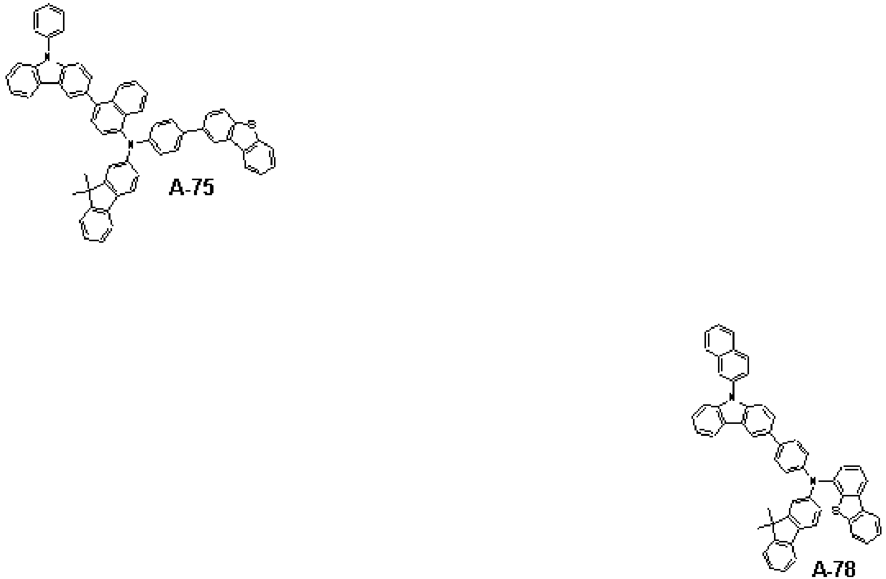

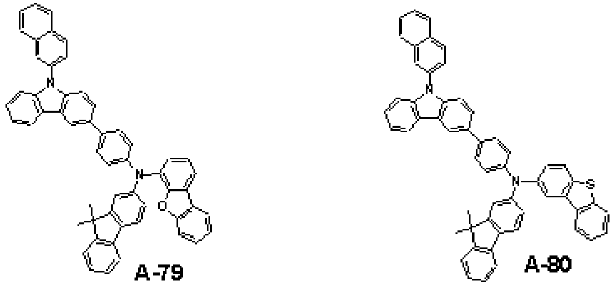

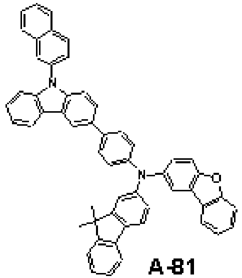

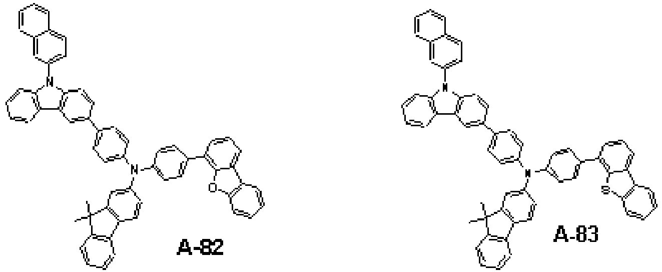

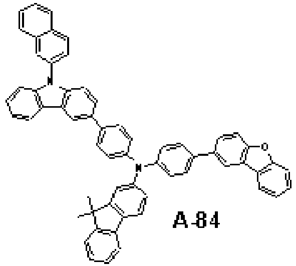

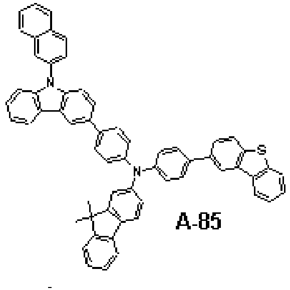

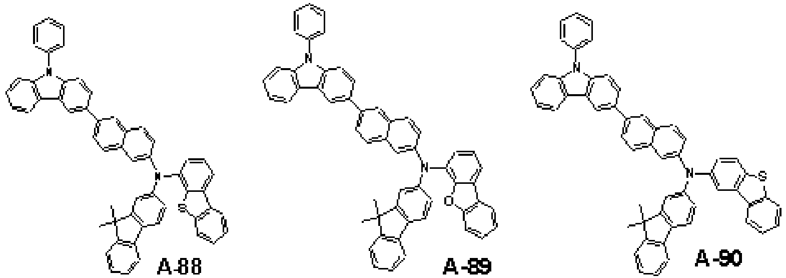

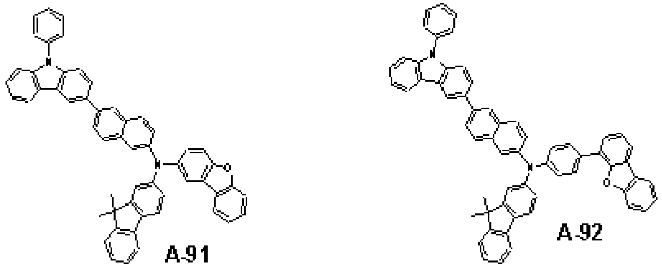

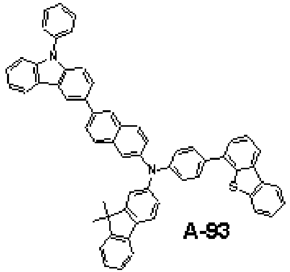

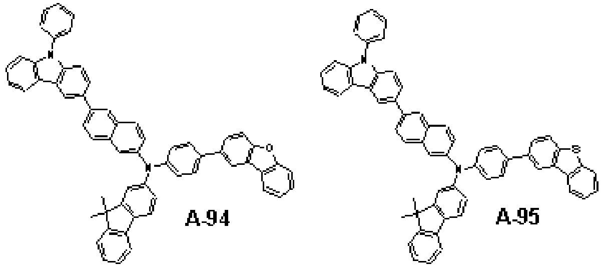

In addition, the compound for an organic optoelectronic device may be represented by one of the following Chemical Formula B-1.

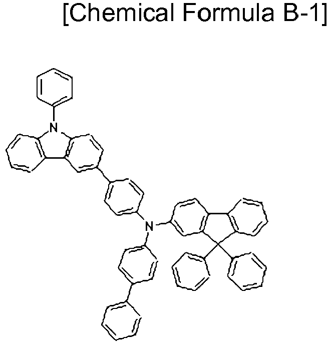

When a material with the structure is used to fabricate an organic photoelectric device (e.g., organic light emitting diode), the device may have excellent life-span.

However, then the compound for an organic optoelectronic device according to one embodiment of the present invention is used to form an electron blocking layer (or a hole transport layer (HTL)), a functional group with electron properties in a molecule may deteriorate electron blocking properties of the electron blocking layer. Accordingly, the compound should not include a functional group with electron properties to form an electron blocking layer. Examples of a functional group with electron properties may include benzoimidazole, pyridine, pyrazine, pyrimidine, triazine, quinoline, isoquinoline, and the like. However, when the compound for an organic optoelectronic device is used for an electron blocking layer or a hole transport layer (HTL) (or a hole injection layer (HIL)), the foresaid description may be limited.

When the aforementioned compound according to one embodiment of the present invention is required of both electron properties and hole properties, the functional group with electron properties may be included in a compound to effectively improve life-span of an organic light emitting diode and decrease its driving voltage.

The aforementioned compound for an organic optoelectronic device according to one embodiment of the present invention may have a maximum light emitting wavelength ranging from about 320 to 500 nm and triplet excitation energy (T1) of more than 2.0 eV, in particular, ranging from 2.0 to 4.0 eV. Accordingly, the compound with high triplet excitation energy (T1) as a host may well transport a charge to a dopant and thus, increase luminous efficiency of the dopant and also, may be freely adjusted according to HOMO and LUMO energy levels and decrease driving voltage of a device. Thus, the compound may be usefully used as a host material or a charge transport material.

In addition, the compound for an organic optoelectronic device has photoactive and electric activity and thus, may be usefully applied to a nonlinear optical material, an electrode material, a discoloring material, an optical switch, a sensor, a module, a wave guide, an organic transistor, a laser, a light-absorbing agent, a dielectric material, a material for a separating membrane, and the like.

The compound for an organic optoelectronic device has a glass transition temperature of 90°C or higher and a thermal decomposition temperature of 400°C or higher and thus, excellent thermal stability. Accordingly, the compound may have high efficiency of an organic photoelectric device.

The compound for an organic optoelectronic device including the above compound may play a role in emitting light or injecting and/or transporting electrons, and it may act as a light emitting host together with a suitable dopant. In other words, the compound for an organic optoelectronic device may be used as a phosphorescent or fluorescent host material, a blue light emitting dopant material, or an electron transporting material.

Since the compound for an organic optoelectronic device according to one embodiment is used for an organic thin layer, it may improve the life span characteristic, efficiency characteristic, electrochemical stability, and thermal stability of an organic photoelectric device, and decrease the driving voltage.

Therefore, according to another embodiment, an organic optoelectronic device is provided that includes the compound for an organic optoelectronic device. The organic optoelectronic device may include and organic photoelectronic device, an organic light emitting diode, an organic solar cell, an organic transistor, an organic photosensitive drum, an organic memory device, or the like. For example, the compound for an organic optoelectronic device according to one embodiment may be included in an electrode or an electrode buffer layer in the organic solar cell to improve quantum efficiency, and it may be used as an electrode material for a gate, a source-drain electrode, or the like in the organic transistor.

Hereinafter, a detailed described relating to the organic light emmiting diode will be provided.

According to another embodiment of the present invention, an organic light emitting diode includes an anode, a cathode, and at least one organic thin layer interposed between the anode and the cathode, wherein at least one organic thin layer may provide an organic photoelectric device including the compound for an organic optoelectronic device according to one embodiment.

The organic thin layer that may include the compound for an organic optoelectronic device may include a layer selected from the group consisting of an emission layer, a hole transport layer (HTL), a hole injection layer (HIL), an electron transport layer (ETL), an electron injection layer (EIL), a hole blocking film, and a combination thereof. The at least one layer includes the compound for an organic optoelectronic device according to one embodiment. Particularly, the electron transport layer (ETL) or the electron injection layer (EIL) may include the compound for an organic optoelectronic device according to one embodiment. In addition, when the compound for an organic optoelectronic device is included in the emission layer, the compound for an organic optoelectronic device may be included as a phosphorescent or fluorescent host, and particularly, as a fluorescent blue dopant material.

FIGS. 1 to 5 are cross-sectional views showing an organic light emitting diode including the compound for an organic optoelectronic device according to one embodiment of the present invention.

Referring to FIGS. 1 to 5, organic light emmiting diodes 100, 200, 300, 400, and 500 according to one embodiment include at least one organic thin layer 105 interposed between an anode 120 and a cathode 110.

The anode 120 includes an anode material laving a large work function to help hole injection into an organic thin layer. The anode material includes: a metal such as nickel, platinum, vanadium, chromium, copper, zinc, and gold, or alloys thereof; a metal oxide such as zinc oxide, indium oxide, indium tin oxide (ITO), and indium zinc oxide (IZO); a combined metal and oxide such as ZnO:AI or SnO₂:Sb; or a conductive polymer such as poly(3-methylthiophene), poly[3,4-(ethylene-1,2-dioxy)thiophene] (PEDT), polypyrrole, and polyaniline, but is not limited thereto. It is preferable to include a transparent electrode including indium tin oxide (ITO) as an anode.

The cathode 110 includes a cathode material having a small work function to help electron injection into an organic thin layer. The cathode material includes: a metal such as magnesium, calcium, sodium, potassium, titanium, indium, yttrium, lithium, gadolinium, aluminum, silver, tin, lead, cesium, barium, and the like, or or alloys thereof; or a multi-layered material such as LiF/Al, LiO₂/Al, LiF/Ca, LiF/Al, and BaF₂/Ca, but is not limited thereto. It is preferable to include a metal electrode including aluminum as a cathode.

Referring to FIG. 1, the organic light emmiting diode 100 includes an organic thin layer 105 including only an emission layer 130.

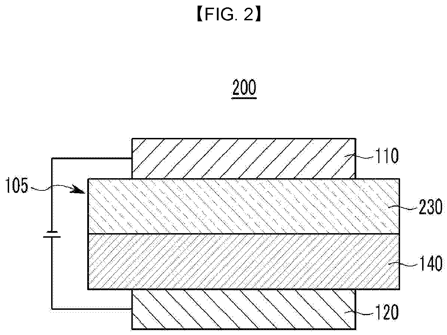

Referring to FIG. 2, the emission layer 130 also functions as an electron transport layer (ETL), and the hole transport layer (HTL) 140 layer has an excellent binding property with a transparent electrode such as ITO or an excellent hole transporting property. The emission layer 130 also functions as an electron transport layer (ETL), and the hole transport layer (HTL) 140 layer has an excellent binding property with a transparent electrode such as ITO or an excellent hole transporting property.

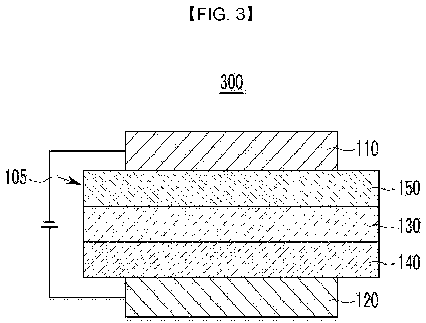

Referring to FIG. 3, a three-layered organic light emmiting diode 300 includes an organic thin layer 105 including an electron transport layer (ETL) 150, an emission layer 130, and a hole transport layer (HTL) 140. The emission layer 130 is independently installed, and layers having an excellent electron transporting property or an excellent hole transporting property are separately stacked.

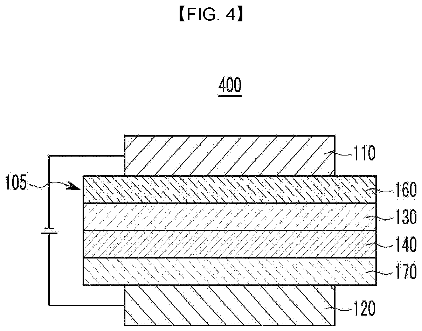

Referring to FIG. 4, a four-layered organic light emmiting diode 400 includes an organic thin layer 105 including an electron injection layer (EIL) 160, an emission layer 130, a hole transport layer (HTL) 140, and a hole injection layer (HIL) 170 for binding with the cathode of ITO.

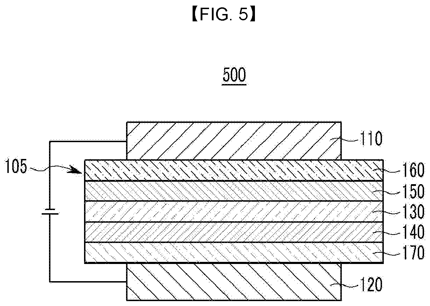

Referring to FIG. 5, a five-layered organic light emmiting diode 500 includes an organic thin layer 105 including an electron transport layer (ETL) 150, an emission layer 130, a hole transport layer (HTL) 140, and a hole injection layer (HIL) 170, and further includes an electron injection layer (EIL) 160 to achieve a low voltage.

In FIG. 1 to FIG. 5, the organic thin layer 105 including at least one selected from the group consisting of an electron transport layer (ETL) 150, an electron injection layer (EIL) 160, an emission layer 130 and 230, a hole transport layer (HTL) 140, a hole injection layer (HIL) 170, and combinations thereof, includes a compound for an organic optoelectronic device. The material for the organic light emmiting diode may be used for an electron transport layer (ETL) 150 including the electron transport layer (ETL) 150 or electron injection layer (EIL) 160. When it is used for the electron transport layer (ETL), it is possible to provide an organic light emmiting diode having a simpler structure because it does not require an additional hole blocking layer (not shown).

Furthermore, when the compound for an organic optoelectronic device is included in the emission layer 130 and 230, the material for the organic light emmiting diode may be included as a phosphorescent or fluorescent host or a fluorescent blue dopant.

The organic light emmiting diode may be fabricated by: forming an anode on a substrate; forming an organic thin layer in accordance with a dry coating method such as evaporation, sputtering, plasma plating, and ion plating, or a wet coating method such as spin coating, dipping, and flow coating; and providing a cathode thereon.

Another embodiment of the present invention provides a display device including the organic light emmiting diode according to the above embodiment.

Hereinafter, the embodiments are illustrated in more detail with reference to examples. However, the following are exemplary embodiments and are not limiting.

### (Preparation of compound for an organic optoelectronic device)

### Synthesis of Intermediate

### Synthesis oflntermediate M-1

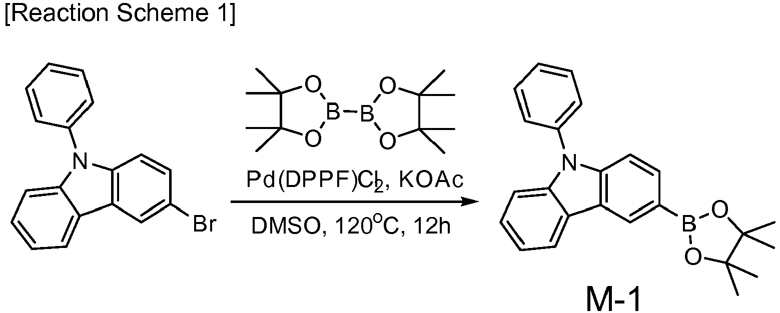

50g (155.18mmol) of 3-bromo-9-phenyl-9H-carbazole, 3.41 g (4.65 mmol) of Pd(dppf)Cl₂, 51.32 g (201.8 mmol) of bis(pinacolato)diboron, and 45.8 g (465.5 mmol) of potassium acetate were dissolved in 520 ml of 1,4-dioxane.

The reactant was refluxed and agitated under a nitrogen atmosphere for 12 hours and then, three times extracted with dichloromethane and distilled water. The extracted solution was dried with magnesium sulfate and filtered and then, concentrated under a reduced pressure.

The product was purified through Silica gel column chromatography by using n-hexane/dichloromethane mixed in a volume ratio of 7:3, obtaining a desired compound, an intermediate M-1, in a white solid of 43 g (yield: 75%).
LC-Mass (theoretical value: 369.19 g/mol, measured value: M+1 = 370 g/mol),

### Synthesis of Intermediate M-2

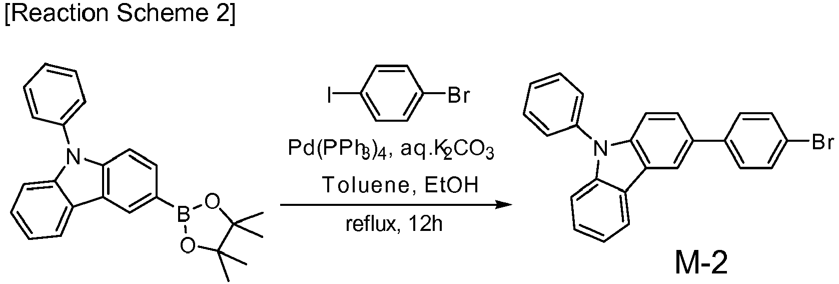

40g (108.3mmol) of the intermediate M-1, 30.6 g (108.3 mmol) of 1-bromo-4-iodobenzene, and 1.25 g (1.08 mmol) of tetrakistriphenylphosphine palladium were in a flask and dissolved in270 ml of toluene and 135mL of ethanol under a nitrogen atmosphere, and 135 ml of an aqueous solution prepared by dissolving 31.9 g (58.9 mmol) of potassium carbonate was added thereto. The mixture was refluxed and agitated for 12 hours.

After the reaction, the resulting product was extracted with ethylacetate. The extracted solution was dried with magnesium sulfate and filtered and then, concentrated under a reduced pressure.

Then, the product was purified through a silica gel column chromatography by using n-hexane/dichloromethane in a volume ratio of 7:3, obtaining a desired compound, an intermediate M-2, in a white solid of 35 g (yield: 81%).
LC-Mass (theoretical value: 398.29 g/mol, measured value: M+1 = 399 g/mol)

### Synthesis of Intermediate M-3

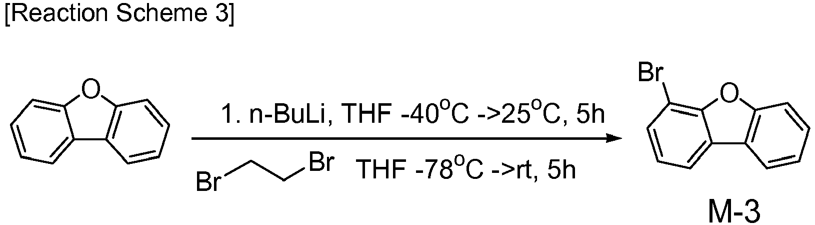

10g (59.5mmol) of dibenzofuran was put in a two-necked round-bottomed flask heated and dried under vacuum, and 119mL of anhydrous tetrahydrofuran was added thereto under a nitrogen atmosphere to dissolve the dibenzofuran. The solution was cooled down to 40°C and agitated.

Next, 26mL of 2.5M n-butyllithium (in 65.5mmol of hexane) was slowly added to the agitated reactant and agitated again at a room temperature under a nitrogen atmosphere for 5 hours. The reactant solution was cooled down to - 78°C, and a solution prepared by dissolving 22.4g (119mmol) of dibromoethane in 10mL of anhydrous tetrahydrofuran was slowly added thereto. The mixture was agitated at a room temperature for 5 hours.

When the reaction was complete, the agitated solution was concentrated under a reduced pressure to remove a solvent therein. The resulting product was extracted with distilled water and dichloromethane. The extraction solution was dried with magnesium sulfate and filtered and then, concentrated under a reduced pressure. The reactant solution was recrystallized with n-hexane, obtaining a desired compound, an intermediate M-3, in a white solid of 11g (yield: 75%).
GC-Mass (theoretical value: 245.97 g/mol, measured value: 246 g/mol)

### Synthesis of Intermediate M-4

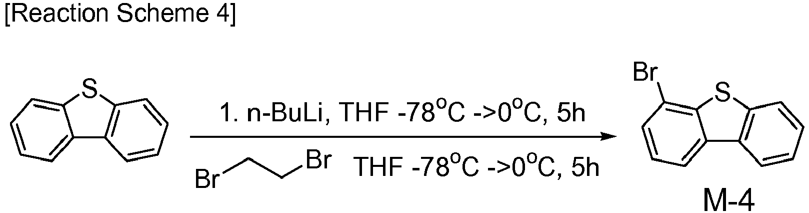

10g (54.3mmol) of dibenzothiophene was put in a two-necked round-bottomed flask heated and dried under vacuum, and 120mL of anhydrous tetrahydrofuran was added thereto to dissolve the dibenzothiophene. The solution was cooled down to -40°C and agitated.

Then, 24mL of 2.5M n-butyllithium (in 59.7mmol of hexane) was slowly added to the resulting product. The mixture was agitated at a room temperature under a nitrogen atmosphere for 5 hours. The reactant solution was cooled down to -78°C, and 20.4g (108.6mmol) of 1,2-dibromoethane dissolved in 10mL of anhydrous tetrahydrofuran was slowly added thereto. The resulting mixture was agitated at a room temperature for 5 hours.

When the reaction was complete, the agitated solution was concentrated under a reduced pressure to remove a solvent and then, extracted with distilled water and dichloromethane. The extracted solution was dried with magnesium sulfate and filtered and then, concentrated again under a reduced pressure. The reactant solution was recrystallized with n-hexane, obtaining a desired compound, an intermediate M-4, in a white solid of 11g (yield: 77%).
GC-Mass (theoretical value: 261.95 g/mol, measured value: 262 g/mol)

### Synthesis of Intermediate M-5

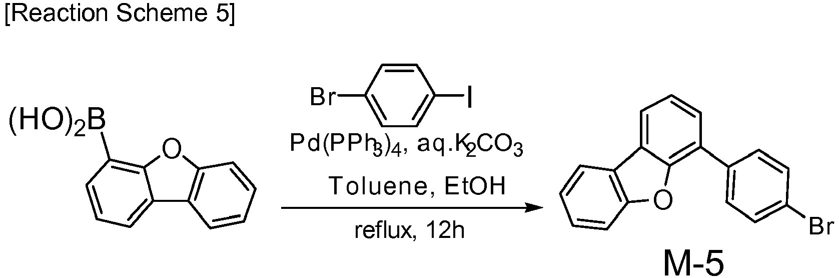

20g (94.4mmol) of 4-dibenzofuranboronic acid), 28 g (99.2 mmol) of 1-bromo-4-iodobenzene, and 1.08 g (0.94 mmol) of tetrakistriphenylphosphine palladium were in a flask, and 120 ml of an aqueous solution prepared by dissolving 28 g (188.8 mmol) of potassium carbonate in 240 ml of toluene and 120mL of ethanol under a nitrogen atmosphere was added thereto. The mixture was agitated for 12 hours.

When the reaction was complete, the resulting reactant was extracted with ethylacetate, dried with magnesium sulfate and filtered and then, concentrated under a reduced pressure. The resulting product was purified through a silica gel column chromatography by using n-hexane/dichloromethane mixed in a volume ratio of 9:1, obtaining a desired compound, an intermediate M-5, in a white solid of 27 g (yield: 89%).
LC-Mass (theoretical value: 322.00 g/mol, measured value: M+1 = 323 g/mol)

### Synthesis of Intermediate M-6

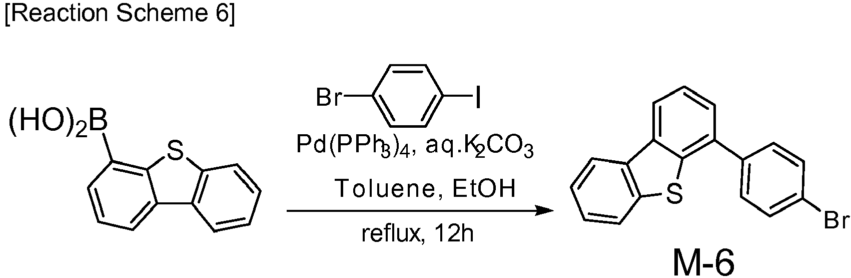

20g (87.69mmol) of 4-dibenzothiopheneboric acid, 27.3 g (96.46 mmol) of 1-bromo-4-iodobenzene, and 1.01 g (0.88 mmol) of tetrakistriphenylphosphine palladium were put in a flask and dissolved in 220 ml of toluene and 110mL of ethanol under a nitrogen atmosphere, and 110 ml of an aqueous solution prepared by dissolving 25.8 g (175.4 mmol) of potassium carbonate therein was added thereto. The mixture was refluxed and agitated for 12 hours.

When the reaction was complete, the reactant was extracted with ethylacetate. The extracted solution was dried with magnesium sulfate and filtered and then, concentrated under a reduced pressure. The product was purified through a silica gel column chromatography by using n-hexane/dichloromethane mixed in a volume ratio of 9:1, obtaining a desired compound, an intermediate M-6, in a white solid of 25 g (yield: 83%).
LC-Mass (theoretical value: 337.98 g/mol, measured value: M+1 = 338 g/mol)

### Synthesis of Intermediate M-7

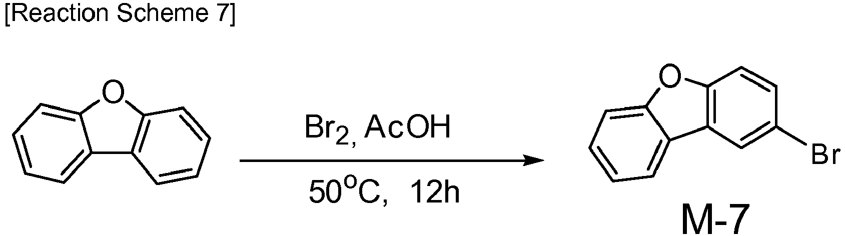

30g (178.4mmol) of dibenzofuran was put in a round-bottomed flask and dissolved in 270g of acetic acid, and 29g (181.5mmol) of bromine dissolved in 6g of acetic acid at 50°C was slowly added thereto for 4 hours. The reactant solution was additionally agitated at 50°C for 8 hours and cooled down and then, added to distilled water. The obtained orange solid was dissolved in dichloromethane and washed with a sodium thiosulfite aqueous solution. Then, the organic layer was dried with magnesium sulfate and filtered and then, concentrated under a reduced pressure.

The resulting product was recrystallized with dichloromethane/n-hexane mixed in a volume ratio of 1:3, obtaining a desired compound, an intermediate M-7, in a white solid of 10.1g (yield: 23%).
GC-Mass (theoretical value: 245.97 g/mol, measured value: 246 g/mol)

### Synthesis of Intermediate M-8

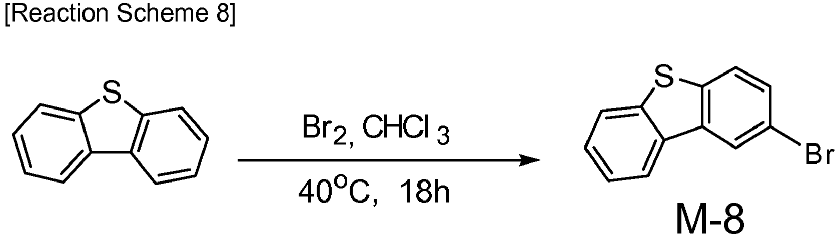

30g (162.8mmol) of dibenzothiophene was put in a round-bottomed flask and dissolved in 2L of chloroform, and 27.3g (170.9mmol) of bromine was slowly added thereto at a room temperature for 6 hours. The reactant solution was additionally agitated at 40°C for 12 hours and cooled down and then, extracted with a sodium thiosulfite aqueous solution. The obtained organic layer was dried with magnesium sulfate and filtered and then, concentrated under a reduced pressure.

The resulting product was recrystallized with ethylacetate/n-hexane mixed in a volume ratio of 1:3, obtaining a desired compound, an intermediate M-8, in a white solid of 15.4g (yield: 36%).
GC-Mass (theoretical value: 261.95 g/mol, measured value: 262 g/mol)

### Synthesis of Intermediate M-9

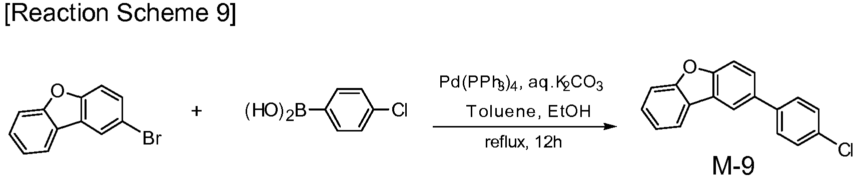

20g (127.9mmol) of 4-chlorophenylboric acid, 30.0 g (121.5 mmol) of the intermediate M-7, and 1.48 g (1.28 mmol) of tetrakistriphenylphosphine palladium were put in a flask and dissolved in 320 ml of toluene and 160mL of ethanol under a nitrogen atmosphere, and 160 ml of an aqueous solution in which 37.7g (255.8 mmol) of potassium carbonate was dissolved was added thereto. The mixture was refluxed and agitated for 12 hours.

When the reaction was complete, the extracted solution was dried with magnesium sulfate and filtered and then, concentrated under a reduced pressure. The resulting product was purified through a silica gel column chromatography by using n-hexane/dichloromethane mixed in a volume ratio of 9:1, obtaining a desired compound, an intermediate M-9, in a white solid of 28.1 g (yield: 83%).
LC-Mass (theoretical value: 278.05 g/mol, measured value: M+1 = 279 g/mol)

### Synthesis of Intermediate M-10

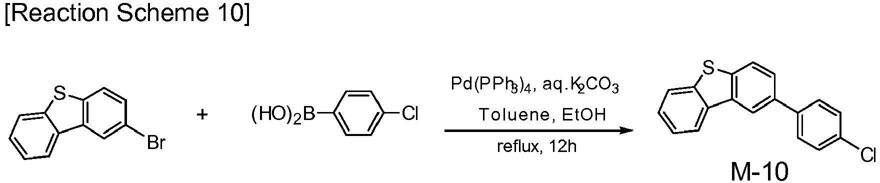

20g (127.9mmol) of 4-chlorophenylboric acid, 32.0 g (121.5 mmol) of the intermediate M-8, and 1.48 g (1.28 mmol) of tetrakistriphenylphosphine palladium were put in a flask and dissolved in 320 ml of toluene and 160mL of ethanol under a nitrogen atmosphere, and 160 ml of an aqueous solution in which 37.7g (255.8 mmol) of potassium carbonate was dissolved was added thereto. The mixture was refluxed and agitated for 12 hours.

When the reaction was complete, the extracted solution was dried with magnesium sulfate and filtered and then, concentrated under a reduced pressure. The resulting product was purified through a silica gel column chromatography by using n-hexane/dichloromethane in a volume ratio of 9:1, obtaining a desired compound, an intermediate M-9, in a white solid of 30.4 g (yield: 85%).
LC-Mass (theoretical value: 294.03 g/mol, measured value: M+1 = 295 g/mol)

### Synthesis of Intermediate M-11

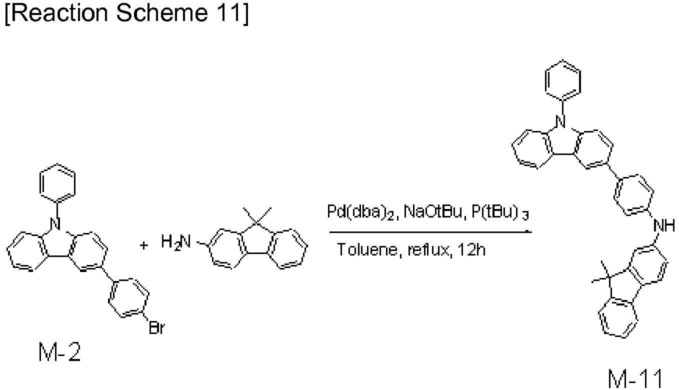

30 g (75.3 mmol) of the intermediate M-2, 18.92 g (90.39 mmol) of 2-amino-9,9'-dimethylfluorene, 26.06 g (271.16 mmol) of sodium t-butoxide, and 0.46 g (2.26 mmol) of tri-tert-butylphosphine were dissolved in 600 ml of toluene, and 1.3 g (2.26 mmol) of Pd(dba)₂ was added thereto. The mixture was refluxed and agitated under a nitrogen atmosphere for 12 hours.

When the reaction was complete, the reactant was extracted with toluene and distilled water. The obtained organic layer was dried with magnesium sulfate and filtered and then, concentrated under a reduced pressure. The product was purified through a silica gel column chromatography by using n-hexane/dichloromethane mixed in a volume ratio of 1:1 and recrystallized in a mixed solvent of methylenechloride/n-hexane, obtaining a desired compound, an intermediate M-11, in a white solid of 30.9 g (yield: 78%).
LC-Mass (theoretical value: 526.24 g/mol, measured value: M+1 = 527.24 g/mol)

### Synthesis of Intermediate M-12

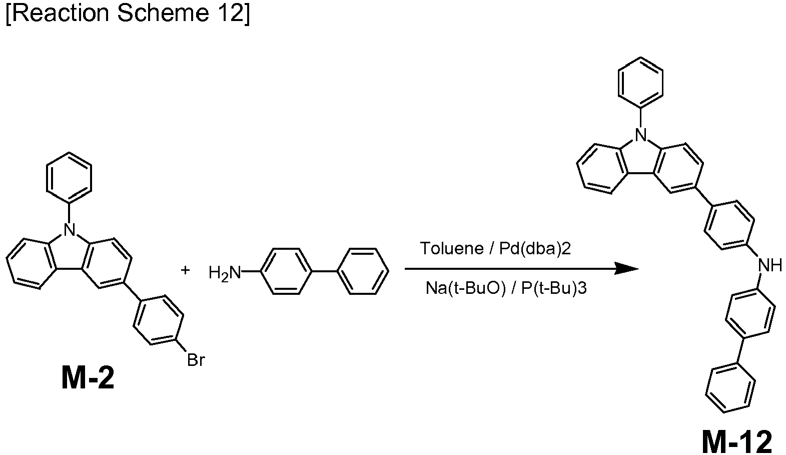

30 g (75.3 mmol) of the intermediate M-2, 15.29 g (90.39 mmol) of 4-aminobiphenyl, 26.06 g (271.16 mmol) of sodium t-butoxide, and 0.46 g (2.26 mmol) of tri-tert-butylphosphine were dissolved in 600 ml of toluene, and 1.3 g (2.26 mmol) of Pd(dba)₂ was added thereto. The mixture was refluxed and agitated under a nitrogen atmosphere for 12 hours.

When the reaction was complete, the product was extracted with toluene and distilled water. Then, the obtained organic layer was dried with magnesium sulfate and filtered and then, concentrated under a reduced pressure. The resulting product was purified through a silica gel column chromatography by using n-hexane/dichloromethane in a volume ratio of 1:1 and then, recrystallized in a mixed solvent of methylenechloride/n-hexane, obtaining a desired compound, an intermediate M-12, in a white solid of 28.4 g (yield: 77.5%).
LC-Mass (theoretical value: 486.21 g/mol, measured value: M+1 = 487.21 g/mol)

### Example 1: Preparation of Compound A-1 (not forming part of the invention)

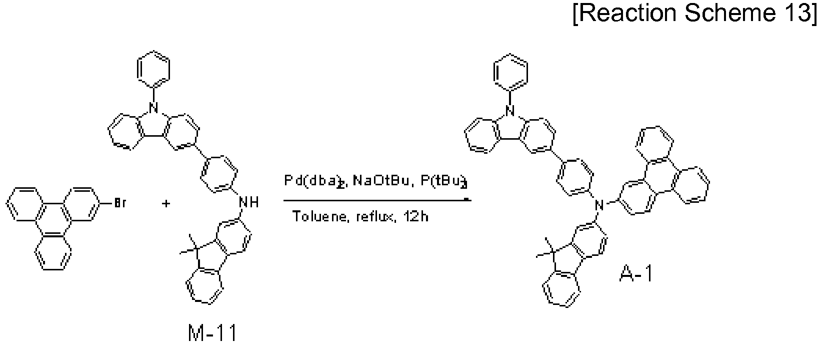

5.6 g (18.23 mmol) of 2-bromo triphenylene, 8.0 g (15.19 mmol) of the intermediate M-11, 5.26 g (54.68 mmol) of sodium t-butoxide, 0.09g (0.46 mmol) of tri-tert-butylphosphine were dissolved in 200 ml of toluene, and 0.26g (0.46 mmol) of Pd(dba)₂ was added thereto. The mixture was refluxed and agitated under a nitrogen atmosphere for 12 hours.

When the reaction was complete, the mixture was extracted with toluene and distilled water. The obtained organic layer was dried with anhydrous magnesium sulfate and filtered and then, concentrated under a reduced pressure. The product was purified through a silica gel column chromatography by using n-hexane/dichloromethane mixed in a volume ratio of 1:1 and recrystallized in a mixed solvent of methylenechloride/ethylacetate, obtaining a desired compound A-1, a white solid of 6.88g (yield: 60.1%).
LC-Mass (theoretical value: 752.32 g/mol, measured value: M+1 = 753.32 g/mol)

### Example 2: Preparation of Compound A-2

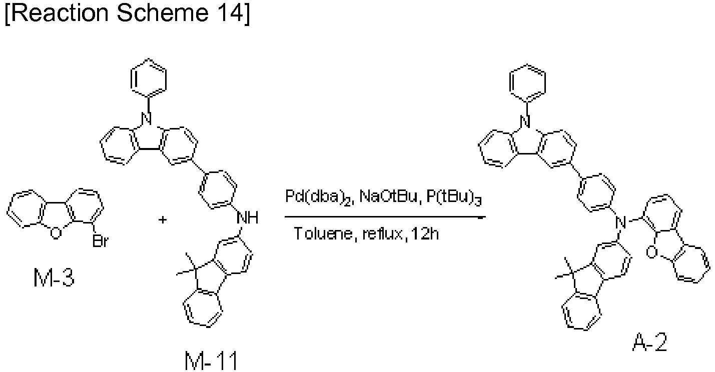

4.13 g (16.71 mmol) of 4-bromo dibenzofuran, 8.0 g (15.19 mmol) of the intermediate M-11, 4.82 g (50.13 mmol) of sodium t-butoxide, and 0.09g (0.46 mmol) of tri-tert-butylphosphine were dissolved in 200 ml of toluene, and 0.26g (0.46 mmol) of Pd(dba)2 was added thereto. The mixture was refluxed and agitated under a nitrogen atmosphere for 12 hours.

When the reaction was complete, the resulting product was extracted with toluene and distilled water. The obtained organic layer was dried with anhydrous magnesium sulfate and filtered and then, concentrated under a reduced pressure. The obtained product was purified through a silica gel column chromatography with n-hexane/dichloromethane mixed in a volume ratio of 1:1, obtaining a desired compound A-2, in a white solid of 9.0g (yield: 85.5%).

LC-Mass (theoretical value: 692.28 g/mol, measured value: M+1 = 693.28 g/mol)

### Example 3: Preparation of Compound A-3

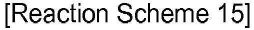

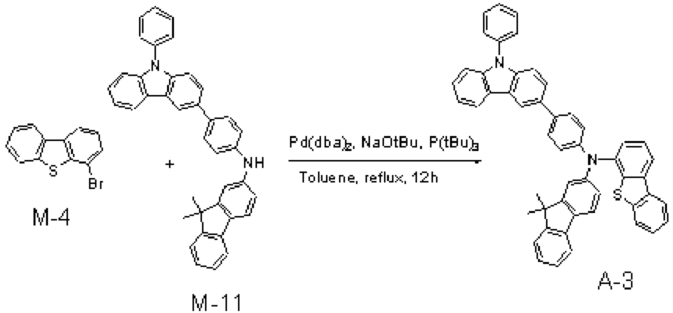

4.4 g (16.71 mmol) of 4-bromo dibenzothiophene, 8.0 g (15.19 mmol) of the intermediate M-11, 4.82 g (50.13 mmol) of sodium t-butoxide, and 0.09g (0.46 mmol) of tri-tert-butylphosphine was dissolved in 200 ml of toluene, and 0.26g (0.46 mmol) of Pd(dba)₂ was added thereto. The mixture was refluxed and agitated under a nitrogen atmosphere for 12 hours.

When the reaction was complete, the resulting product was extracted with toluene and distilled water. The obtained organic layer was dried with anhydrous magnesium sulfate and filtered and then, concentrated under a reduced pressure. The obtained product was purified through a silica gel column chromatography by using n-hexane/dichloromethane mixed in a volume ratio of 1:1, obtaining a desired compound A-3 in a white solid of 9.0g (yield: 83.58%).

LC-Mass (theoretical value: 708.91 g/mol, measured value: M+1 = 709.91 g/mol)

### Example 4: Preparation of Compound A-4

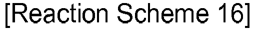

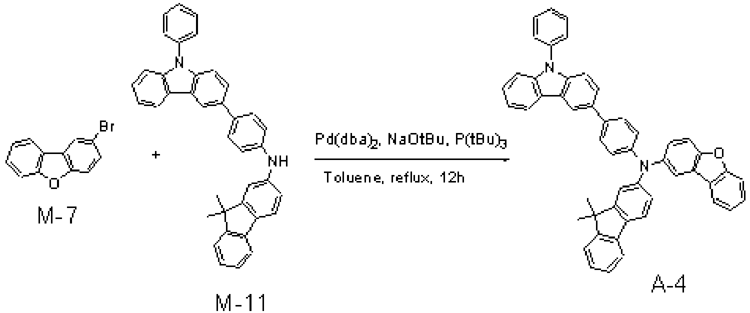

4.13 g (16.71 mmol) of 2-bromo dibenzofuran, 8.0 g (15.19 mmol) of the intermediate M-11, 4.82 g (50.13 mmol) of sodium t-butoxide, and 0.09g (0.46 mmol) of tri-tert-butylphosphine were dissolved in 200 ml of toluene, and 0.26g (0.46 mmol) of Pd(dba)₂ was added thereto. The mixture was refluxed and agitated under a nitrogen atmosphere for 12 hours.

When the reaction was complete, the resulting product was extracted with toluene and distilled water. The obtained organic layer was dried with anhydrous magnesium sulfate and filtered and then, concentrated under a reduced pressure. The obtained product was purified through a silica gel column chromatography by using n-hexane/dichloromethane mixed in a volume ratio of 1:1, preparing a desired compound A-4 in a white solid of 8.7g (yield: 82.6%).
LC-Mass (theoretical value: 692.28 g/mol, measured value: M+1 = 693.28 g/mol)

### Example 5: Preparation of Compound A-5

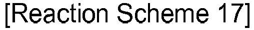

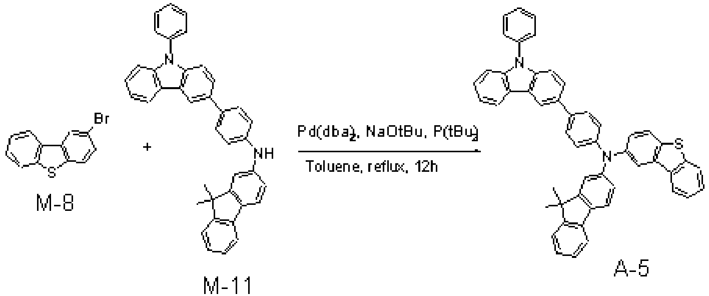

4.4 g (16.71 mmol) of 2-bromo dibenzothiophene, 8.0 g (15.19 mmol) of the intermediate M-11, 4.82 g (50.13 mmol) of sodium t-butoxide, and 0.09g (0.46 mmol) of tri-tert-butylphosphine were dissolved in 200 ml of toluene, and 0.26g (0.46 mmol) of Pd(dba)₂ was added thereto. The mixture was refluxed and agitated under a nitrogen atmosphere for 12 hours.

When the reaction was complete, the resulting product was extracted with toluene and distilled water. The obtained organic layer was dried with anhydrous magnesium sulfate and filtered and then, concentrated under a reduced pressure. The prepared product was purified through a silica gel column chromatography by using n-hexane/dichloromethane mixed in a volume ratio of 1:1, obtaining a desired compound A-5 in a white solid of 8.4g (yield: 78%).
LC-Mass (theoretical value: 708.91 g/mol, measured value: M+1 = 709.91 g/mol)

### Example 6: Preparation of Compound A-6

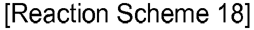

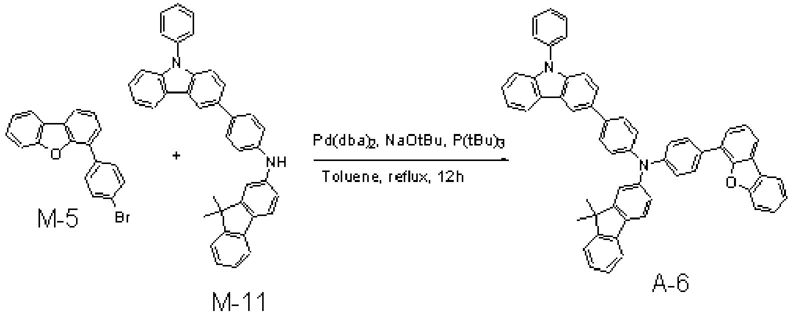

5.4 g (16.71 mmol) of the intermediate M-5, 8.0 g (15.19 mmol) of the intermediate M-11, 4.82 g (50.13 mmol) of sodium t-butoxide, and 0.09g (0.46 mmol) of tri-tert-butylphosphine were dissolved in 300 ml of toluene, and 0.26g (0.46 mmol) of Pd(dba)₂ was added thereto. The mixture was refluxed and agitated under a nitrogen atmosphere for 12 hours.

When the reaction was complete, the resulting product was extracted with toluene and distilled water. The obtained organic layer was dried with anhydrous magnesium sulfate and filtered and then, concentrated under a reduced pressure. The prepared product was purified through a silica gel column chromatography by using n-hexane/dichloromethane mixed in a volume ratio of 4:1, obtaining a desired compound A-6 in a white solid of 9.2g (yield: 78.7%).
LC-Mass (theoretical value: 768.31 g/mol, measured value: M+1 = 769.31 g/mol)

### Example 7: Preparation of Compound A-7

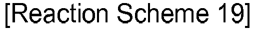

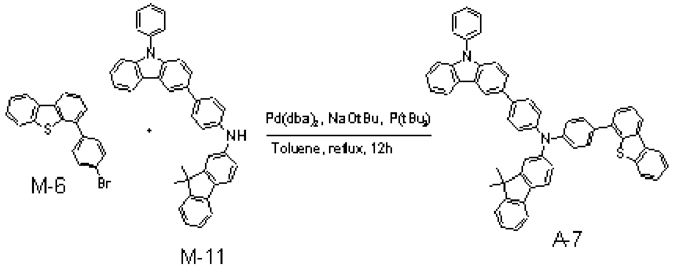

5.67 g (16.71 mmol) of the intermediate M-6, 8.0 g (15.19 mmol) of the intermediate M-11, 4.82 g (50.13 mmol) of sodium t-butoxide, and 0.09g (0.46 mmol) of tri-tert-butylphosphine was dissolved in 300 ml of toluene, and 0.26g (0.46 mmol) of Pd(dba)₂ was added thereto. The mixture was refluxed and agitated under a nitrogen atmosphere for 12 hours.

When the reaction was complete, the resulting product was extracted with toluene and distilled water. The obtained organic layer was dried with anhydrous magnesium sulfate and filtered and then, concentrated under a reduced pressure. The prepared product was purified through a silica gel column chromatography by using n-hexane/dichloromethane mixed in a volume ratio of 4:1, obtaining a desired compound A-7 in a white solid of 9.5g (yield: 79.6%).
LC-Mass (theoretical value: 784.29 g/mol, measured value: M+1 = 785.29 g/mol)

### Example 8: Preparation of Compound A-8

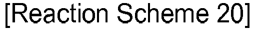

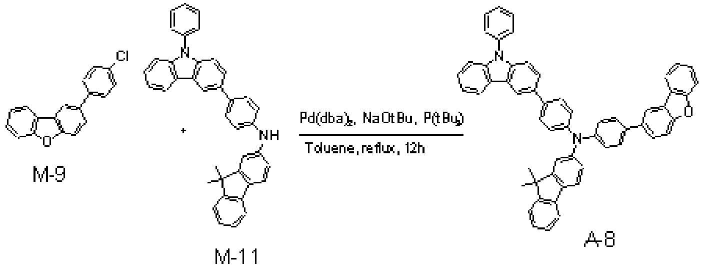

4.66 g (16.71 mmol) of the intermediate M-9, 8.0 g (15.19 mmol) of the intermediate M-11, 4.82 g (50.13 mmol) of sodium t-butoxide, and 0.09g (0.46 mmol) of tri-tert-butylphosphine were dissolved in 300 ml of toluene, and 0.26g (0.46 mmol) of Pd(dba)₂ was added thereto. The mixture was refluxed and agitated under a nitrogen atmosphere for 12 hours.

When the reaction was complete, the resulting product was extracted with toluene and distilled water. The obtained organic layer was dried with anhydrous magnesium sulfate and filtered and then, concentrated under a reduced pressure. The prepared product was purified through a silica gel column chromatography by using n-hexane/dichloromethane mixed in a volume ratio of 4:1, obtaining a desired compound A-8 in a white solid of 9.0g (yield: 77%).
LC-Mass (theoretical value: 768.31 g/mol, measured value: M+1 = 769.31 g/mol)

### Example 9: Preparation of Compound A-9

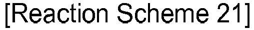

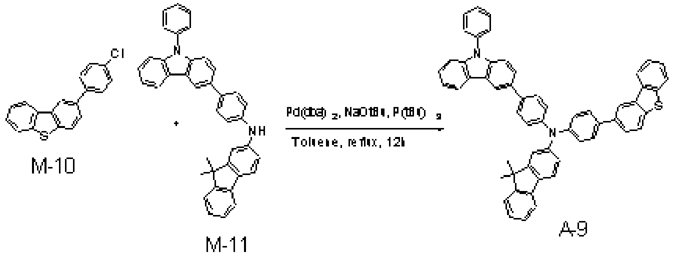

4.93 g (16.71 mmol) of the intermediate M-10, 8.0 g (15.19 mmol) of the intermediate M-11, 4.82 g (50.13 mmol) of sodium t-butoxide, and 0.09g (0.46 mmol) of tri-tert-butylphosphine were dissolved in 300 ml of toluene, and 0.26g (0.46 mmol) of Pd(dba)₂ was added thereto. The mixture was refluxed and agitated under a nitrogen atmosphere for 12 hours.

When the reaction was complete, the resulting mixture was extracted with toluene and distilled water. The obtained organic layer was dried with anhydrous magnesium sulfate and filtered and then, concentrated under a reduced pressure. The obtained product was purified through a silica gel column chromatography by using n-hexane/dichloromethane in a volume ratio of 4:1, obtaining a desired compound A-9 in a white solid of 9.4g (yield: 78.8%).
LC-Mass (theoretical value: 784.29 g/mol, measured value: M+1 = 785.29 g/mol)

### Example Ad-1: Preparation of Compound B-1

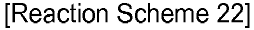

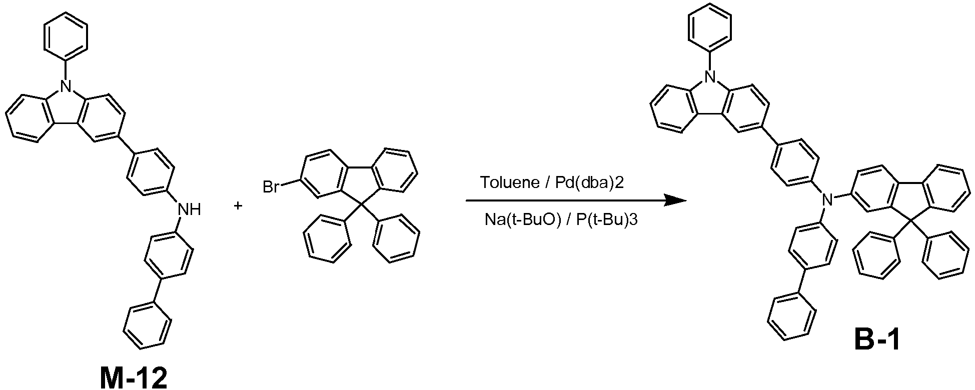

6 g (15.1 mmol) of 2-bromo-9,9'-diphenyl fluorene, 6.52 g (13.4 mmol) of the intermediate M-12, 4.82 g (50.13 mmol) of sodium t-butoxide, and 0.09g (0.46 mmol) of tri-tert-butylphosphine were dissolved in 300 ml of toluene, and 0.26g (0.46 mmol) of Pd(dba)₂ was added thereto. The mixture was refluxed and agitated under a nitrogen atmosphere for 12 hours.

When the reaction was complete, the resulting product was extracted with toluene and distilled water. The obtained organic layer was dried with anhydrous magnesium sulfate and filtered and then, concentrated under a reduced pressure. The prepared product was twice recrystallized in a mixed solvent of methylene chloride/acetone, obtaining a desired compound B-1, a white solid of 9.5g (yield: 88.7%).
LC-Mass (theoretical value: 802.33 g/mol, measured value: M+1 = 803.33 g/mol)

### Fabrication of Organic light emitting diode

### Example 10 (not forming part of the invention)

A glass substrate coated with a 1500Å-thick ITO (Indium tin oxide) thin film was cleaned with a distilled water ultrasonic wave. Next, the glass substrate was ultrasonic wave-cleaned with a solvent such as isopropyl alcohol, acetone, methanol, and the like and then, cleaned in a plasma cleaner by using oxygen plasma for 5 minutes and moved with a vacuum evaporator. The ITO transparent electrode was used as a positive electrode, and 4,4'-bis[N-[4-{N,N-bis(3-methylphenyl)amino}-phenyl]-N-phenylamino]biphenyl (DNTPD) was vacuum-deposited to form a 600Å-thick hole injection layer (HIL) thereon. Then, the compound of Example 1 was vacuum-deposited to form a 300Å-thick hole transport layer (HTL) on the hole injection layer (HIL). On the hole transport layer (HTL), a 250Å-thick emission layer was vacuum deposited by using 9,10-di-(2-naphthyl)anthracene (ADN) as a host and 3wt% of 2,5,8,11-tetra(tert-butyl)perylene (TBPe) as a dopant.

On the emission layer, Alq3 was vacuum-deposited to form a 250Å-thick electron transport layer (ETL). On the electron transport layer (ETL), LiF was vacuum-deposit to be10Å thick, and sequentially, Al is formed to be 1000Å thick to fabricate a cathode. Then, the cathode was used to fabricate an organic light emitting diode.

The organic light emitting diode had a structure of five organic thin layers, in particular, Al 1000Å / LiF 10Å / Alq3 250Å / EML[ADN:TBPe=97:3] 250 Å / A-1 300Å / DNTPD 600Å / ITO 1500Å.

### Example 11

An organic light emitting diode was fabricated according to the same method as Example 10 except for using A-6 according to Example 6 instead of A-1 according to Example 1.

### Example 12

An organic light emitting diode was fabricated according to the same method as Example 10 except for using A-7 according to Example 7 instead of A-1 according to Example 1.

### Example Ad-2

An organic light emitting diode was fabricated according to the same method as Example 10 except for using B-1 according to Example Ad-1 instead of A-1 according to Example 1.

### Comparative Example 1

An organic light emitting diode was fabricated according to the same method as Example 10 except for using NPB instead of the compound A-1 of Example 1.

### Comparative Example 2

An organic light emitting diode was fabricated according to the same method as Example 10 except for using H1 instead of the compound A-1 of Example 1.

The compounds used in Examples and Comparative Examples are provided as follows.

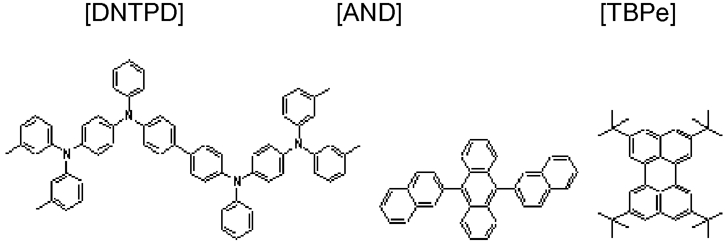

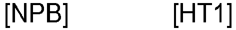

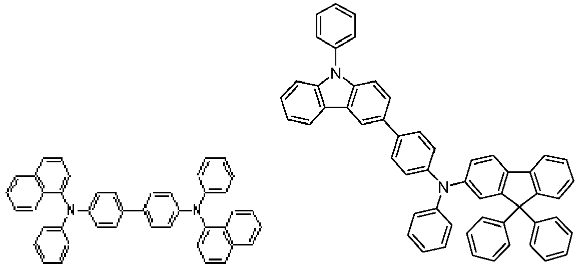

### (Thermal Stability Evaluation of Material)

Each specimen was measured regarding glass transition temperature and decomposition temperature by measuring DSC and TGA. The results are provided in the following Table 1.

**[Table 1]**

| Materials | Tg (°C) | Td (°C) |
|---|---|---|
| Example 1 A-1* | 161 | 483 |
| Example 6 A-6 | 142 | 487 |
| Example 7 A-7 | 142 | 513 |
| Example Ad-1 B-1 | 150 | 507 |

| | | |
|---|---|---|
| Tg: glass transition temperature Td: decomposition temperature * Not forming part of the invention | | |

As shown in Table 1, the compounds according to Examples 1, 6, 7, and Ad-1 had a decomposition temperature of about 500°C or so and thus, very high thermal stability compared with 392°C of the decomposition temperature of carbazole biphenyl (CBP).

In addition, the compounds according to Examples 1, 6, 7, and Ad-1 had remarkably high glass transition temperature compared with 90°C of the glass transition temperature of a generally-known compound for an organic optoelectronic device.

### (Performance Evaluation of Organic light emitting diode)

Each organic light emitting diode according to Examples 10 to 12 and Ad-2 and Comparative Examples 1 and 2 were measured regarding current density change and luminance change depending voltage change and luminous efficiency. In particular, the measurements were made in the following method, and the results are provided in the following Table 2.

### (1) Current density change depending on voltage change

The organic light emitting diodes were measured regarding current per unit device by using a current-voltage system (Keithley 2400) while its voltage was increased from 0 V to 10 V and current density by dividing the current value by an area.

### (2) Luminance change depending on voltage change

The organic light emitting diodes was measured regarding luminance by using a luminance meter (Minolta Cs-1000A) while its voltage was increased from 0 V to 10 V.

### (3) Luminous efficiency

The luminance and current density obtained (1) and (2) and voltage were used to calculate current efficiency (cd/A) of the same current density (10 mA/cm²).

**[Table 2]**

| Devices | HTL | Voltage (V) | EL color | Efficiency (cd/A) | half life-span (h) @1000cd/m² |
|---|---|---|---|---|---|
| Example 10* | A-1 | 6.2 | Blue | 6.0 | 1,500 |
| Example 11 | A-6 | 6.2 | Blue | 5.7 | 1,700 |
| Example 12 | A-7 | 6.1 | Blue | 5.9 | 2,000 |
| Example Ad-2 | Ad-1 | 6.0 | Blue | 5.6 | 2,000 |
| Comparative Example 1 | NPB | 7.1 | Blue | 4.9 | 1,250 |
| Comparative Example 2 | HT1 | 6.2 | Blue | 5.5 | 1,500 |

| | | | | | |
|---|---|---|---|---|---|
| * Not forming part of the invention | | | | | |

Based on the results of Table 2, the organic light emitting diodes according to Examples 10 to 12 and Ad-2 had remarkably excellent efficiency and half life-span compared with those of Comparative Examples 1 and 2.

In addition, the organic light emitting diodes according to Examples 10 to 12 and Ad-2 had remarkably improved half life-span compared with those of Comparative Examples 1 and 2. In particular, the organic light emitting diodes according to Examples 12 and Ad-2 had 2,000 hours (h) of half life- span compared with 1250 hours and thus, more than about 1.6 times improved half life-span. Considering life-span of a device to be the most important factor in terms of actual commercialization of the device, the organic light emitting diodes according to Examples turned out to have a satisfactory life-span.

### <Description of Symbols>

| | | | |
|---|---|---|---|
| 100: | organic light emmiting diode | 110: | cathode |
| 120: | anode | 105: | organic thin layer |
| 130: | emission layer | 140: | hole transport layer (HTL) |
| 150: | electron transport layer (ETL) | 160: | electron injection layer (EIL) |
| 170: | hole injection layer (HIL) | 230: | emission layer + electron transport layer (ETL) |

## Claims

1. A compound for an organic optoelectronic device represented by the following Chemical Formula 1: 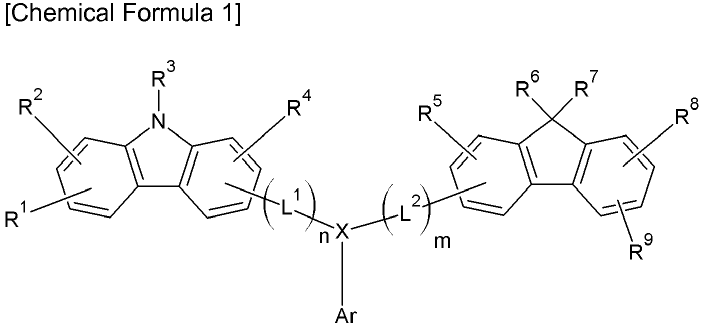 wherein, in Chemical Formula 1,
Ar is a substituted or unsubstituted biphenyl group; a substituted or unsubstituted dibenzofuranyl group; or a substituted or unsubstituted dibenzothiophenyl group,
X is N, B or P,
L¹ and L² are the same or different and independently a single bond, a substituted or unsubstituted C2 to C10 alkenylene group, a substituted or unsubstituted C2 to C10 alkynylene group, a substituted or unsubstituted C6 to C30 arylene group or a substituted or unsubstituted C2 to C30 heteroarylene group,
n and m are the same or different and independently integers ranging from 0 to 3, and
R¹ to R⁹ are the same or different and independently hydrogen, deuterium, halogen, a cyano group, a hydroxyl group, an amino group, a substituted or unsubstituted C1 to C20 amine group, a nitro group, a carboxyl group, a ferroceny group, a substituted or unsubstituted C1 to C20 alkyl group, a substituted or unsubstituted C6 to C30 aryl group, a substituted or unsubstituted C2 to C30 heteroaryl group, a substituted or unsubstituted C1 to C20 alkoxy group, a substituted or unsubstituted C6 to C20 aryloxy group, a substituted or unsubstituted C3 to C40 silyloxy group, a substituted or unsubstituted C1 to C20 acyl group, a substituted or unsubstituted C2 to C20 alkoxycarbonyl group, a substituted or unsubstituted C2 to C20 acyloxy group, a substituted or unsubstituted C2 to C20 acylamino group, a substituted or unsubstituted C2 to C20 alkoxycarbonylamino group, a substituted or unsubstituted C7 to C20 aryloxycarbonylamino group, a substituted or unsubstituted C1 to C20 sulfamoylamino group, a substituted or unsubstituted C1 to C20 sulfonyl group, a substituted or unsubstituted C1 to C20 alkylthiol group, a substituted or unsubstituted C6 to C20 arylthiol group, a substituted or unsubstituted C1 to C20 heterocyclothiol group, a substituted or unsubstituted C1 to C20 ureide group, a substituted or unsubstituted C3 to C40 silyl group, or a combination thereof, wherein
when Ar is a substituted or unsubstituted biphenyl group, the Chemical Formula 1 is represented by the following Chemical Formula B-1:

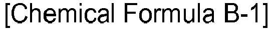

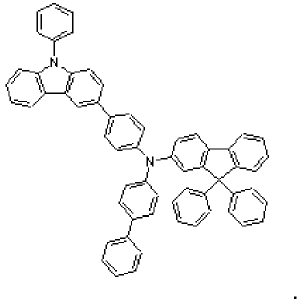

2. The compound for an organic optoelectronic device of claim 1, wherein the compound for an organic optoelectronic device is represented by the following Chemical Formula 3: 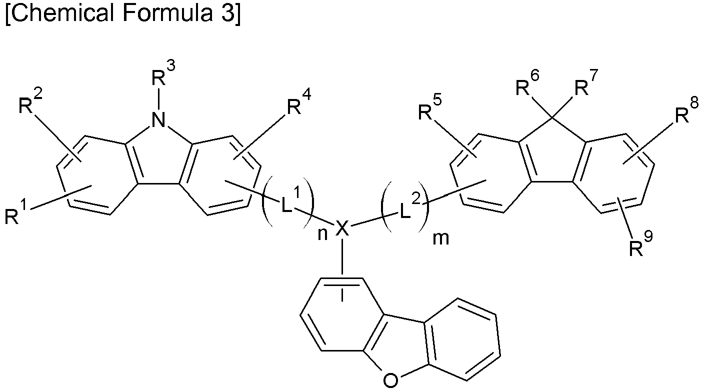 wherein, in Chemical Formula 3,
X is N, B or P,
L¹ and L² are the same or different and independently a single bond, a substituted or unsubstituted C2 to C10 alkenylene group, a substituted or unsubstituted C2 to C10 alkynylene group, a substituted or unsubstituted C6 to C30 arylene group or a substituted or unsubstituted C2 to C30 heteroarylene group,
n and m are the same or different and independently integers ranging from 0 to 3, and
R¹ to R⁹ are the same or different and independently hydrogen, deuterium, halogen, a cyano group, a hydroxyl group, an amino group, a substituted or unsubstituted C1 to C20 amine group, a nitro group, a carboxyl group, a ferroceny group, a substituted or unsubstituted C1 to C20 alkyl group, a substituted or unsubstituted C6 to C30 aryl group, a substituted or unsubstituted C2 to C30 heteroaryl group, a substituted or unsubstituted C1 to C20 alkoxy group, a substituted or unsubstituted C6 to C20 aryloxy group, a substituted or unsubstituted C3 to C40 silyloxy group, a substituted or unsubstituted C1 to C20 acyl group, a substituted or unsubstituted C2 to C20 alkoxycarbonyl group, a substituted or unsubstituted C2 to C20 acyloxy group, a substituted or unsubstituted C2 to C20 acylamino group, a substituted or unsubstituted C2 to C20 alkoxycarbonylamino group, a substituted or unsubstituted C7 to C20 aryloxycarbonylamino group, a substituted or unsubstituted C1 to C20 sulfamoylamino group, a substituted or unsubstituted C1 to C20 sulfonyl group, a substituted or unsubstituted C1 to C20 alkylthiol group, a substituted or unsubstituted C6 to C20 arylthiol group, a substituted or unsubstituted C1 to C20 heterocyclothiol group, a substituted or unsubstituted C1 to C20 ureide group, a substituted or unsubstituted C3 to C40 silyl group, or a combination thereof.

3. The compound for an organic optoelectronic device of claim 1, wherein the compound for an organic optoelectronic device is represented by the following Chemical Formula 4: 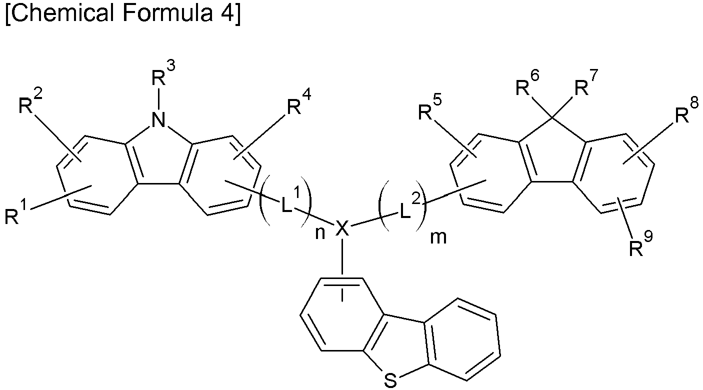 wherein, in Chemical Formula 4,
X is N, B or P,
L¹ and L² are the same or different and independently a single bond, a substituted or unsubstituted C2 to C10 alkenylene group, a substituted or unsubstituted C2 to C10 alkynylene group, a substituted or unsubstituted C6 to C30 arylene group or a substituted or unsubstituted C2 to C30 heteroarylene group,
n and m are the same or different and independently integers ranging from 0 to 3, and
R¹ to R⁹ are the same or different and independently hydrogen, deuterium, halogen, a cyano group, a hydroxyl group, an amino group, a substituted or unsubstituted C1 to C20 amine group, a nitro group, a carboxyl group, a ferroceny group, a substituted or unsubstituted C1 to C20 alkyl group, a substituted or unsubstituted C6 to C30 aryl group, a substituted or unsubstituted C2 to C30 heteroaryl group, a substituted or unsubstituted C1 to C20 alkoxy group, a substituted or unsubstituted C6 to C20 aryloxy group, a substituted or unsubstituted C3 to C40 silyloxy group, a substituted or unsubstituted C1 to C20 acyl group, a substituted or unsubstituted C2 to C20 alkoxycarbonyl group, a substituted or unsubstituted C2 to C20 acyloxy group, a substituted or unsubstituted C2 to C20 acylamino group, a substituted or unsubstituted C2 to C20 alkoxycarbonylamino group, a substituted or unsubstituted C7 to C20 aryloxycarbonylamino group, a substituted or unsubstituted C1 to C20 sulfamoylamino group, a substituted or unsubstituted C1 to C20 sulfonyl group, a substituted or unsubstituted C1 to C20 alkylthiol group, a substituted or unsubstituted C6 to C20 arylthiol group, a substituted or unsubstituted C1 to C20 heterocyclothiol group, a substituted or unsubstituted C1 to C20 ureide group, a substituted or unsubstituted C3 to C40 silyl group, or a combination thereof.

4. The compound for an organic optoelectronic device of claims 1-3, wherein X is N.

5. The compound for an organic optoelectronic device of claim 1, wherein the compound for an organic optoelectronic device is compresented by one of the following Chemical Formula B-1:

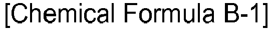

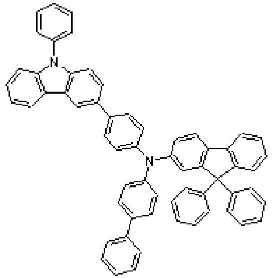

6. The compound for an organic optoelectronic device of claims 1 or 2, wherein the compound for an organic optoelectronic device is a presented by the following Chemical Formula A-2, A-4, A-6, A-8, A-11, A-13, A-15, A-17, A-20, A-22, A-24, A-26, A-29, A-31, A-33, A-35, A-38, A-40, A-42, A-44, A-47, A-49, A-51, A-53, A-57, A-59, A-62, A-64, A-69, A-71, A-72, A-74, A-79, A-81, A-82, A-84, A-89, A-91, A-92 or A-94.

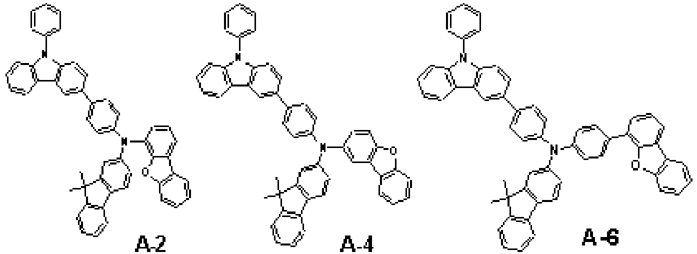

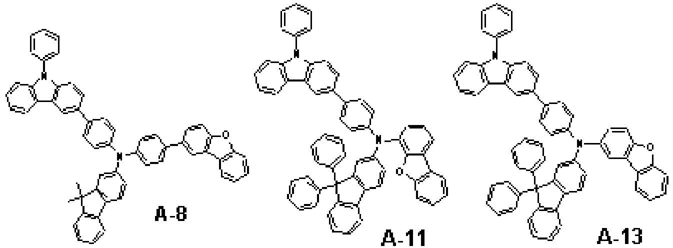

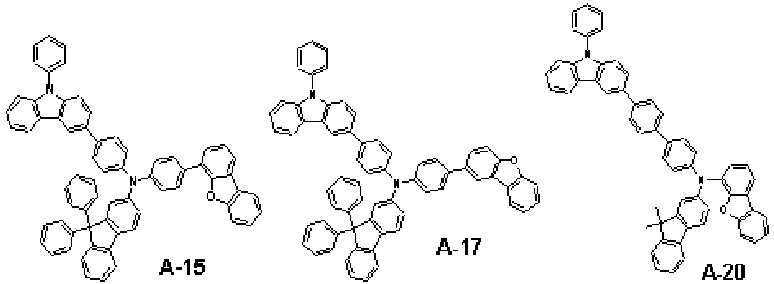

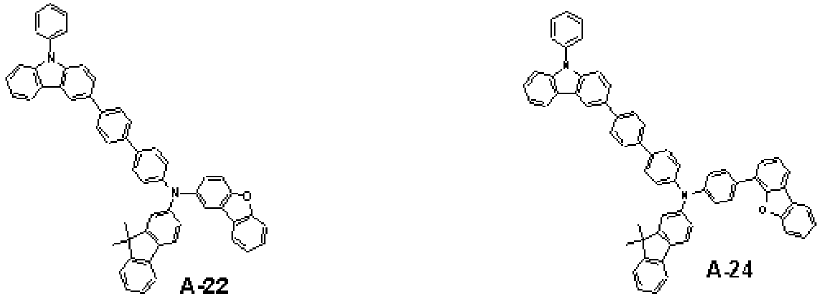

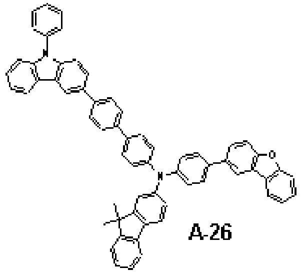

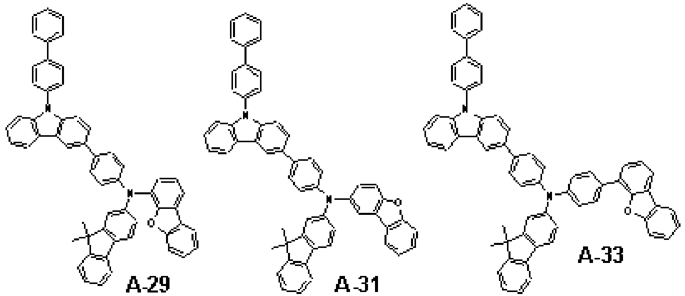

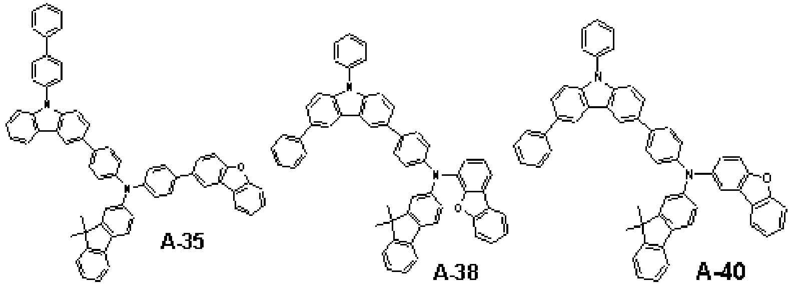

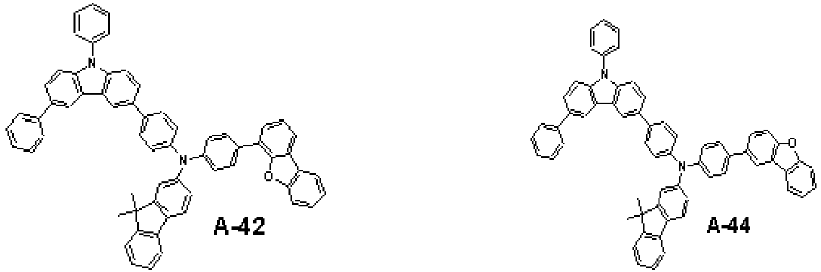

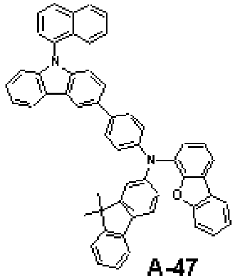

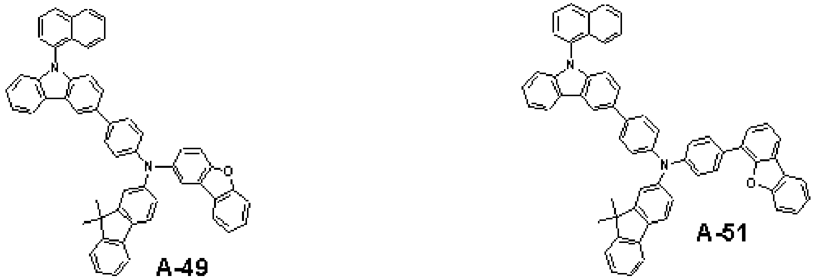

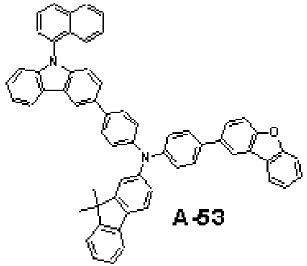

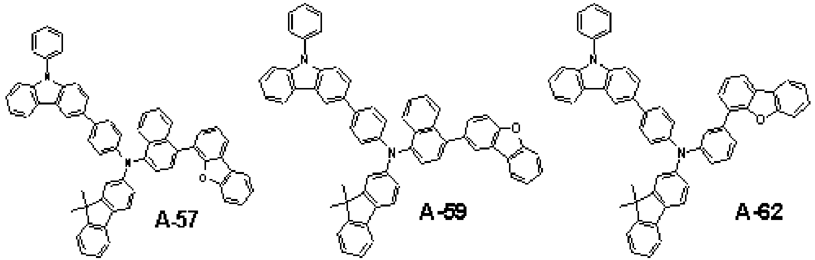

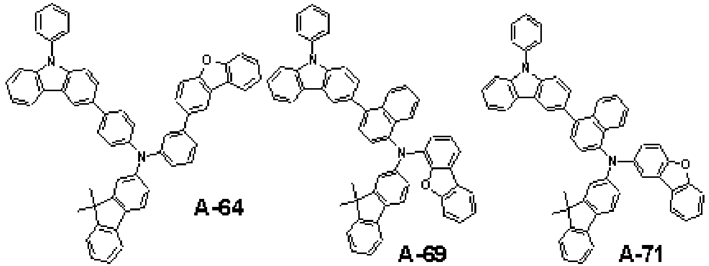

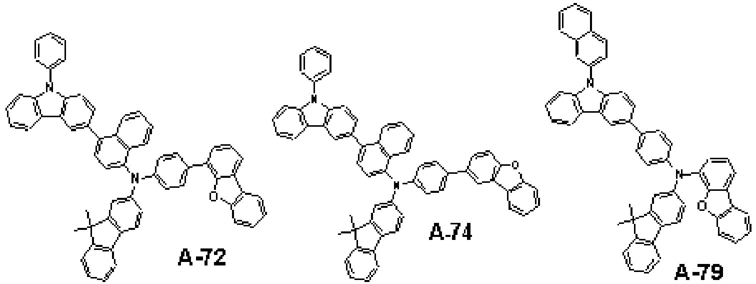

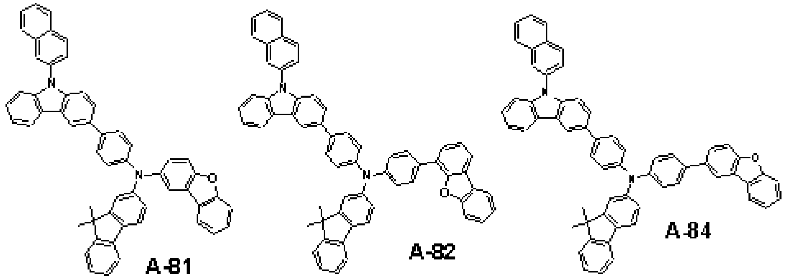

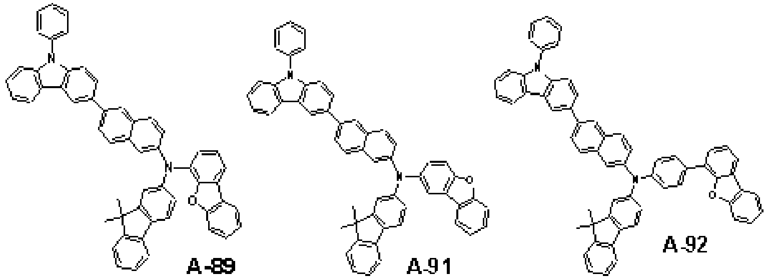

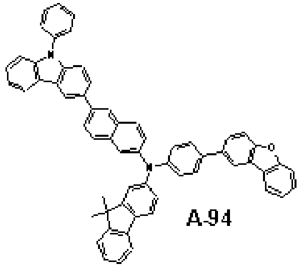

7. The compound for an organic optoelectronic device of claims 1 or 3, wherein the compound for an organic optoelectronic device is a compresented by the following Chemical Formula A-3, A-5, A-7, A-9, A-12, A-14, A-16, A-18, A-21, A-23, A-25, A-27, A-30, A-32, A-34, A-36, A-39, A-41, A-43, A-45, A-48, A-50, A-52, A-54, A-58, A-60, A-63, A-65, A-68, A-70, A-73, A-75, A-78, A-80, A-83, A-85, A-88, A-90, A-93 or A-95.

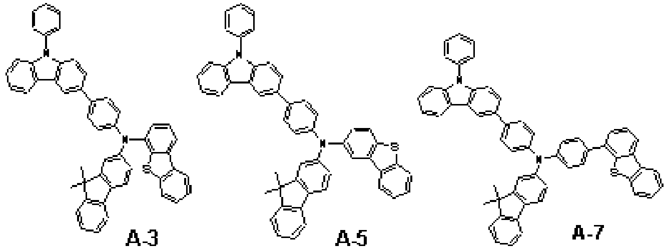

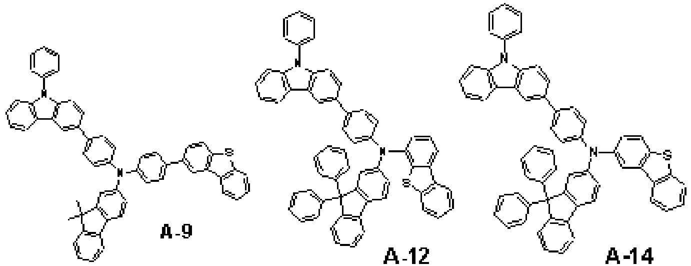

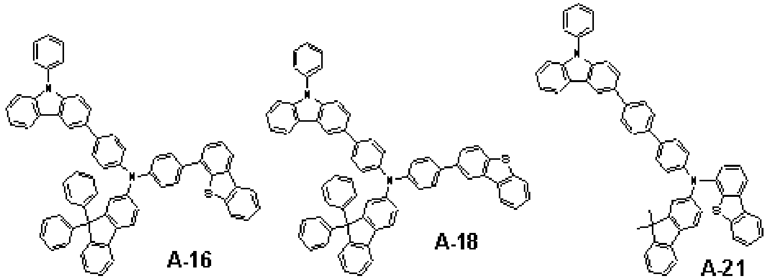

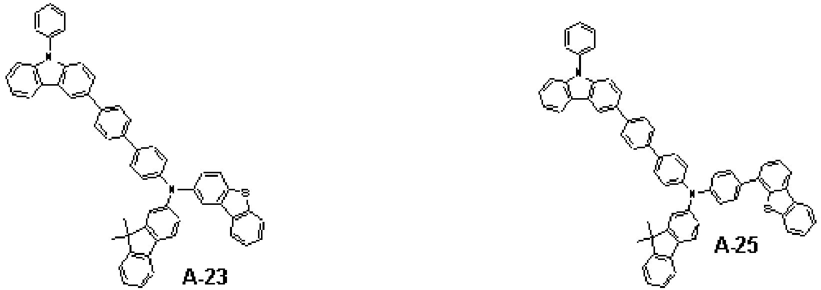

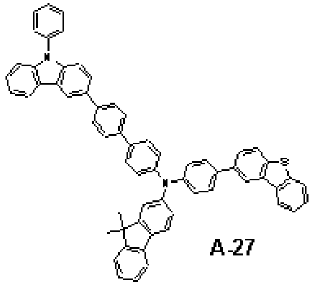

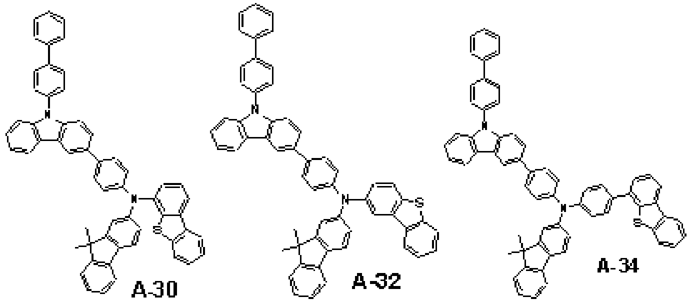

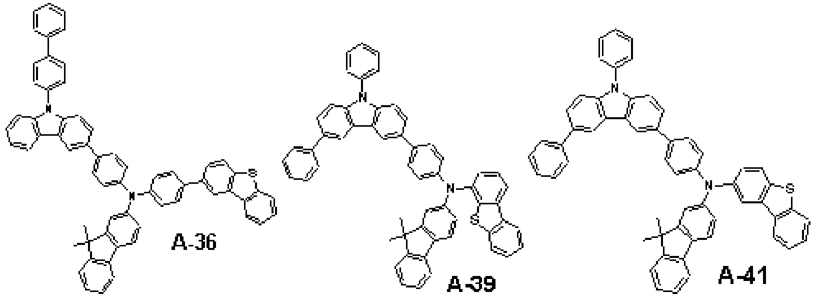

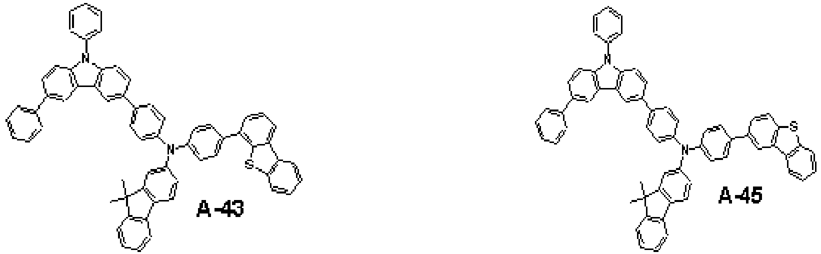

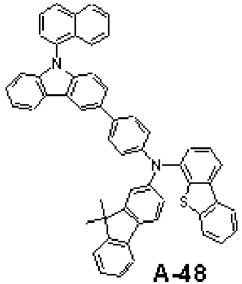

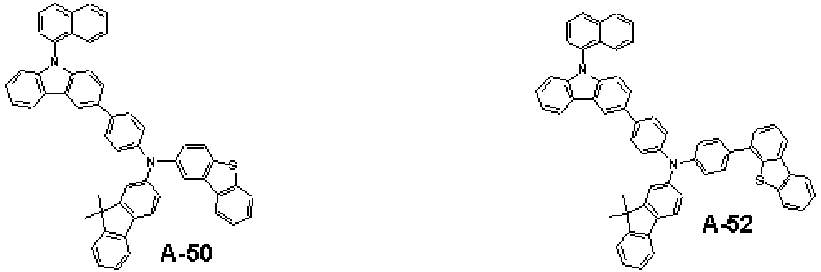

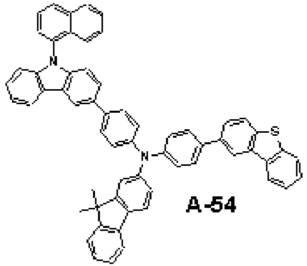

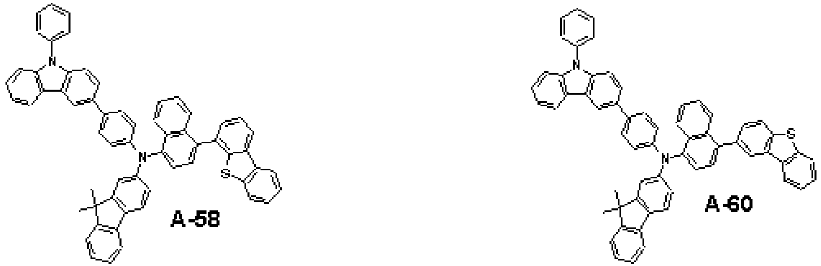

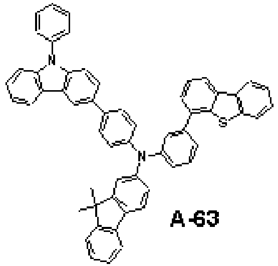

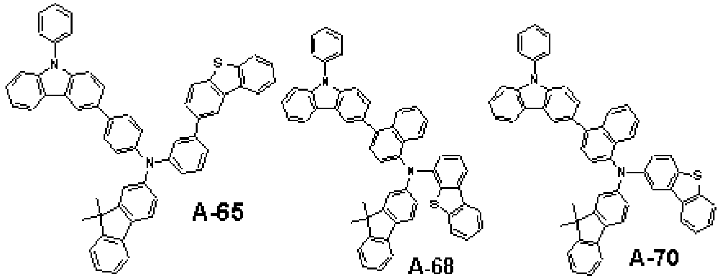

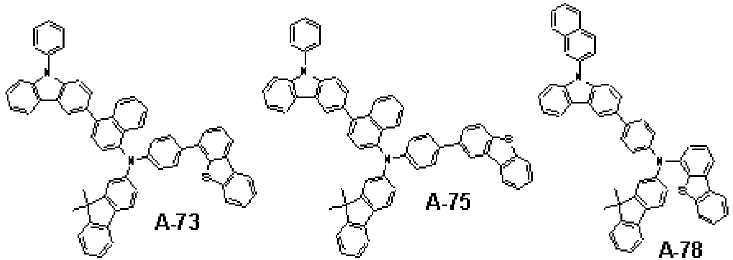

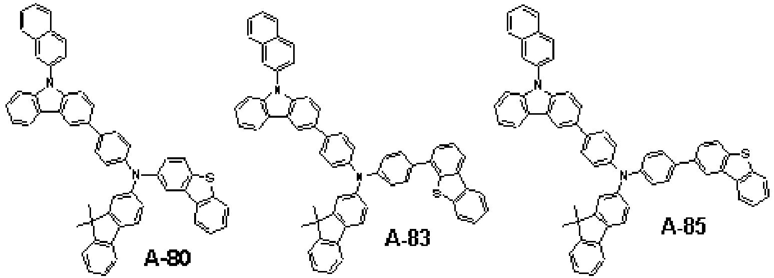

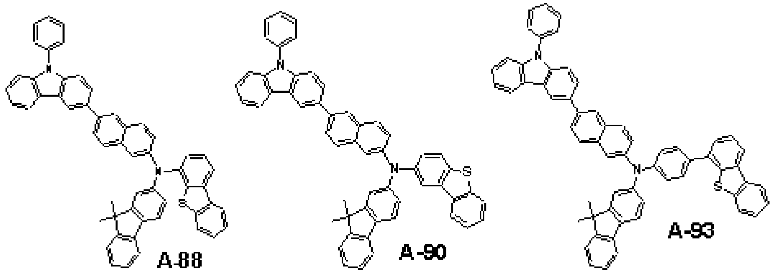

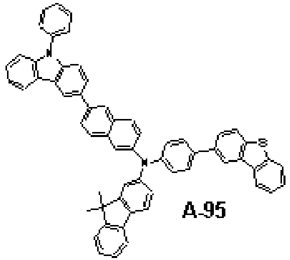

8. An organic light emitting diode comprising
an anode, a cathode, and at least one organic thin layer interposed between the anode and cathode,
wherein at least one organic thin layer includes the compound for an organic optoelectronic device of claims 1 to 7.

9. The organic light emitting diode of claim 8, wherein the compound for an organic optoelectronic device is included in a hole transport layer (HTL) or a hole injection layer (HIL).

10. A display device comprising the organic light emitting diode according to claims 8 or 9.

## Patentansprüche

1. Verbindung für eine organische optoelektronische Vorrichtung der folgenden Chemischen Formel 1: 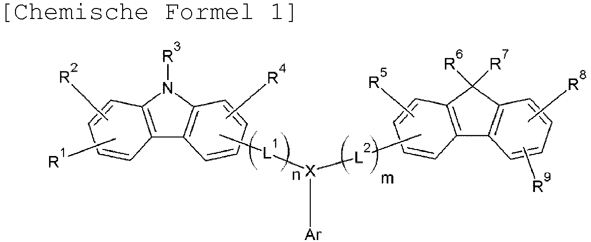 wobei in der Chemischen Formel 1
Ar für eine substituierte oder unsubstituierte Biphenylgruppe, eine substituierte oder unsubstituierte Dibenzofuranylgruppe oder eine substituierte oder unsubstituierte Dibenzothiophenylgruppe steht,
X für N, B oder P steht,
L¹ und L² gleich oder verschieden sind und unabhängig für eine Einfachbindung, eine substituierte oder unsubstituierte C2- bis C10-Alkenylengruppe, eine substituierte oder unsubstituierte C2- bis C10-Alkinylengruppe, eine substituierte oder unsubstituierte C6- bis C30-Arylengruppe oder eine substituierte oder unsubstituierte C2- bis C30-Heteroarylengruppe stehen,
n und m gleich oder verschieden sind und unabhängig für ganze Zahlen im Bereich von 0 bis 3 stehen und R¹ bis R⁹ gleich oder verschieden sind und unabhängig für Wasserstoff, Deuterium, Halogen, eine Cyanogruppe, eine Hydroxylgruppe, eine Aminogruppe, eine substituierte oder unsubstituierte C1- bis C20-Amingruppe, eine Nitrogruppe, eine Carboxylgruppe, eine Ferrocenylgruppe, eine substituierte oder unsubstituierte C1- bis C20-Alkylgruppe, eine substituierte oder unsubstituierte C6- bis C30-Arylgruppe, eine substituierte oder unsubstituierte C2- bis C30-Heteroarylgruppe, eine substituierte oder unsubstituierte C1- bis C20-Alkoxygruppe, eine substituierte oder unsubstituierte C6- bis C20-Aryloxygruppe, eine substituierte oder unsubstituierte C3- bis C40-Silyloxygruppe, eine substituierte oder unsubstituierte C1- bis C20-Acylgruppe, eine substituierte oder unsubstituierte C2- bis C20-Alkoxycarbonylgruppe, eine substituierte oder unsubstituierte C2- bis C20-Acyloxygruppe, eine substituierte oder unsubstituierte C2- bis C20-Acylaminogruppe, eine substituierte oder unsubstituierte C2- bis C20-Alkoxycarbonylaminogruppe, eine substituierte oder unsubstituierte C7- bis C20-Aryloxycarbonylaminogruppe, eine substituierte oder unsubstituierte C1- bis C20-Sulfamoylaminogruppe, eine substituierte oder unsubstituierte C1- bis C20-Sulfonylgruppe, eine substituierte oder unsubstituierte C1- bis C20-Alkylthiolgruppe, eine substituierte oder unsubstituierte C6- bis C20-Arylthiolgruppe, eine substituierte oder unsubstituierte C1- bis C20-Heterocyclylthiolgruppe, eine substituierte oder unsubstituierte C1- bis C20-Ureidgruppe, eine substituierte oder unsubstituierte C3- bis C40-Silylgruppe oder eine Kombination davon stehen, wobei
dann, wenn Ar für eine substituierte oder unsubstituierte Biphenylgruppe steht, die Chemische Formel 1 durch die folgende Chemische Formel B-1 wiedergegeben wird:

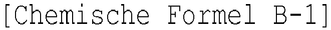

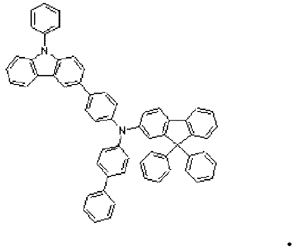

2. Verbindung für eine organische optoelektronische Vorrichtung nach Anspruch 1, wobei die Verbindung für eine organische optoelektronische Vorrichtung durch die folgende Chemische Formel 3 wiedergegeben wird: 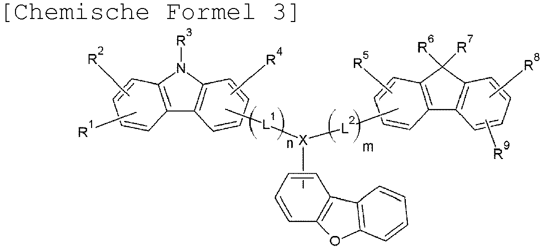 wobei in der Chemischen Formel 3
X für N, B oder P steht,
L¹ und L² gleich oder verschieden sind und unabhängig für eine Einfachbindung, eine substituierte oder unsubstituierte C2- bis C10-Alkenylengruppe, eine substituierte oder unsubstituierte C2- bis C10-Alkinylengruppe, eine substituierte oder unsubstituierte C6- bis C30-Arylengruppe oder eine substituierte oder unsubstituierte C2- bis C30-Heteroarylengruppe stehen,
n und m gleich oder verschieden sind und unabhängig für ganze Zahlen im Bereich von 0 bis 3 stehen und R¹ bis R⁹ gleich oder verschieden sind und unabhängig für Wasserstoff, Deuterium, Halogen, eine Cyanogruppe, eine Hydroxylgruppe, eine Aminogruppe, eine substituierte oder unsubstituierte C1- bis C20-Amingruppe, eine Nitrogruppe, eine Carboxylgruppe, eine Ferrocenylgruppe, eine substituierte oder unsubstituierte C1- bis C20-Alkylgruppe, eine substituierte oder unsubstituierte C6- bis C30-Arylgruppe, eine substituierte oder unsubstituierte C2- bis C30-Heteroarylgruppe, eine substituierte oder unsubstituierte C1- bis C20-Alkoxygruppe, eine substituierte oder unsubstituierte C6- bis C20-Aryloxygruppe, eine substituierte oder unsubstituierte C3- bis C40-Silyloxygruppe, eine substituierte oder unsubstituierte C1- bis C20-Acylgruppe, eine substituierte oder unsubstituierte C2- bis C20-Alkoxycarbonylgruppe, eine substituierte oder unsubstituierte C2- bis C20-Acyloxygruppe, eine substituierte oder unsubstituierte C2- bis C20-Acylaminogruppe, eine substituierte oder unsubstituierte C2- bis C20-Alkoxycarbonylaminogruppe, eine substituierte oder unsubstituierte C7- bis C20-Aryloxycarbonylaminogruppe, eine substituierte oder unsubstituierte C1- bis C20-Sulfamoylaminogruppe, eine substituierte oder unsubstituierte C1- bis C20-Sulfonylgruppe, eine substituierte oder unsubstituierte C1- bis C20-Alkylthiolgruppe, eine substituierte oder unsubstituierte C6- bis C20-Arylthiolgruppe, eine substituierte oder unsubstituierte C1- bis C20-Heterocyclylthiolgruppe, eine substituierte oder unsubstituierte C1- bis C20-Ureidgruppe, eine substituierte oder unsubstituierte C3- bis C40-Silylgruppe oder eine Kombination davon stehen.

3. Verbindung für eine organische optoelektronische Vorrichtung nach Anspruch 1, wobei die Verbindung für eine organische optoelektronische Vorrichtung durch die folgende Chemische Formel 4 wiedergegeben wird: 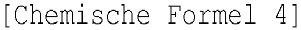 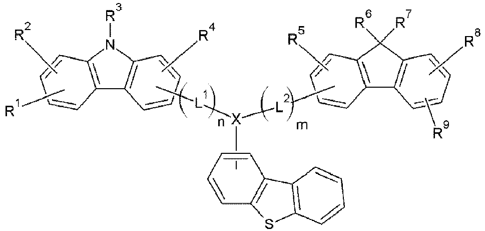 wobei in der Chemischen Formel 4
X für N, B oder P steht,
L¹ und L² gleich oder verschieden sind und unabhängig für eine Einfachbindung, eine substituierte oder unsubstituierte C2- bis C10-Alkenylengruppe, eine substituierte oder unsubstituierte C2- bis C10-Alkinylengruppe, eine substituierte oder unsubstituierte C6- bis C30-Arylengruppe oder eine substituierte oder unsubstituierte C2- bis C30-Heteroarylengruppe stehen,
n und m gleich oder verschieden sind und unabhängig für ganze Zahlen im Bereich von 0 bis 3 stehen und R¹ bis R⁹ gleich oder verschieden sind und unabhängig für Wasserstoff, Deuterium, Halogen, eine Cyanogruppe, eine Hydroxylgruppe, eine Aminogruppe, eine substituierte oder unsubstituierte C1- bis C20-Amingruppe, eine Nitrogruppe, eine Carboxylgruppe, eine Ferrocenylgruppe, eine substituierte oder unsubstituierte C1- bis C20-Alkylgruppe, eine substituierte oder unsubstituierte C6- bis C30-Arylgruppe, eine substituierte oder unsubstituierte C2- bis C30-Heteroarylgruppe, eine substituierte oder unsubstituierte C1- bis C20-Alkoxygruppe, eine substituierte oder unsubstituierte C6- bis C20-Aryloxygruppe, eine substituierte oder unsubstituierte C3- bis C40-Silyloxygruppe, eine substituierte oder unsubstituierte C1- bis C20-Acylgruppe, eine substituierte oder unsubstituierte C2- bis C20-Alkoxycarbonylgruppe, eine substituierte oder unsubstituierte C2- bis C20-Acyloxygruppe, eine substituierte oder unsubstituierte C2- bis C20-Acylaminogruppe, eine substituierte oder unsubstituierte C2- bis C20-Alkoxycarbonylaminogruppe, eine substituierte oder unsubstituierte C7- bis C20-Aryloxycarbonylaminogruppe, eine substituierte oder unsubstituierte C1- bis C20-Sulfamoylaminogruppe, eine substituierte oder unsubstituierte C1- bis C20-Sulfonylgruppe, eine substituierte oder unsubstituierte C1- bis C20-Alkylthiolgruppe, eine substituierte oder unsubstituierte C6- bis C20-Arylthiolgruppe, eine substituierte oder unsubstituierte C1- bis C20-Heterocyclylthiolgruppe, eine substituierte oder unsubstituierte C1- bis C20-Ureidgruppe, eine substituierte oder unsubstituierte C3- bis C40-Silylgruppe oder eine Kombination davon stehen.

4. Verbindung für eine organische optoelektronische Vorrichtung nach den Ansprüchen 1-3, wobei X für N steht.

5. Verbindung für eine organische optoelektronische Vorrichtung nach Anspruch 1, wobei die Verbindung für eine organische optoelektronische Vorrichtung durch eine der folgenden Chemischen Formeln B-1 wiedergegeben wird:

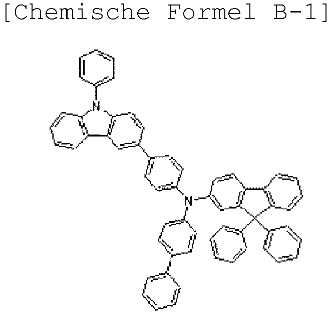

6. Verbindung für eine organische optoelektronische Vorrichtung nach Anspruch 1 oder 2, wobei die Verbindung für eine organische optoelektronische Vorrichtung eine durch die folgende Chemische Formel A-2, A-4, A-6, A-8, A-11, A-13, A-15, A-17, A-20, A-22, A-24, A-26, A-29, A-31, A-33, A-35, A-38, A-40, A-42, A-44, A-47, A-49, A-51, A-53, A-57, A-59, A-62, A-64, A-69, A-71, A-72, A-74, A-79, A-81, A-82, A-84, A-89, A-91, A-92 oder A-94 wiedergegeben wird.

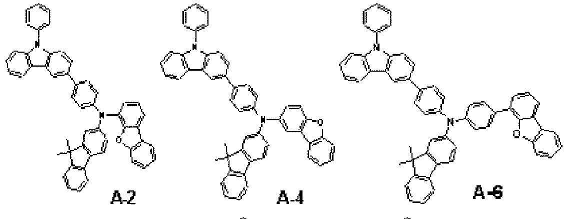

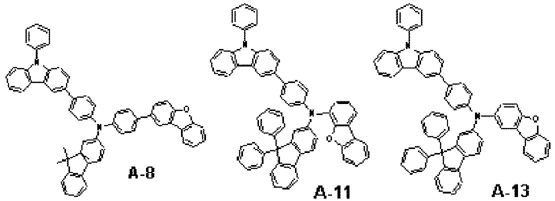

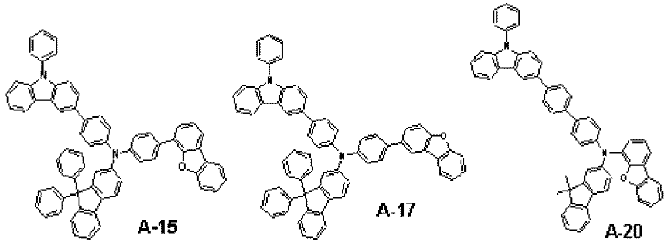

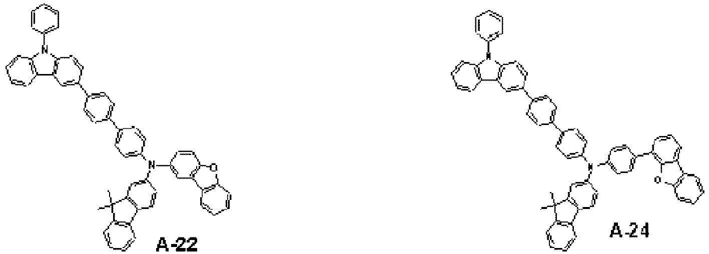

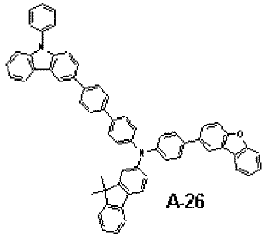

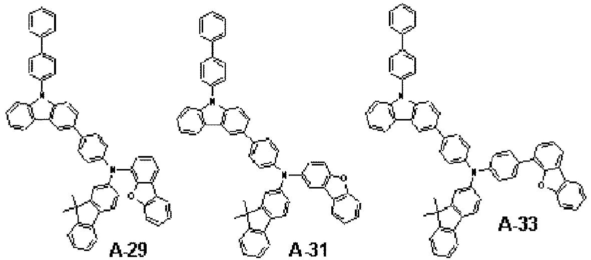

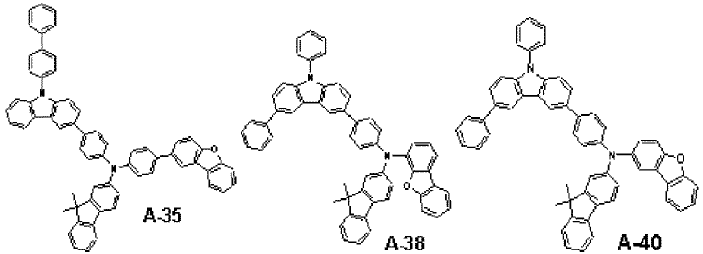

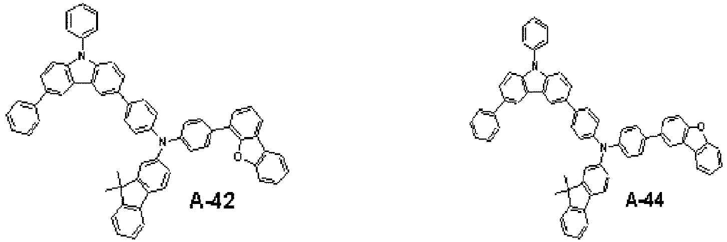

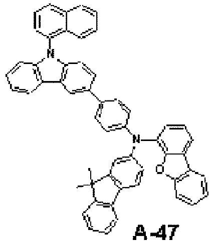

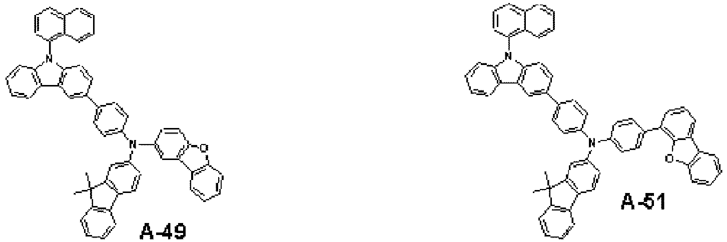

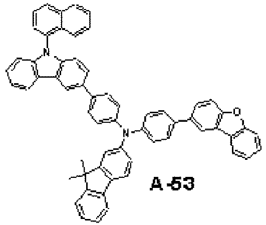

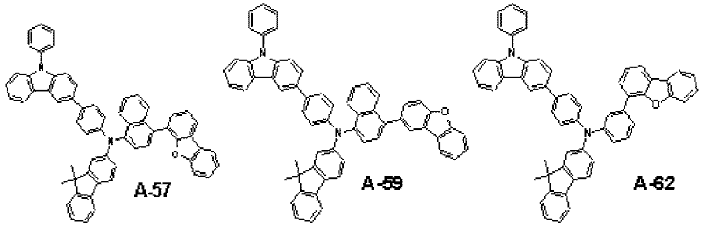

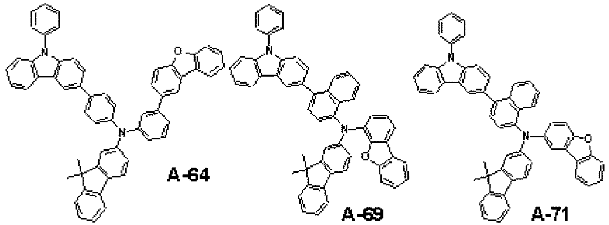

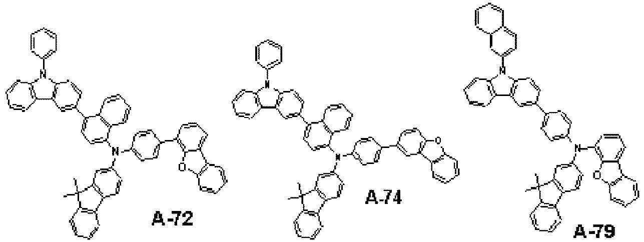

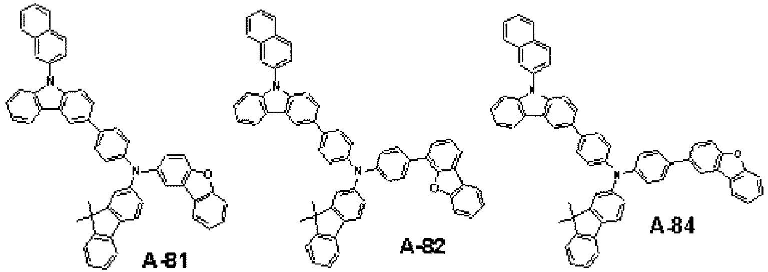

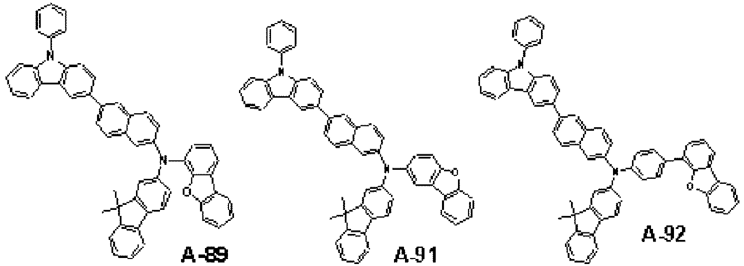

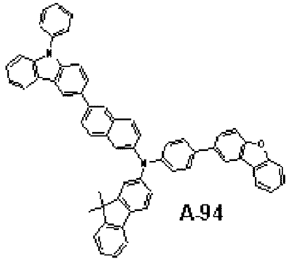

7. Verbindung für eine organische optoelektronische Vorrichtung nach Anspruch 1 oder 3, wobei die Verbindung für eine organische optoelektronische Vorrichtung durch die folgende Chemische Formel A-3, A-5, A-7, A-9, A-12, A-14, A-16, A-18, A-21, A-23, A-25, A-27, A-30, A-32, A-34, A-36, A-39, A-41, A-43, A-45, A-48, A-50, A-52, A-54, A-58, A-60, A-63, A-65, A-68, A-70, A-73, A-75, A-78, A-80, A-83, A-85, A-88, A-90, A-93 oder A-95 wiedergegeben wird.

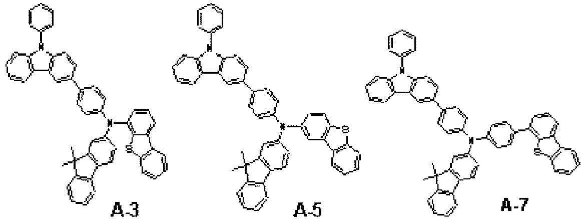

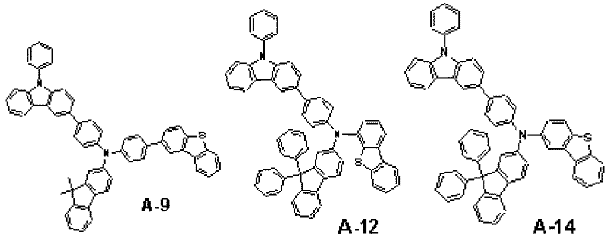

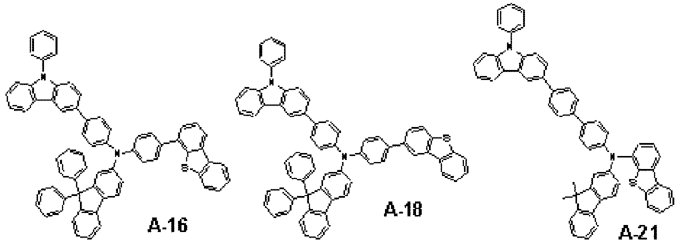

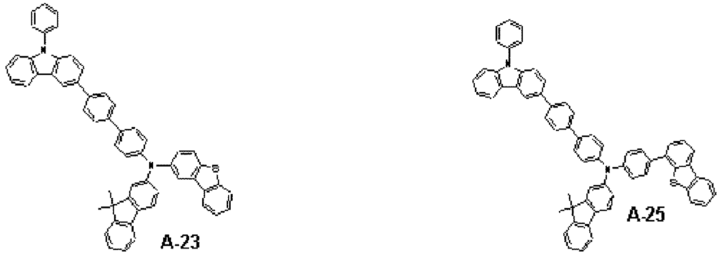

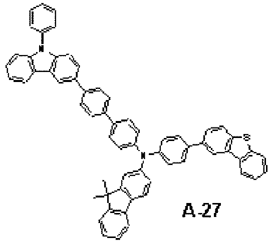

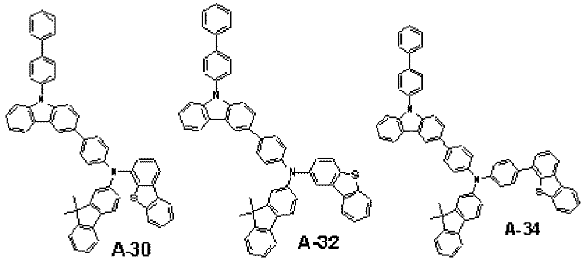

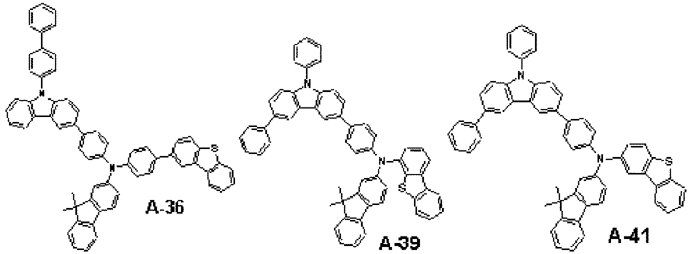

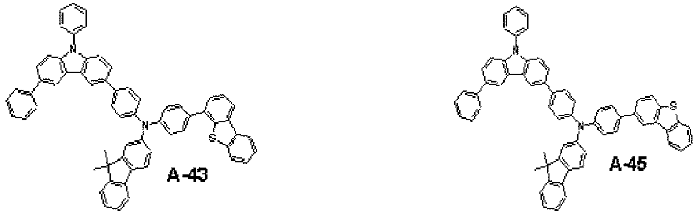

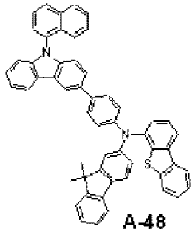

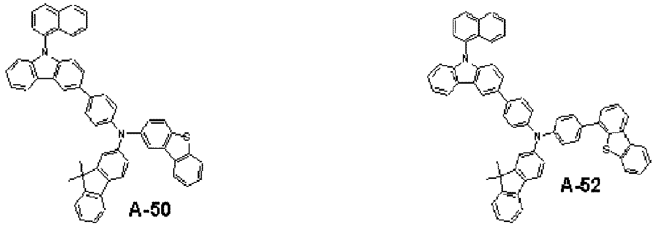

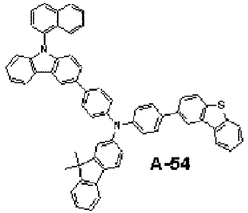

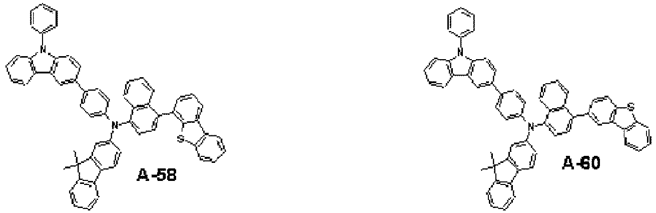

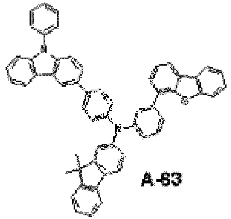

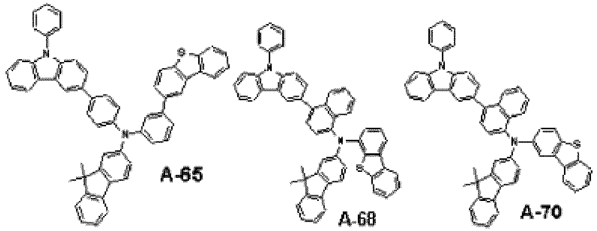

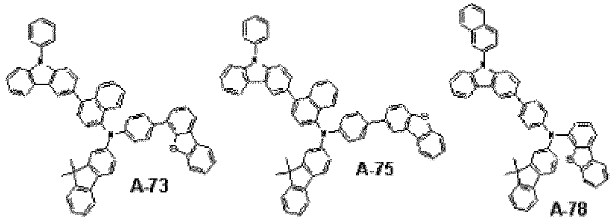

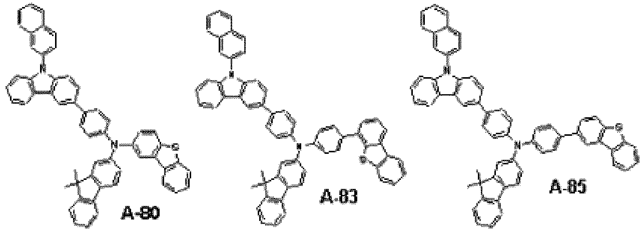

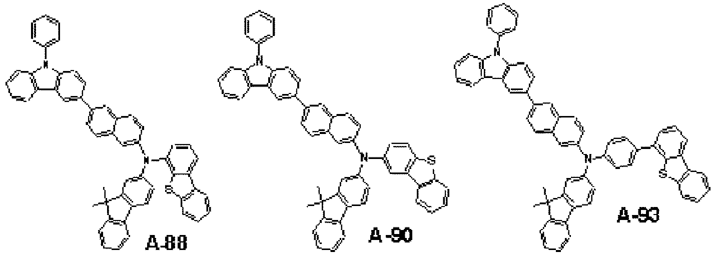

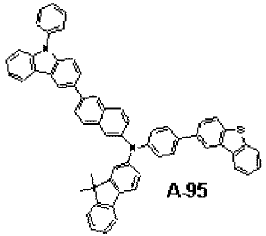

8. Organische Leuchtdiode, umfassend
eine Anode, eine Kathode und mindestens eine organische dünne Schicht zwischen der Anode und der Kathode,
wobei mindestens eine organische dünne Schicht die Verbindung für eine organische optoelektronische Vorrichtung nach den Ansprüchen 1 bis 7 enthält.

9. Organische Leuchtdiode nach Anspruch 8, wobei die Verbindung für eine organische optoelektronische Vorrichtung in einer Lochtransportschicht (Hole Transport Layer, HTL) oder einer Lochinjektionsschicht (Hole Injection Layer, HIL) enthalten ist.

10. Anzeigevorrichtung, umfassend die organische Leuchtdiode nach Anspruch 8 oder 9.

## Revendications

1. Composé destiné à un dispositif optoélectronique organique, représenté par la Formule Chimique 1 suivante : 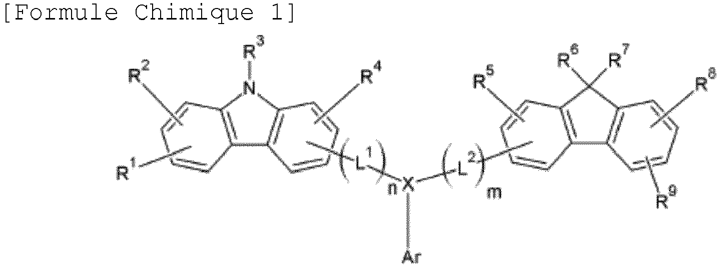 où, dans la Formule Chimique 1,
Ar est un groupement biphényle substitué ou non substitué ; un groupement dibenzofuranyle substitué ou non substitué ; ou un groupement dibenzothiophényle substitué ou non substitué,
X est N, B, ou P,
L¹ et L² sont identiques ou différents et indépendamment une liaison simple, un groupement C2 à C10 alcénylène substitué ou non substitué, un groupement C2 à C10 alcynylène substitué ou non substitué, un groupement C6 à C30 arylène substitué ou non substitué ou un groupement C2 à C30 hétéroarylène substitué ou non substitué,
n et m sont identiques ou différents et indépendamment des nombres entiers allant de 0 à 3, et
R¹ à R⁹ sont identiques ou différents et indépendamment hydrogène, deutérium, halogène, un groupement cyano, un groupement hydroxyle, un groupement amino, un groupement C1 à C20 amine substitué ou non substitué, un groupement nitro, un groupement carboxyle, un groupement ferrocényle, un groupement C1 à C20 alkyle substitué ou non substitué, un groupement C6 à C30 aryle substitué ou non substitué, un groupement C2 à C30 hétéroaryle substitué ou non substitué, un groupement C1 à C20 alcoxy substitué ou non substitué, un groupement C6 à C20 aryloxy substitué ou non substitué, un groupement C3 à C40 silyloxy substitué ou non substitué, un groupement C1 à C20 acyle substitué ou non substitué, un groupement C2 à C20 alcoxycarbonyle substitué ou non substitué, un groupement C2 à C20 acyloxy substitué ou non substitué, un groupement C2 à C20 acylamino substitué ou non substitué, un groupement C2 à C20 alcoxycarbonylamino substitué ou non substitué, un groupement C7 à C20 aryloxycarbonylamino substitué ou non substitué, un groupement C1 à C20 sulfamoylamino substitué ou non substitué, un groupement C1 à C20 sulfonyle substitué ou non substitué, un groupement C1 à C20 alkylthiol substitué ou non substitué, un groupement C6 à C20 arylthiol substitué ou non substitué, un groupement C1 à C20 hétérocyclothiol substitué ou non substitué, un groupement C1 à C20 uréido substitué ou non substitué, un groupement C3 à C40 silyle substitué ou non substitué, ou une combinaison de ceux-ci, où
lorsque Ar est un groupement biphényle substitué ou non substitué, la Formule Chimique 1 est représentée par la Formule Chimique B-1 suivante :

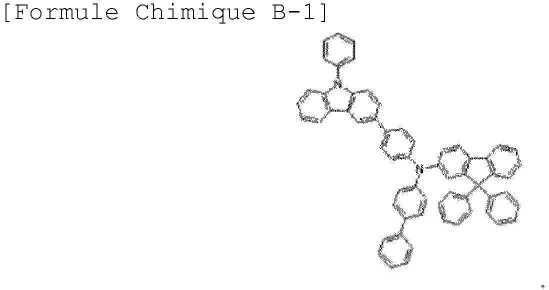

2. Composé destiné à un dispositif optoélectronique organique selon la revendication 1, où le composé destiné à un dispositif optoélectronique organique est représenté par la Formule Chimique 3 suivante : 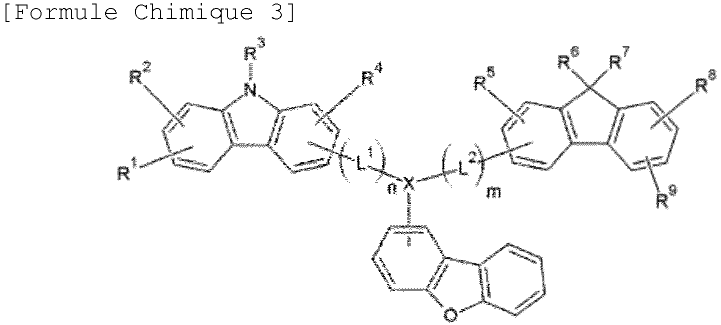 où, dans la Formule Chimique 3,
X est N, B, ou P,
L¹ et L² sont identiques ou différents et indépendamment une liaison simple, un groupement C2 à C10 alcénylène substitué ou non substitué, un groupement C2 à C10 alcynylène substitué ou non substitué, un groupement C6 à C30 arylène substitué ou non substitué, ou un groupement C2 à C30 hétéroarylène substitué ou non substitué,
n et m sont identiques ou différents et indépendamment des nombres entiers allant de 0 à 3, et
R¹ à R⁹ sont identiques ou différents et indépendamment hydrogène, deutérium, halogène, un groupement cyano, un groupement hydroxyle, un groupement amino, un groupement C1 à C20 amine substitué ou non substitué, un groupement nitro, un groupement carboxyle, un groupement ferrocényle, un groupement C1 à C20 alkyle substitué ou non substitué, un groupement C6 à C30 aryle substitué ou non substitué, un groupement C2 à C30 hétéroaryle substitué ou non substitué, un groupement C1 à C20 alcoxy substitué ou non substitué, un groupement C6 à C20 aryloxy substitué ou non substitué, un groupement C3 à C40 silyloxy substitué ou non substitué, un groupement C1 à C20 acyle substitué ou non substitué, un groupement C2 à C20 alcoxycarbonyle substitué ou non substitué, un groupement C2 à C20 acyloxy substitué ou non substitué, un groupement C2 à C20 acylamino substitué ou non substitué, un groupement C2 à C20 alcoxycarbonylamino substitué ou non substitué, un groupement C7 à C20 aryloxycarbonylamino substitué ou non substitué, un groupement C1 à C20 sulfamoylamino substitué ou non substitué, un groupement C1 à C20 sulfonyle substitué ou non substitué, un groupement C1 à C20 alkylthiol substitué ou non substitué, un groupement C6 à C20 arylthiol substitué ou non substitué, un groupement C1 à C20 hétérocyclothiol substitué ou non substitué, un groupement C1 à C20 uréido substitué ou non substitué, un groupement C3 à C40 silyle substitué ou non substitué, ou une combinaison de ceux-ci.

3. Composé destiné à un dispositif optoélectronique organique selon la revendication 1, où le composé destiné à un dispositif optoélectronique organique est représenté par la Formule Chimique 4 suivante : 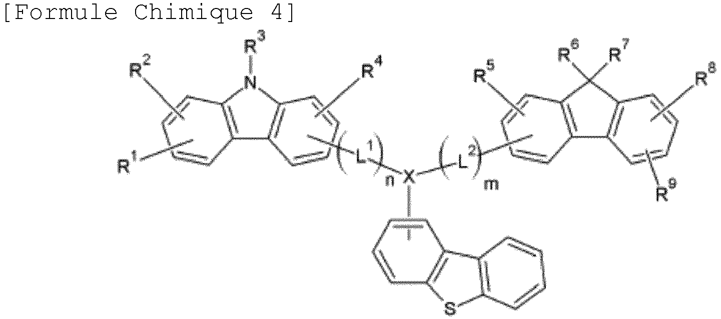 où, dans la Formule Chimique 4,
X est N, B, ou P,
L¹ et L² sont identiques ou différents et indépendamment une liaison simple, un groupement C2 à C10 alcénylène substitué ou non substitué, un groupement C2 à C10 alcynylène substitué ou non substitué, un groupement C6 à C30 arylène substitué ou non substitué, ou un groupement C2 à C30 hétéroarylène substitué ou non substitué,
n et m sont identiques ou différents et indépendamment des nombres entiers allant de 0 à 3, et
R¹ à R⁹ sont identiques ou différents et indépendamment hydrogène, deutérium, halogène, un groupement cyano, un groupement hydroxyle, un groupement amino, un groupement C1 à C20 amine substitué ou non substitué, un groupement nitro, un groupement carboxyle, un groupement ferrocényle, un groupement C1 à C20 alkyle substitué ou non substitué, un groupement C6 à C30 aryle substitué ou non substitué, un groupement C2 à C30 hétéroaryle substitué ou non substitué, un groupement C1 à C20 alcoxy substitué ou non substitué, un groupement C6 à C20 aryloxy substitué ou non substitué, un groupement C3 à C40 silyloxy substitué ou non substitué, un groupement C1 à C20 acyle substitué ou non substitué, un groupement C2 à C20 alcoxycarbonyle substitué ou non substitué, un groupement C2 à C20 acyloxy substitué ou non substitué, un groupement C2 à C20 acylamino substitué ou non substitué, un groupement C2 à C20 alcoxycarbonylamino substitué ou non substitué, un groupement C7 à C20 aryloxycarbonylamino substitué ou non substitué, un groupement C1 à C20 sulfamoylamino substitué ou non substitué, un groupement C1 à C20 sulfonyle substitué ou non substitué, un groupement C1 à C20 alkylthiol substitué ou non substitué, un groupement C6 à C20 arylthiol substitué ou non substitué, un groupement C1 à C20 hétérocyclothiol substitué ou non substitué, un groupement C1 à C20 uréido substitué ou non substitué, un groupement C3 à C40 silyle substitué ou non substitué, ou une combinaison de ceux-ci.

4. Composé destiné à un dispositif optoélectronique organique selon les revendication 1-3, où X est N.

5. Composé destiné à un dispositif optoélectronique organique selon la revendication 1, où le composé destiné à un dispositif optoélectronique organique est représenté par l'une parmi la Formule Chimique B-1 suivante :

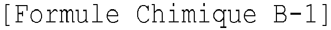

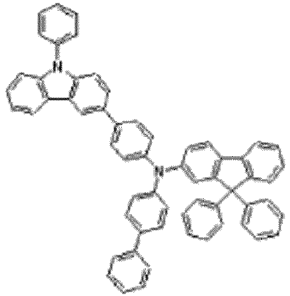

6. Composé destiné à un dispositif optoélectronique organique selon les revendications 1 ou 2, où le composé destiné à un dispositif optoélectronique organique est un représenté par la Formule Chimique suivante : A-2, A-4, A-6, A-8, A-11, A-13, A-15, A-17, A-20, A-22, A-24, A-26, A-29, A-31, A-33, A-35, A-38, A-40, A-42, A-44, A-47, A-49, A-51, A-53, A-57, A-59, A-62, A-64, A-69, A-71, A-72, A-74, A-79, A-81, A-82, A-84, A-89, A-91, A-92, ou A-94

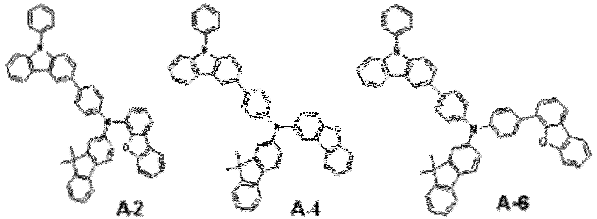

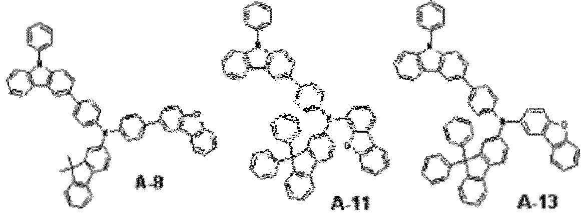

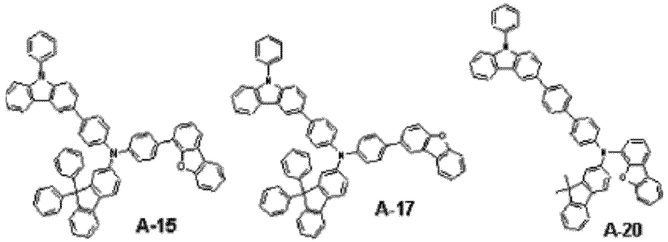

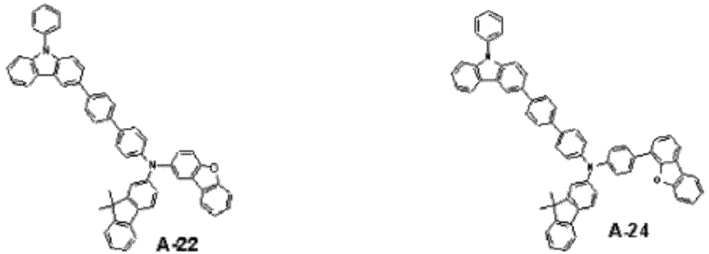

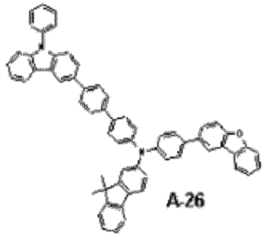

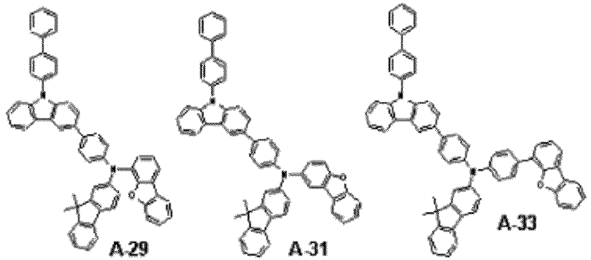

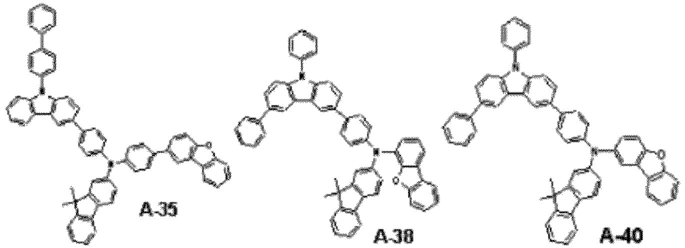

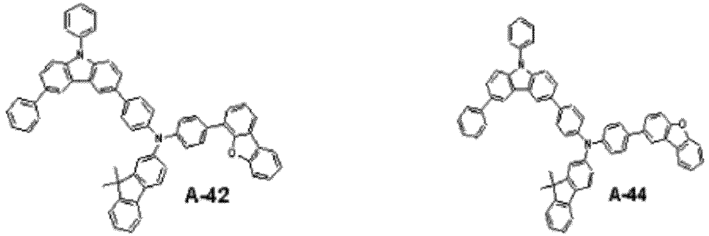

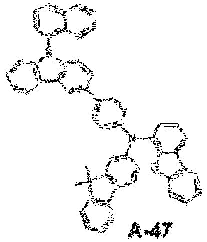

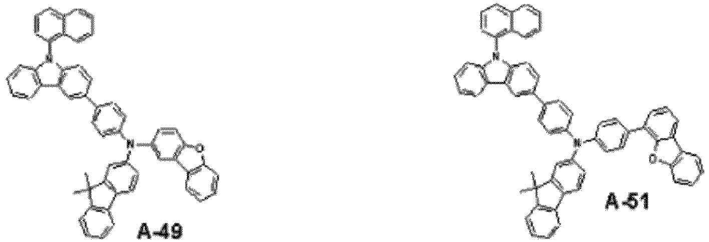

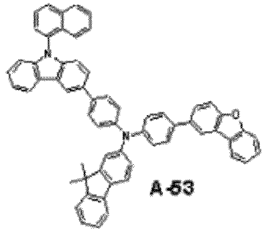

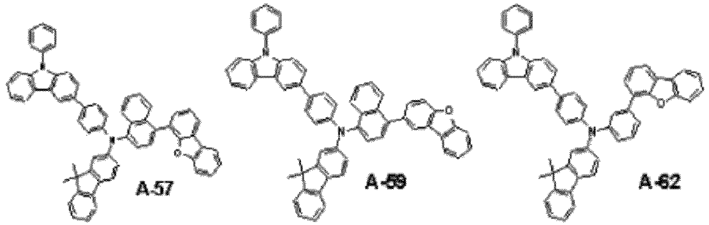

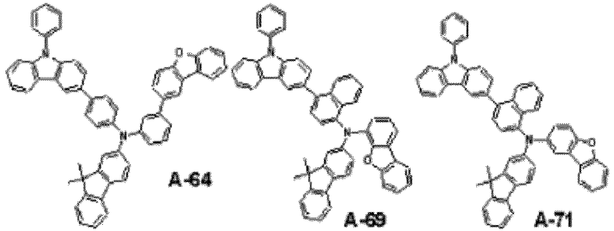

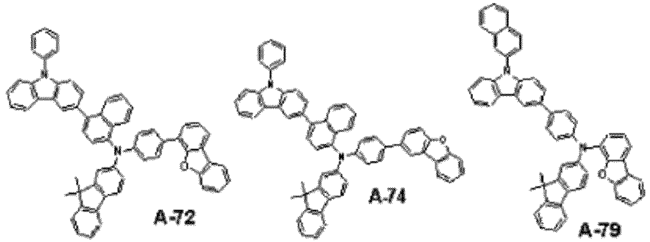

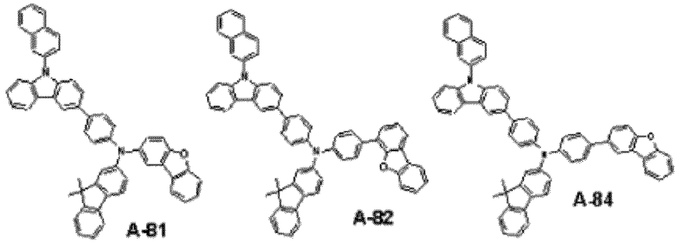

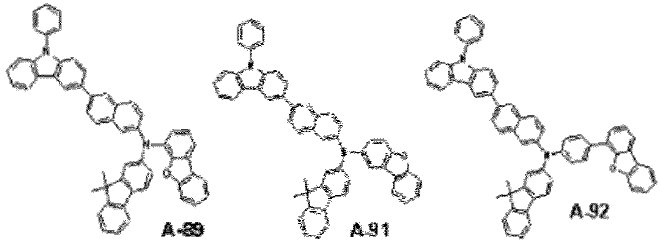

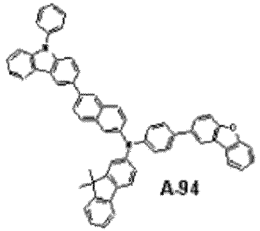

7. Composé destiné à un dispositif optoélectronique organique selon les revendications 1 ou 3, où le composé destiné à un dispositif optoélectronique organique est représenté par la Formule Chimique suivante : A-3, A-5, A-7, A-9, A-12, A-14, A-16, A-18, A-21, A-23, A-25, A-27, A-30, A-32, A-34, A-36, A-39, A-41, A-43, A-45, A-48, A-50, A-52, A-54, A-58, A-60, A-63, A-65, A-68, A-70, A-73, A-75, A-78, A-80, A-83, A-85, A-88, A-90, A-93, ou A-95

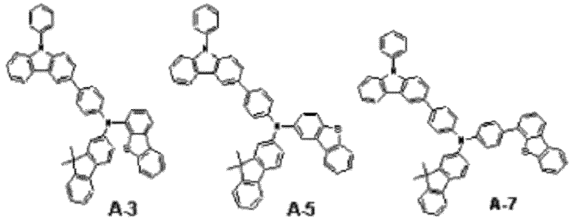

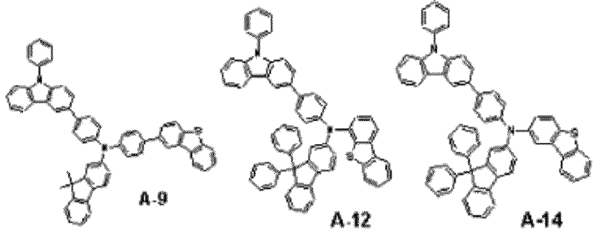

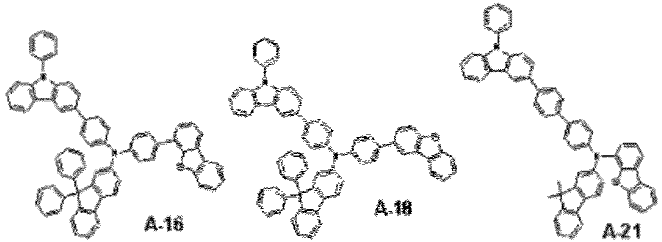

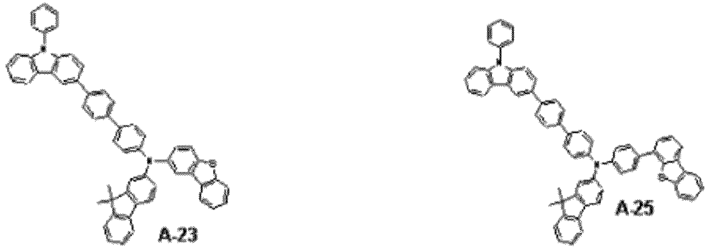

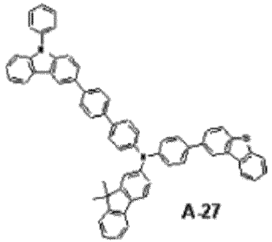

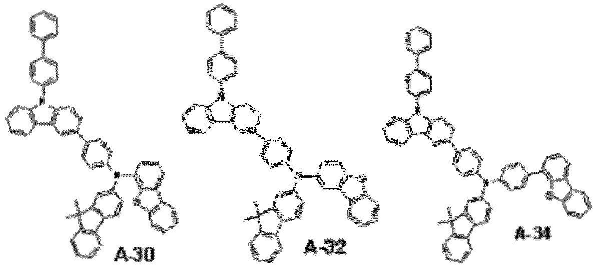

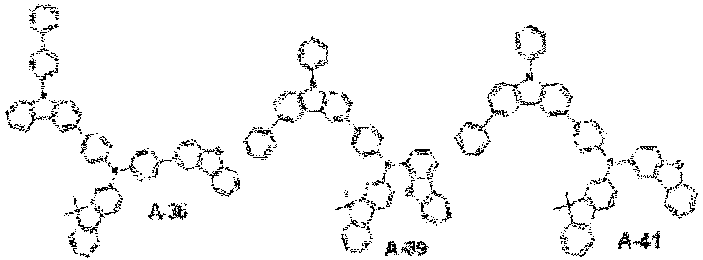

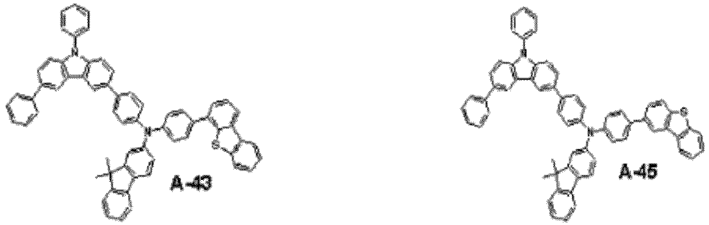

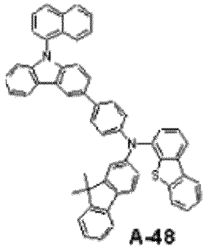

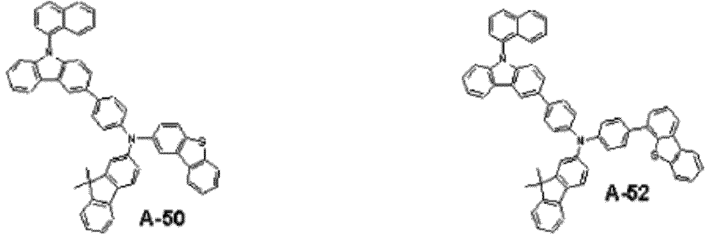

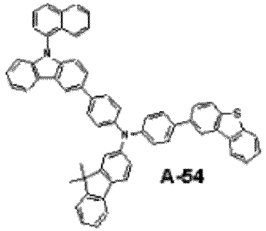

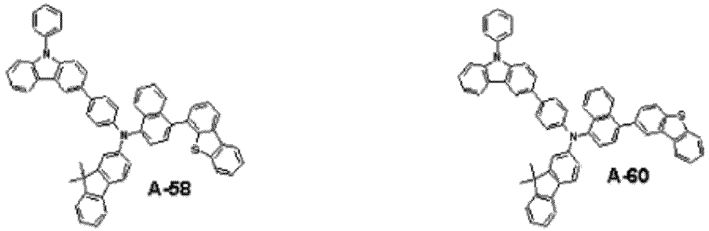

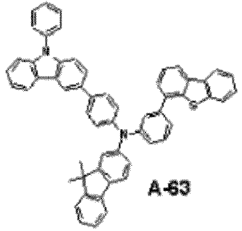

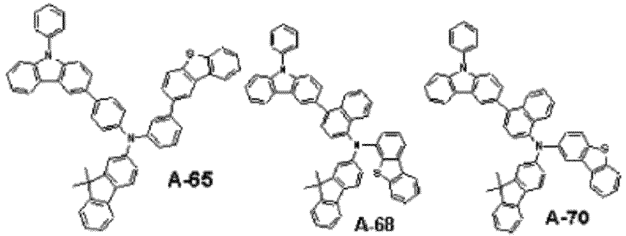

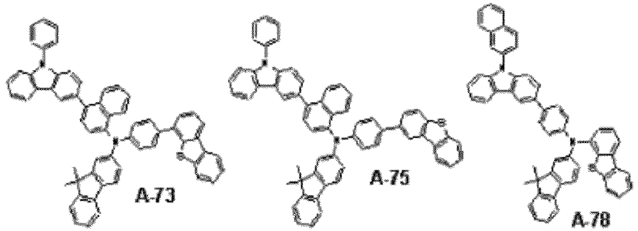

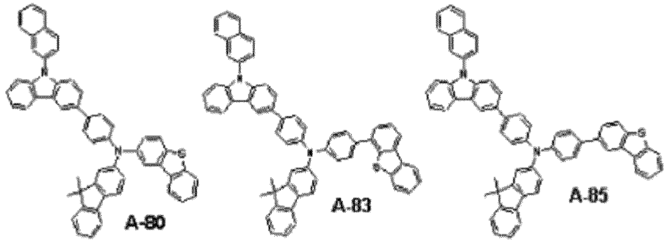

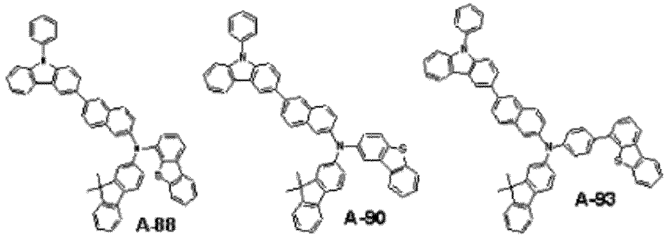

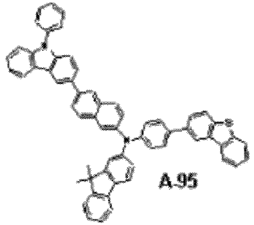

8. Diode électroluminescente organique, comprenant
une anode, une cathode, et au moins une couche fine organique interposée entre l'anode et la cathode,
où au moins une couche fine organique comporte le composé destiné à un dispositif optoélectronique organique selon les revendications 1 à 7.

9. Diode électroluminescente organique selon la revendication 8, où le composé destiné à un dispositif optoélectronique organique est inclus dans une couche de transport de trous (HTL) ou une couche d'injection de trous (HIL).

10. Dispositif d'affichage comprenant la diode électroluminescente organique selon les revendications 8 ou 9.
